# EUROPEAN PATENT APPLICATION

(11) **EP 4 810 501 A1**
(43) Date of publication of application: **23.09.2026**
(21) Application number: 26166032.8
(22) Date of filing: 19.03.2026
(51) Int. Cl.: C07F 5/02, C07F 7/08, C07F 7/30, C09K 11/06, H10K 85/00

(54) **POLYCYCLIC COMPOUND AND ORGANIC LIGHT-EMITTING DEVICE COMPRISING THE SAME**

(30) Priority: 19.03.2025 KR 20250035357; 12.02.2026 KR 20260028237
(71) Applicant: SFC Co., Ltd., Cheongju-si, Chungcheongbuk-do 28122 (KR)
(72) Inventor: SHIM, So-young, 28122 Cheongju-si, Chungcheongbuk-do (KR); CHO, Jin-hwi, 28122 Cheongju-si, Chungcheongbuk-do (KR)
(74) Representative: Grosse, Felix Christopher

(57) **Abstract**

The present invention relates to a polycyclic compound represented by the following [Chemical Formula 1] or [Chemical Formula 2], and a high-efficiency and long-lifespan organic light-emitting device having significantly improved low-voltage driving, and excellent light-emitting efficiency, long lifespan and the like by employing the same as a dopant material of a light-emitting layer in the device.

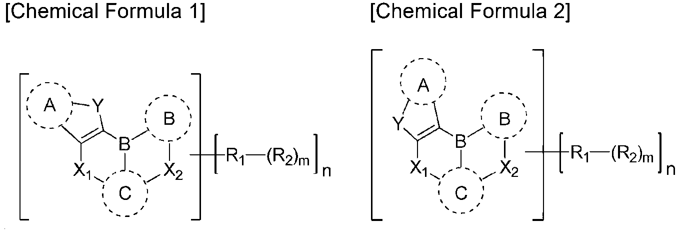

## Description

The present invention relates to a polycyclic compound employed in an organic layer in an organic light-emitting device, and an organic light-emitting device including the same.

Organic light-emitting devices are self-luminous devices in which electrons injected from an electron injecting electrode (cathode) combine with holes injected from a hole injecting electrode (anode) in a light-emitting layer to form excitons, which emit light while releasing energy. Such organic light-emitting devices have advantages of low driving voltage, high luminance, wide viewing angle and short response time, and being applicable to full-color light-emitting flat-panel displays. Due to these advantages, organic light-emitting devices have received attention as next-generation light sources.

The above characteristics of organic light-emitting devices are achieved by structural optimization of organic layers of the devices and are supported by stable and efficient materials for the organic layers, such as hole injecting materials, hole transport materials, hole blocking materials, light-emitting materials, electron transport materials, electron injecting materials, and electron blocking materials. However, more research still needs to be done to develop structurally optimized structures of organic layers for organic light-emitting devices and stable and efficient materials for organic layers of organic light-emitting devices.

Particularly, to obtain maximum efficiency in a light-emitting layer, an appropriate combination of energy band gaps of a host and a dopant is required so that holes and electrons each migrate to the dopant through stable electrochemical paths to form excitons.

Accordingly, the present invention is directed to providing a light-emitting layer dopant material having a characteristic structure, and a high-efficiency and long-lifespan organic light-emitting device having significantly improved low-voltage driving, light-emitting efficiency and lifespan by including the same.

In order to solve the above-described problems, one aspect of the present invention provides a polycyclic compound represented by the following [Chemical Formula 1] or [Chemical Formula 2], and an organic light-emitting device including the same as a light-emitting layer dopant in the device.

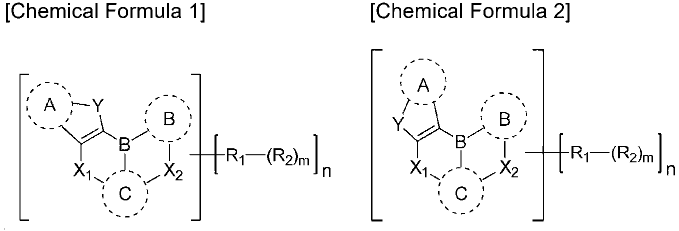

Specific structures of [Chemical Formula 1] and [Chemical Formula 2], specific compounds according to the present invention obtained therefrom, and a definition of each substituent will be described below.

The present invention relates to an organic compound in which a characteristic moiety is introduced to a skeleton having a characteristic polycyclic structure, and to an organic light-emitting device employing the same as a dopant of a light-emitting layer, and the organic light-emitting device having improved low voltage driving, high efficiency and long lifespan can be achieved. Accordingly, the organic light-emitting device can be effectively utilized not only in lighting devices, but also in various display devices such as flat-panel, flexible, stretchable and wearable displays, and displays for vehicles or aviation, and virtual or augmented reality.

Hereinafter, the present invention will be described in more detail.

One aspect of the present invention relates to a polycyclic compound represented by the following [Chemical Formula 1] or [Chemical Formula 2].

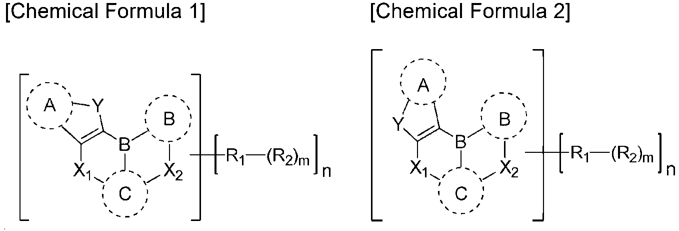

In [Chemical Formula 1] and [Chemical Formula 2], rings A to C are the same as or different from each other, and each independently selected from a substituted or unsubstituted C₆-C₅₀ aromatic hydrocarbon ring, a substituted or unsubstituted C₃-C₅₀ aliphatic hydrocarbon ring, a substituted or unsubstituted C₂-C₅₀ aromatic heteroring, a substituted or unsubstituted C₂-C₅₀ aliphatic heteroring, and a substituted or unsubstituted ring in which a C₃-C₃₀ aliphatic ring and a C₃-C₃₀ aromatic ring are fused.

X₁ and X₂ are the same as or different from each other, and each independently selected from O, S, Se, NR₃, CR₄R₅, SiR₆R₇ and GeR₈R₉.

Y is selected from O, S, NR₃, CR₄R₅, SiR₆R₇ and GeR₈R₉.

R₁ and R₂ are the same as or different from each other, and each independently selected from a substituted or unsubstituted C₁-C₃₀ arylamine group, a substituted or unsubstituted C₁-C₃₀ arylsilyl group, and a substituted or unsubstituted C₁-C₃₀ arylgermanium group.

R₃ to R₉ are the same as or different from each other, and each independently selected from hydrogen, deuterium, tritium, a substituted or unsubstituted C₁-C₃₀ alkyl group, a substituted or unsubstituted C₁-C₃₀ halogenated alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted cyclic group in which a C₃-C₃₀ aliphatic ring and a C₅-C₃₀ aromatic ring are fused, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group.

m is an integer of 1 to 3, and when m is an integer of 2 or greater, the respective R₂s are the same as or different from each other, and n is an integer of 1 to 3, and when n is an integer of 2 or greater, the respective R₁s and R₂s in the parentheses are the same as or different from each other.

According to one embodiment of the present invention, in each of [Chemical Formula 1] and [Chemical Formula 2], Y may each be any one selected from O and S.

According to one embodiment of the present invention, in each of [Chemical Formula 1] and [Chemical Formula 2], X₁ and X₂ are the same as or different from each other, and may be each independently NR₃.

Herein, when R₃ is a 'substituted or unsubstituted C₆-C₅₀ aryl group' among the substituents defined above, the term 'substituted' excludes a C₂-C₃₀ heteroaryl group including N.

In addition, according to one embodiment of the present invention, the rings A to C in each of [Chemical Formula 1] and [Chemical Formula 2] are the same as or different from each other, and may be each independently a substituted or unsubstituted C₆-C₂₀ aromatic hydrocarbon ring.

In addition, in the polycyclic compound according to the present invention, n is 1, and R₁ is a substituted or unsubstituted C₁-C₃₀ arylamine group in each of [Chemical Formula 1] and [Chemical Formula 2].

In addition, in the polycyclic compound according to the present invention, n is 1, and R₁ is a substituted or unsubstituted C₁-C₃₀ arylsilyl group in each of [Chemical Formula 1] and [Chemical Formula 2].

In addition, the 'substituted' in the 'substituted or unsubstituted' in [Chemical Formula 1] and [Chemical Formula 2] means being substituted with one, or two or more substituents selected from the group consisting of deuterium, tritium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a cyclic group in which a C₃-C₂₄ aliphatic ring and a C₅-C₂₄ aromatic ring are fused, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, or being substituted with a substituent in which two or more of the above-mentioned substituents are linked. Hydrogen atoms in the substituents may be substituted with one or more deuterium or tritium atoms, and two or more adjacent substituents may be linked to each other to further form an alicyclic or aromatic monocyclic or polycyclic ring.

Meanwhile, the range of the number of carbon atoms in the alkyl group or aryl group in the 'substituted or unsubstituted C₁-C₃₀ alkyl group', 'substituted or unsubstituted C₆-C₅₀ aryl group' and the like refers to the total number of carbon atoms forming the alkyl or aryl moiety when unsubstituted without considering the moiety substituted with the substituents. For example, it means that a phenyl group substituted with a butyl group at a para position corresponds to a C₆ aryl group substituted with a C₄ butyl group.

In addition, in the present invention, being linked to each other or to adjacent groups to further form a ring may mean that adjacent substituents among the specified substituents may bond to each other or the specified substituent and another adjacent group may bond to each other to form a substituted or unsubstituted alicyclic or aromatic ring, and the 'adjacent group' may refer to a substituent substituting on an atom directly linked to an atom substituted with the corresponding substituent, a substituent positioned sterically closest to the corresponding substituent, or another substituent substituting on an atom substituted with the corresponding substituent. For example, two substituents substituting at an ortho position of a benzene ring and two substituents substituting on the same carbon in an aliphatic ring may be interpreted as 'adjacent groups' to each other, and the carbon atoms of the formed alicyclic or aromatic monocyclic or polycyclic ring may be replaced by a heteroatom such as O, S, N, P, Si or Ge.

In the present invention, the alkyl group may be linear or branched. Specific examples thereof may include a methyl group, an ethyl group, a propyl group, an n-propyl group, an isopropyl group, a butyl group, an n-butyl group, an isobutyl group, a tert-butyl group, a sec-butyl group, a 1-methyl-butyl group, a 1-ethyl-butyl group, a pentyl group, an n-pentyl group, an isopentyl group, a neopentyl group, a tert-pentyl group, a hexyl group, an n-hexyl group, a 1-methylpentyl group, a 2-methylpentyl group, a 4-methyl-2-pentyl group, a 3,3-dimethylbutyl group, a 2-ethylbutyl group, a heptyl group, an n-heptyl group, a 1-methylhexyl group, a cyclopentylmethyl group, a cyclohexylmethyl group, an octyl group, an n-octyl group, a tert-octyl group, a 1-methylheptyl group, a 2-ethylhexyl group, a 2-propylpentyl group, an n-nonyl group, a 2,2-dimethylheptyl group, a 1-ethyl-propyl group, a 1,1-dimethyl-propyl group, an isohexyl group, a 2-methylpentyl group, a 4-methylhexyl group, a 5-methylhexyl group and the like, but are not limited thereto.

In the present invention, specific examples of the arylalkyl group may include phenylmethyl (benzyl), phenylethyl, phenylpropyl, naphthylmethyl, naphthylethyl and the like, but are not limited thereto.

In the present invention, specific examples of the alkylaryl group may include tolyl, xylenyl, dimethylnaphthyl, t-butylphenyl, t-butylnaphthyl, t-butylphenanthryl and the like, but are not limited thereto.

In the present invention, the alkenyl group includes linear or branched forms, and may be further substituted with other substituents. Specific examples thereof may include a vinyl group, a 1-propenyl group, an isopropenyl group, a 1-butenyl group, a 2-butenyl group, a 3-butenyl group, a 1-pentenyl group, a 2-pentenyl group, a 3-pentenyl group, a 3-methyl-1-butenyl group, a 1,3-butadienyl group, an allyl group, a 1-phenylvinyl-1-yl group, a 2-phenylvinyl-1-yl group, a 2,2-diphenylvinyl-1-yl group, a 2-phenyl-2-(naphthyl-1-yl)vinyl-1-yl group, a 2,2-bis(diphenyl-1-yl)vinyl-1-yl group, a stilbenyl group, a styrenyl group and the like, but are not limited thereto.

In the present invention, the alkynyl group also includes linear or branched forms, and may be further substituted with other substituents. Examples thereof may include ethynyl, 2-propynyl and the like, but are not limited thereto.

In the present invention, the cycloalkenyl group is a non-aromatic cyclic unsaturated hydrocarbon group having one or more carbon double bonds. Examples thereof may include cyclopropenyl, cyclobutenyl, cyclopentenyl, cyclohexenyl, cycloheptenyl, 1,3-cyclohexadienyl, 1,4-cyclohexadienyl, 2,4-cycloheptadienyl, 1,5-cyclooctadienyl and the like, but are not limited thereto.

In the present invention, the aromatic hydrocarbon ring or the aryl group may be monocyclic or polycyclic. The term 'polycyclic group' refers to a group directly linked to or fused with other cyclic groups, and the other cyclic group may be an aromatic hydrocarbon ring, but may also be other types of cyclic groups such as an aliphatic heteroring, an aliphatic hydrocarbon ring and an aromatic heteroring. Examples of the monocyclic aryl group may include a phenyl group, a biphenyl group, a terphenyl group and the like, and examples of the polycyclic aryl group may include a naphthyl group, an anthracenyl group, a phenanthrenyl group, a pyrenyl group, a perylenyl group, a tetracenyl group, a chrysenyl group, a fluorenyl group, an acenaphathcenyl group, a triphenylene group, a fluoranthrene group and the like, however, the scope of the present invention is not limited to these examples.

In addition, in the present invention, the arylene group refers to a divalent or higher group derived from an aromatic hydrocarbon group such as benzene, naphthalene, biphenyl, anthracene, fluorene or phenanthrene. A preferred arylene group is a divalent or trivalent arylene group. Specific examples of the arylene group may include a phenylene group, a biphenylene group, a naphthylene group, a fluorenylene group and the like. More specifically, a 1,4-phenylene group, a 1,3-phenylene group, a 1,2-phenylene group, a 4,4'-biphenylene group, a 4,3'-biphenylene group, a 1,4-naphthalenylene group, a 1,5-naphthalenylene group, a 1,3,5-phenylene group and the like may be included, however, the arylene group is not limited thereto.

In the present invention, the aromatic heteroring or the heteroaryl group is an aromatic ring including one or more of heteroatoms. Examples thereof may include a thiophene group, a furan group, a pyrrole group, an imidazole group, a thiazole group, an oxazole group, an oxadiazole group, a triazole group, a pyridyl group, a bipyridyl group, a pyrimidyl group, a triazine group, a triazole group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, an indolocarbazole group, a benzoxazole group, a benzimidazole group, a benzothiazole group, a benzocarbazole group, a benzothiophene group, a dibenzothiophene group, a benzofuranyl group, a dibenzofuranyl group, a phenanthroline group, a thiazolyl group, an isoxazolyl group, an oxadiazolyl group, a thiadiazolyl group, a benzothiazolyl group, a phenothiazinyl and the like, but are not limited thereto.

In addition, in the present invention, the heteroarylene group refers to a divalent or higher group derived from an aromatic group having one or more atoms other than carbon in the ring, such as pyridine, quinoline, pyrimidine, pyrazine, triazine, quinoxaline, quinazoline, dibenzofuran or dibenzothiophene. A preferred heteroarylene group is a divalent or trivalent heteroarylene group. Specific examples of the heteroarylene group may include a 2,6-pyridylene group, a 2,5-pyridylene group, a 3,5-pyridylene group, a 2,4,6-pyridylene group, a 2,4-pyrimidinylene group, a 2,5-pyrimidinylene group, a 4,6-pyrimidinylene group, a 2,4,6-pyrimidinylene group, a 2,4,6-triazinylene group, a 4,6-dibenzofuranylene group, a 2,6-dibenzofuranylene group, a 3,7-dibenzofuranylene group, a 4,6-dibenzothiophenylene group and the like, but are not limited thereto.

In the present invention, the aliphatic hydrocarbon ring or the cycloalkyl group refers to a non-aromatic ring formed only with carbon and hydrogen atoms. Examples thereof may include monocyclic or polycyclic groups, and the aliphatic hydrocarbon ring or the cycloalkyl group may be further substituted with other substituents. The term 'polycyclic group' refers to a group directly linked to or fused with other cyclic groups, and the other cyclic group may be an aliphatic hydrocarbon ring, but may also be other types of cyclic groups such as an aliphatic heteroring, an aromatic hydrocarbon ring and an aromatic heteroring. Specific examples thereof may include a cycloalkyl group such as a cyclopropyl group, a cyclobutyl group, a cyclopentyl group, an adamantyl group, a bicycloheptanyl group, a 3-methylcyclopentyl group, a 2,3-dimethylcyclopentyl group, a cyclohexyl group, a 3-methylcyclohexyl group, a 4-methylcyclohexyl group, a 2,3-dimethylcyclohexyl group, a 3,4,5-trimethylcyclohexyl group, a 4-tert-butylcyclohexyl group, a cycloheptyl group and a cyclooctyl group, a cycloalkane group such as a cyclohexane group and a cyclopentane group, and a cycloalkene group such as a cyclohexene group and a cyclobutene group, but are not limited thereto.

In the present invention, the aliphatic heteroring or the heterocycloalkyl group refers to an aliphatic ring including one or more of heteroatoms such as O, S, Se, N, Si or Ge, includes monocyclic or polycyclic groups as well, and may be further substituted with other substituents. The term 'polycyclic group' refers to a group in which heterocycloalkyl, heterocycloalkane or the like is directly linked to or fused with other cyclic groups, and the other cyclic group may be an aliphatic heteroring, but may also be other types of cyclic groups such as an aliphatic hydrocarbon ring, an aromatic hydrocarbon ring and an aromatic heteroring.

In the present invention, the ring (cyclic group) in which an aliphatic ring and an aromatic ring are fused is an aliphatic-aromatic mixed ring (cyclic group), and refers to a ring in which two or more rings are linked to and fused with each other, and an aliphatic ring and an aromatic ring are fused. More specifically, the ring (cyclic group) in which an aliphatic ring and an aromatic ring are fused may include an aromatic hydrocarbon ring (cyclic group) fused with an aliphatic hydrocarbon ring, an aromatic hydrocarbon ring (cyclic group) fused with an aliphatic heteroring, an aromatic heteroring (cyclic group) fused with an aliphatic hydrocarbon ring, an aromatic heteroring (cyclic group) fused with an aliphatic heteroring, an aliphatic hydrocarbon ring (cyclic group) fused with an aromatic hydrocarbon ring, an aliphatic hydrocarbon ring (cyclic group) fused with an aromatic heteroring, an aliphatic heteroring (cyclic group) fused with an aromatic hydrocarbon ring, an aliphatic heteroring (cyclic group) fused with an aromatic heteroring, and the like, and specific examples thereof may include a tetrahydronaphthyl group, a tetrahydrobenzocycloheptene group, a tetrahydrophenanthrene group, a tetrahydroanthracenyl group, an octahydrotriphenylene group, a tetrahydrobenzothiophene group, a tetrahydrobenzofuranyl group, a tetrahydrocarbazole group, a tetrahydroquinoline group and the like. In addition, carbon in the ring (cyclic group) in which an aliphatic ring and an aromatic ring are fused may be substituted with a heteroatom such as O, S, N, P, Si or Ge.

In the present invention, the alkoxy group may specifically be methoxy, ethoxy, propoxy, isobutyloxy, sec-butyloxy, pentyloxy, iso-amyloxy, hexyloxy or the like, but is not limited thereto.

In the present invention, the silyl group may include -SiH₃, an alkylsilyl group, an arylsilyl group, an alkylarylsilyl group, an arylheteroarylsilyl group, a heteroarylsilyl group and the like. The arylsilyl group refers to a silyl group in which one, two or three hydrogen atoms are substituted with an aryl group in -SiH₃, the alkylsilyl group refers to a silyl group in which one, two or three hydrogen atoms are substituted with an alkyl group in -SiH₃, the alkylarylsilyl group refers to a silyl group including one or two alkyl groups and two or one aryl groups corresponding thereto by at least one hydrogen atom being substituted with an alkyl group and an aryl group in -SiH₃, the arylheteroarylsilyl group refers to a silyl group including one or two aryl groups and two or one heteroaryl groups corresponding thereto by at least one hydrogen atom being substituted with an aryl group and a heteroaryl group in -SiH₃, and the heteroarylsilyl group refers to a silyl group in which one, two or three hydrogen atoms are substituted with a heteroaryl group in - SiH₃. Examples of the arylsilyl group may include a substituted or unsubstituted monoarylsilyl group, a substituted or unsubstituted diarylsilyl group or a substituted or unsubstituted triarylsilyl group, and the same also applies to the alkylsilyl group and the heteroarylsilyl group. For example, in the case of the monoarylsilyl group, the remaining two hydrogen atoms may be substituted with an alkyl group, a cycloalkyl group, a heteroaryl group, a cyclic group in which an aliphatic ring and an aromatic ring are fused, or the like, however, the substitution is not limited thereto.

Herein, the aryl group in each of the arylsilyl group, the heteroarylsilyl group and the arylheteroarylsilyl group may be a monocyclic aryl group or a polycyclic aryl group, and the heteroaryl group in each of the arylsilyl group, the heteroarylsilyl group and the arylheteroarylsilyl group may be a monocyclic heteroaryl group or a polycyclic heteroaryl group.

In addition, specific examples of the silyl group may include trimethylsilyl, triethylsilyl, triphenylsilyl, trimethoxysilyl, dimethoxyphenylsilyl, diphenylmethylsilyl, diphenylvinylsilyl, methylcyclobutylsilyl, dimethylfurylsilyl and the like, and one or more hydrogen atoms in the silyl group may be substituted with the same substituents as in the case of the aryl group.

In addition, in the present invention, the silyl group is substituted with an aryl group or a heteroaryl group.

In the present invention, the amine group may include -NH₂, an alkylamine group, an arylamine group, an alkylarylamine group, an arylheteroarylamine group, a heteroarylamine group and the like. The arylamine group refers to an amine group in which one or two hydrogen atoms are substituted with an aryl group in -NH₂, the alkylamine group refers to an amine group in which one or two hydrogen atoms are substituted with an alkyl group in -NH₂, and the alkylarylamine group refers to an amine group in which one hydrogen atom is substituted with an alkyl group and the other hydrogen atom is substituted with an aryl group in -NH₂. The arylheteroarylamine group refers to an amine group in which one hydrogen atom is substituted with an aryl group and the other hydrogen atom is substituted with a heteroaryl group in -NH₂, and the heteroarylamine group refers to an amine group in which one or two hydrogen atoms are substituted with a heteroaryl group in -NH₂. Examples of the arylamine group may include a substituted or unsubstituted monoarylamine group or a substituted or unsubstituted diarylamine group, and the same also applies to the alkylamine group and the heteroarylamine group. For example, in the case of the monoarylamine group, the remaining one hydrogen atom may be substituted with an alkyl group, a cycloalkyl group, a heteroaryl group, a cyclic group in which an aliphatic ring and an aromatic ring are fused, or the like, however, the substitution is not limited thereto.

Herein, the aryl group in each of the arylamine group, the heteroarylamine group and the arylheteroarylamine group may be a monocyclic aryl group or a polycyclic aryl group, and the heteroaryl group in each of the arylamine group, the heteroarylamine group and the arylheteroarylamine group may be a monocyclic heteroaryl group or a polycyclic heteroaryl group.

In addition, in the present invention, the amine group is substituted with an aryl group or a heteroaryl group
In the present invention, the germanium group (or germane group) may include -GeH₃, an alkylgermanium group, an arylgermanium group, a heteroarylgermanium group, an alkylarylgermanium group, an alkylheteroarylgermanium group, an arylheteroarylgermanium group and the like. The definitions thereof follow those of the silyl group described above, except that the silicon atom (Si) in the silyl group is replaced with a germanium atom (Ge), and may be applied to each substituent.

In addition, specific examples of the germanium group may include trimethylgermane, triethylgermane, triphenylgermane, trimethoxygermane, dimethoxyphenylgermane, diphenylmethylgermane, diphenylvinylgermane, methylcyclobutylgermane, dimethylfurylgermane and the like, and one or more hydrogen atoms in the germanium group may be substituted with the same substituents as in the case of the aryl group.

In addition, in the present invention, the germanium group is substituted with an aryl group or a heteroaryl group.

In the present invention, the cycloalkyl group, the aryl group and the heteroaryl group in the cycloalkyloxy group, the aryloxy group, the heteroaryloxy group, the cycloalkylthioxy group, the arylthioxy group and the heteroarylthioxy group are the same as the examples of the cycloalkyl group, the aryl group and the heteroaryl group provided above. Specific examples of the aryloxy group may include a phenoxy group, a p-tolyloxy group, an m-tolyloxy group, a 3,5-dimethyl-phenoxy group, a 2,4,6-trimethylphenoxy group, a p-tert-butylphenoxy group, a 3-biphenyloxy group, a 4-biphenyloxy group, a 1-naphthyloxy group, a 2-naphthyloxy group, a 4-methyl-1-naphthyloxy group, a 5-methyl-2-naphthyloxy group, a 1-anthryloxy group, a 2-anthryloxy group, a 9-anthryloxy group, a 1-phenanthryloxy group, a 3-phenanthryloxy group, a 9-phenanthryloxy group and the like, and specific examples of the arylthioxy group may include a phenylthioxy group, a 2-methylphenylthioxy group, a 4-tert-butylphenylthioxy group and the like. However, the aryloxy group and the arylthioxy group are not limited thereto.

In the present invention, examples of the halogen group include fluorine, chlorine, bromine or iodine.

According to one embodiment of the present invention, the polycyclic compound represented by [Chemical Formula 1] or [Chemical Formula 2] may be any one selected from compounds represented by the following chemical formulae, however, the scope of the present invention is not limited thereby.

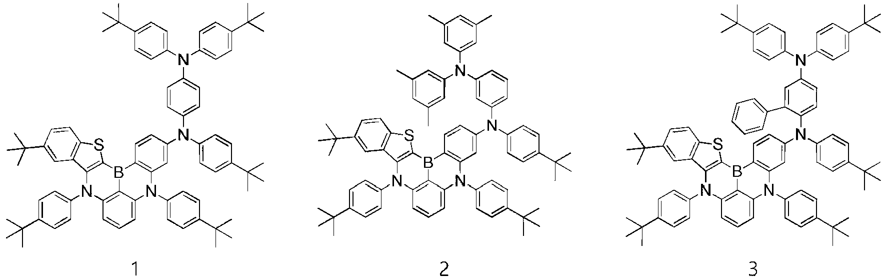

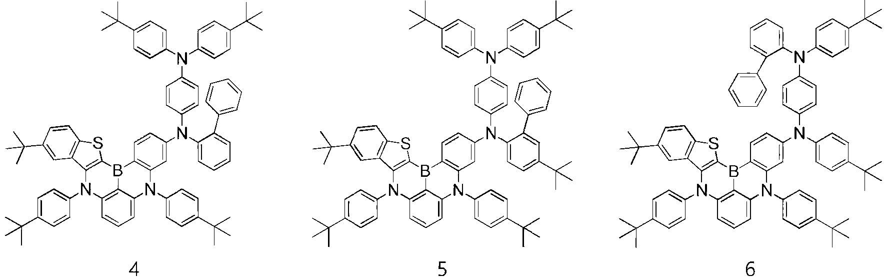

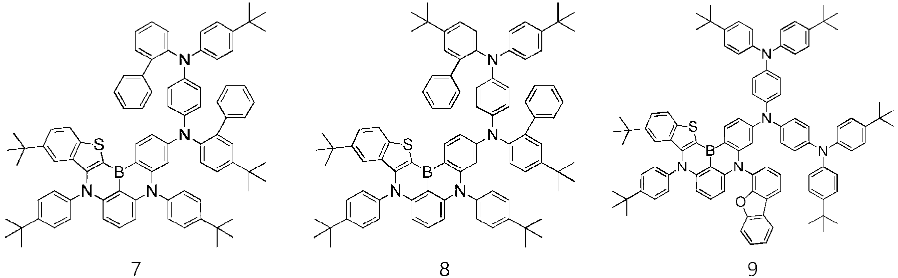

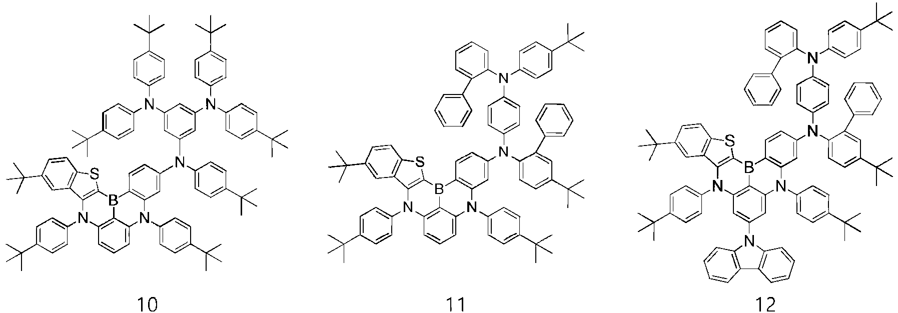

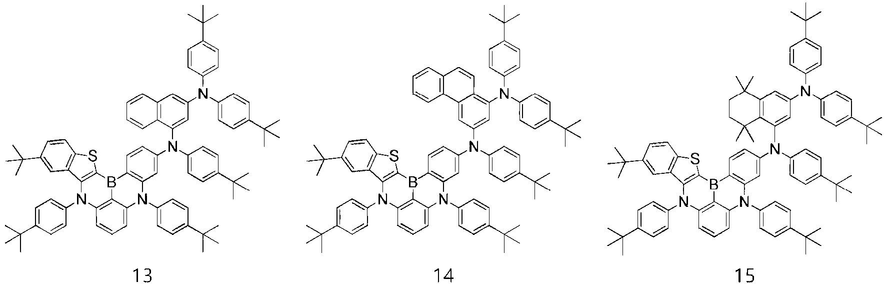

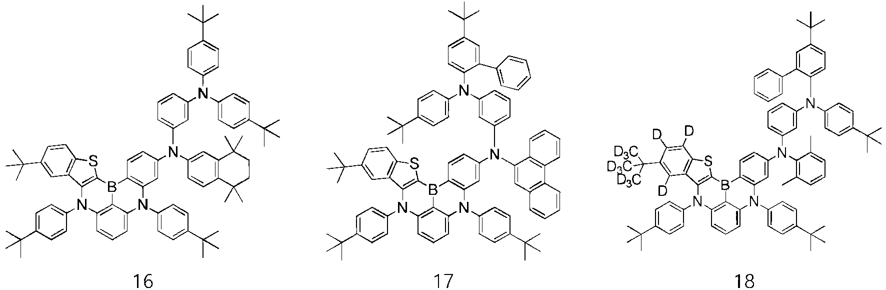

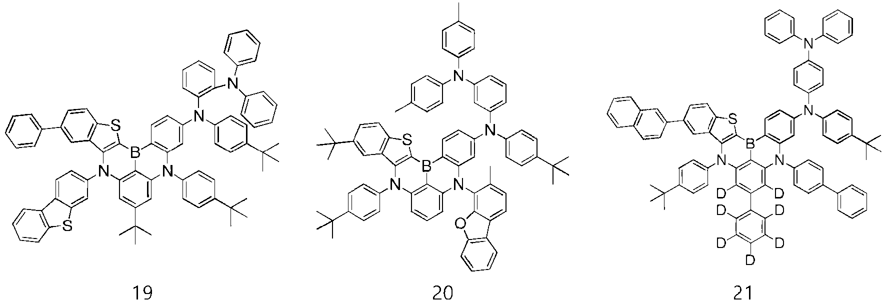

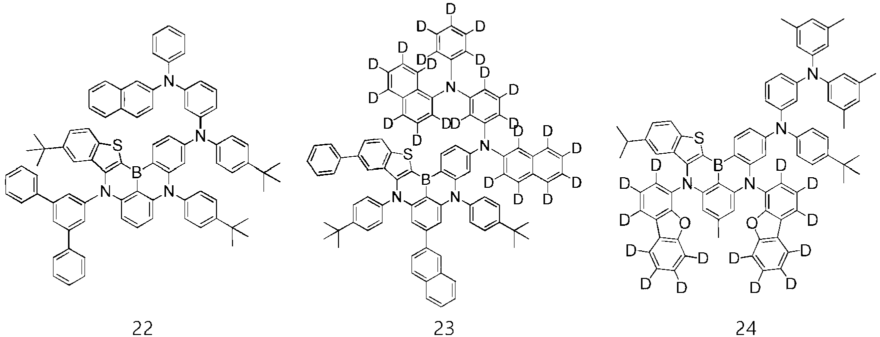

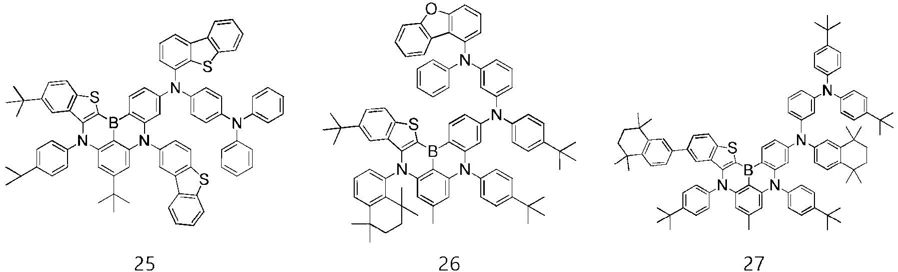

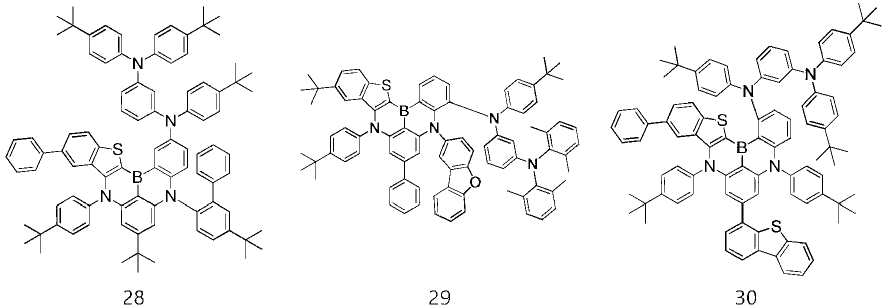

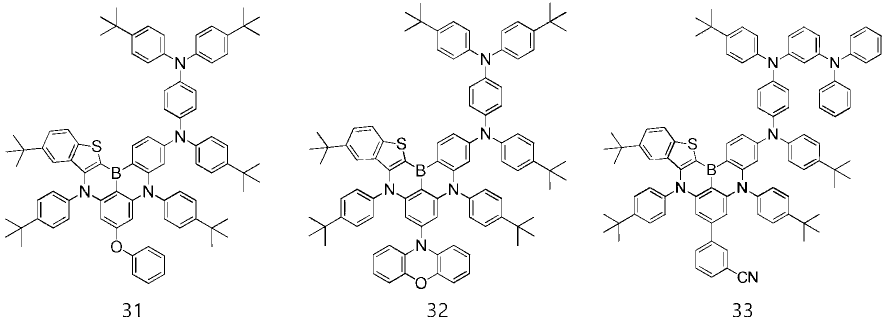

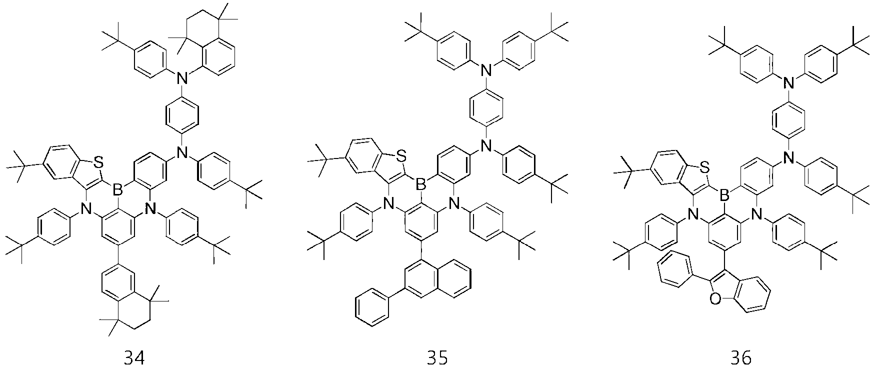

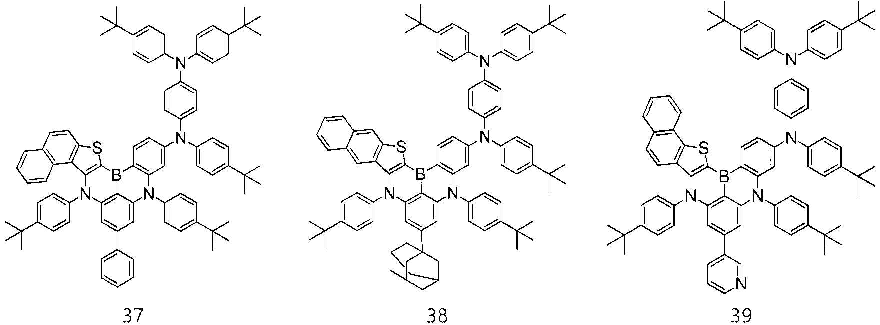

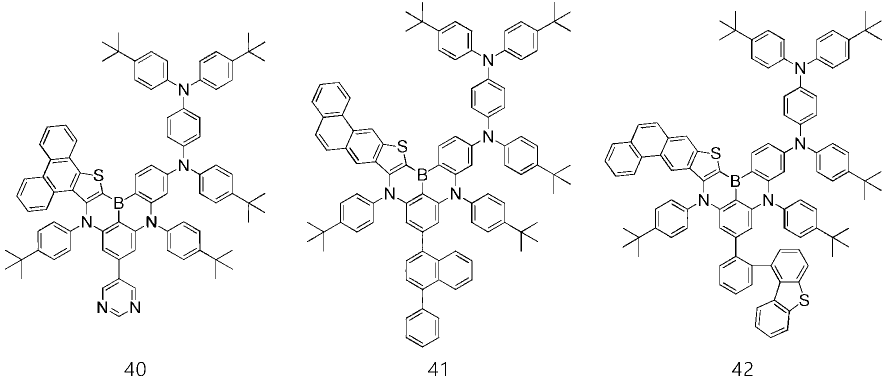

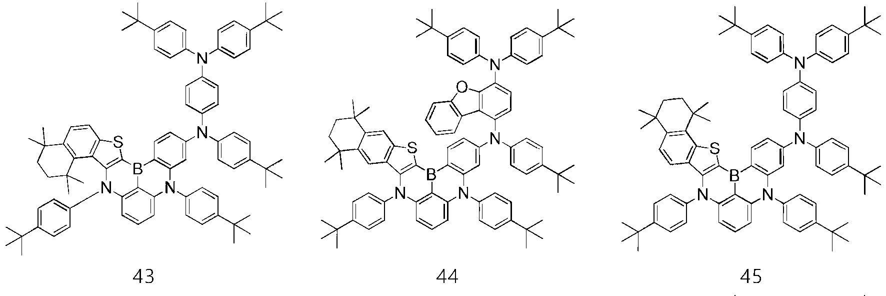

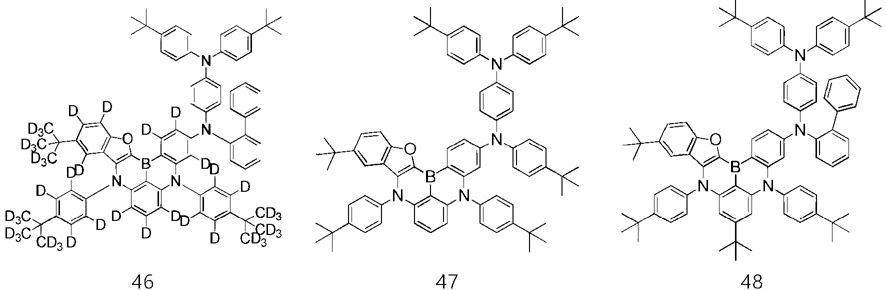

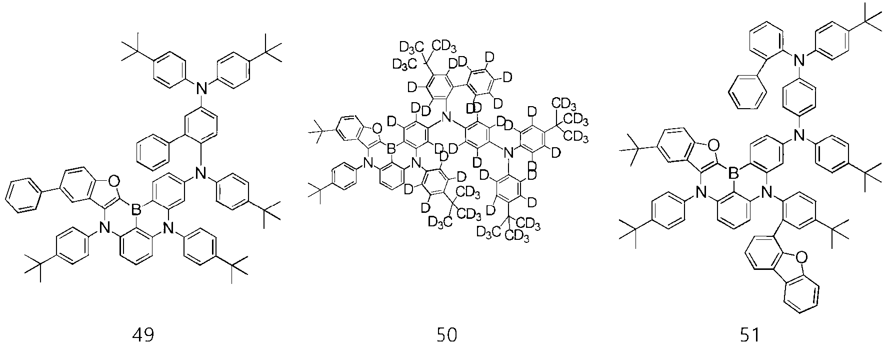

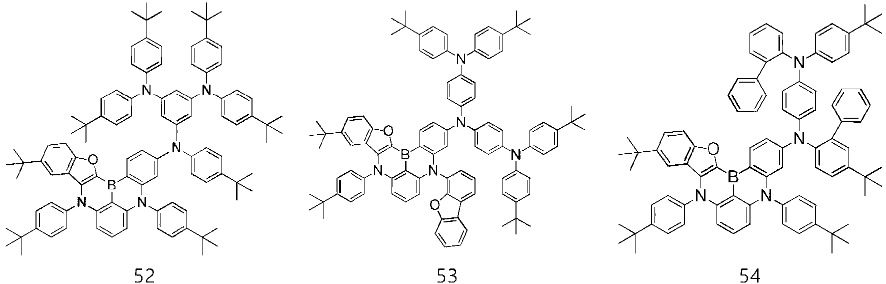

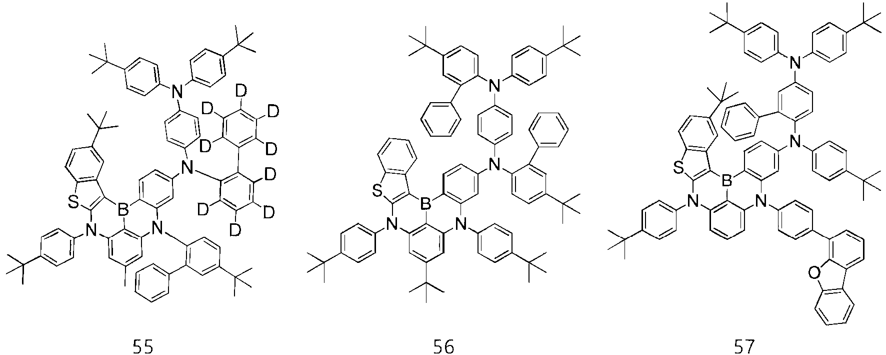

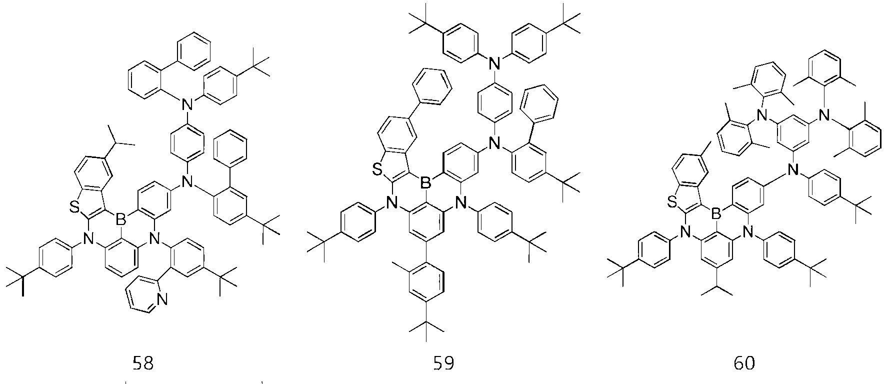

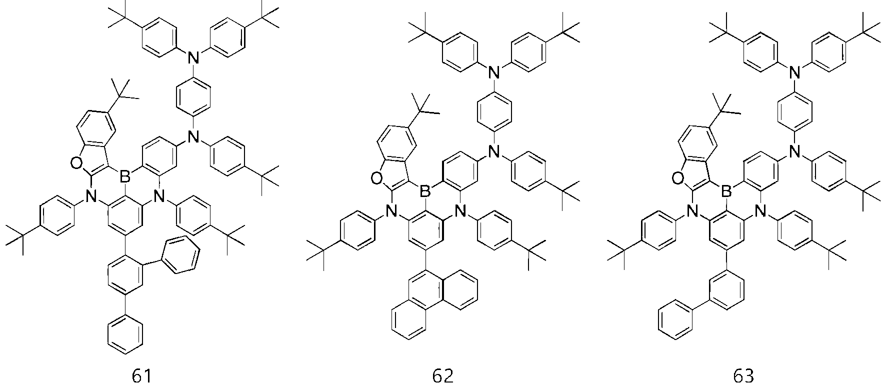

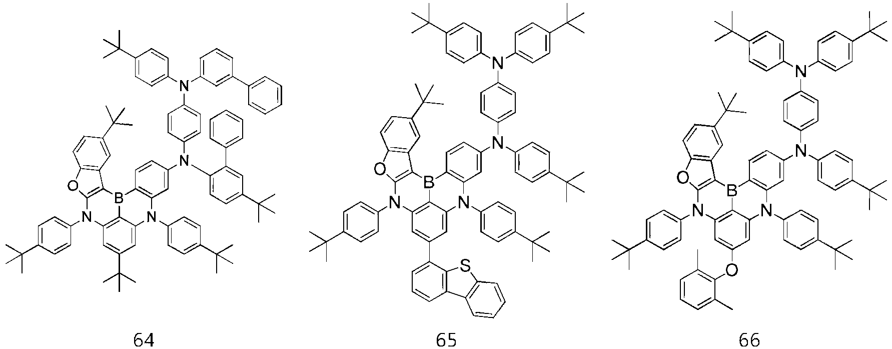

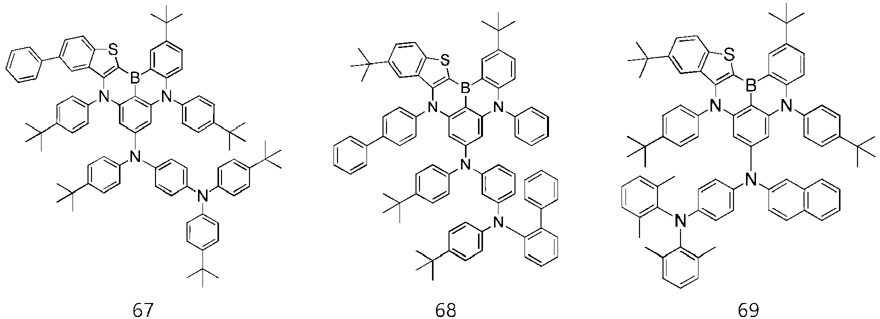

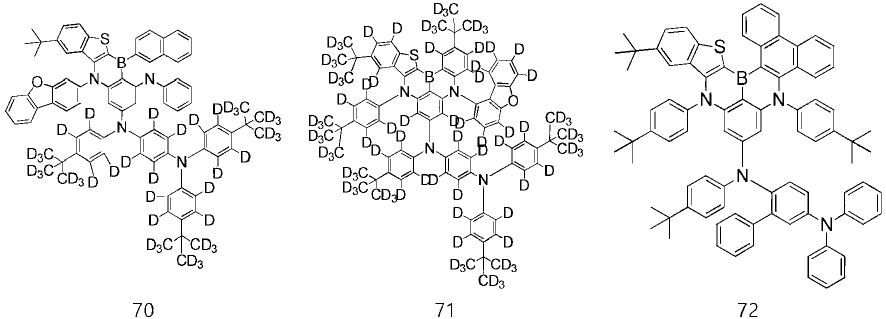

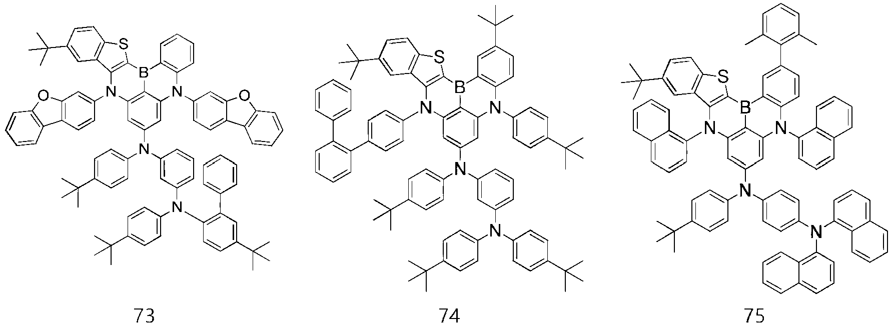

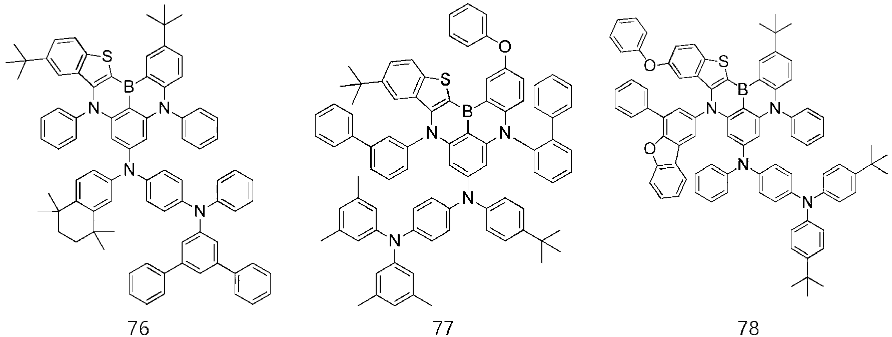

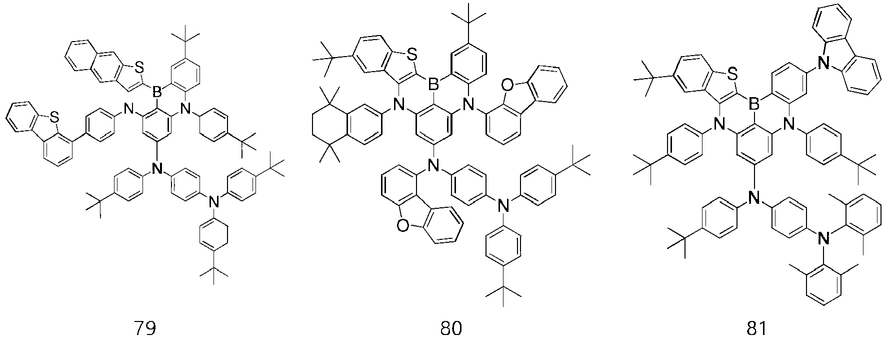

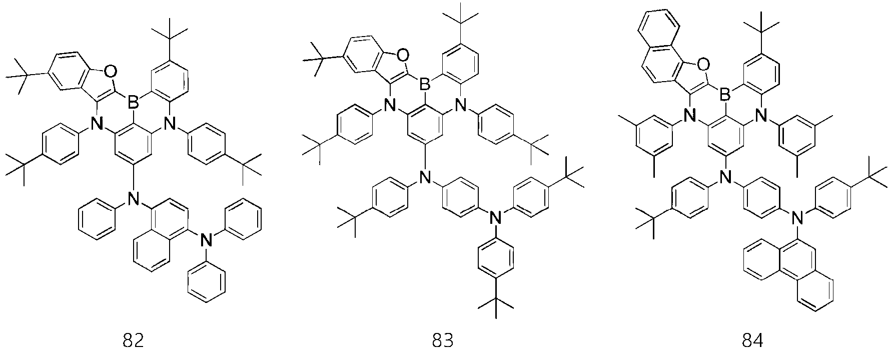

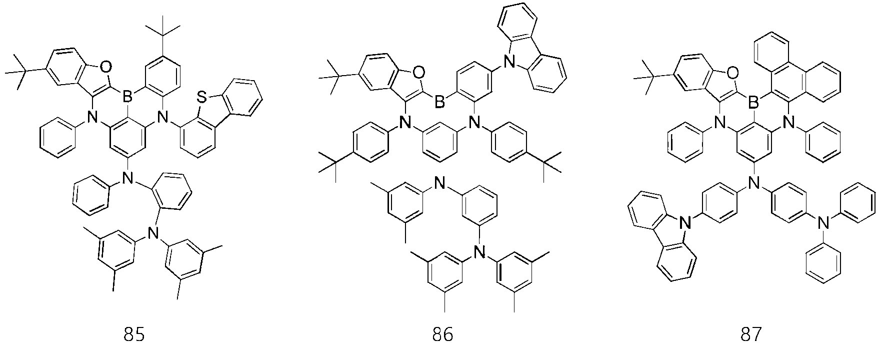

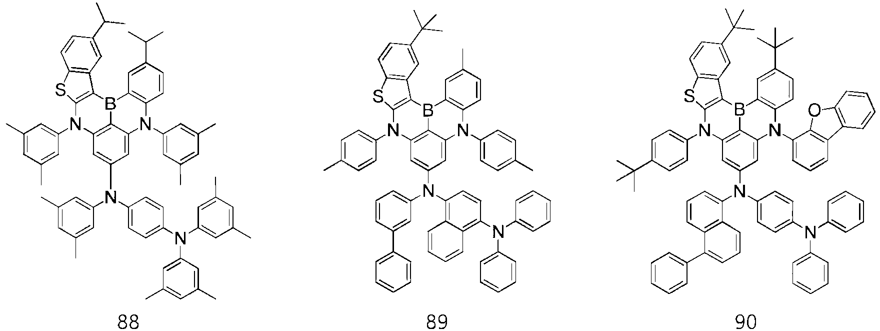

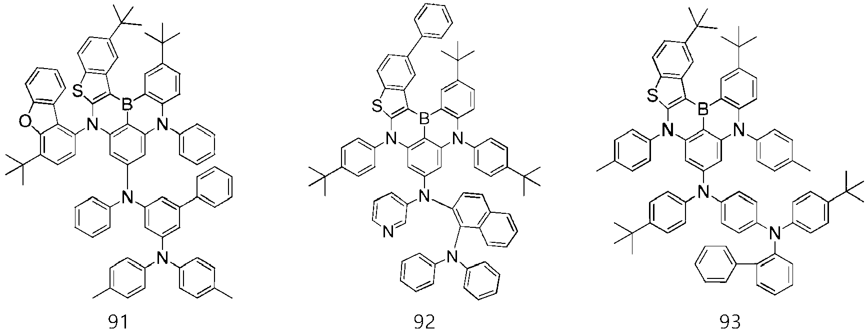

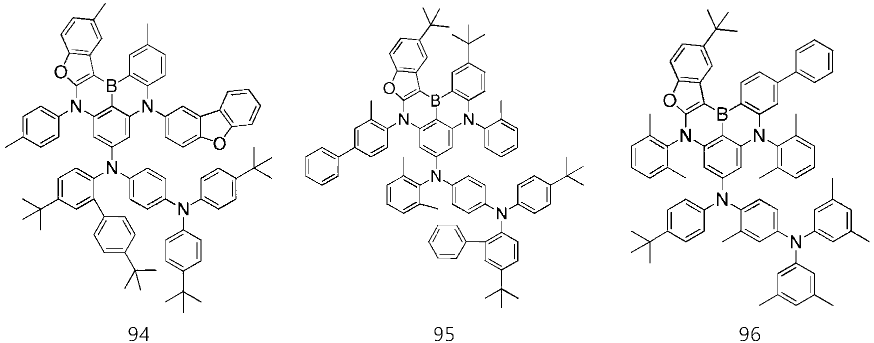

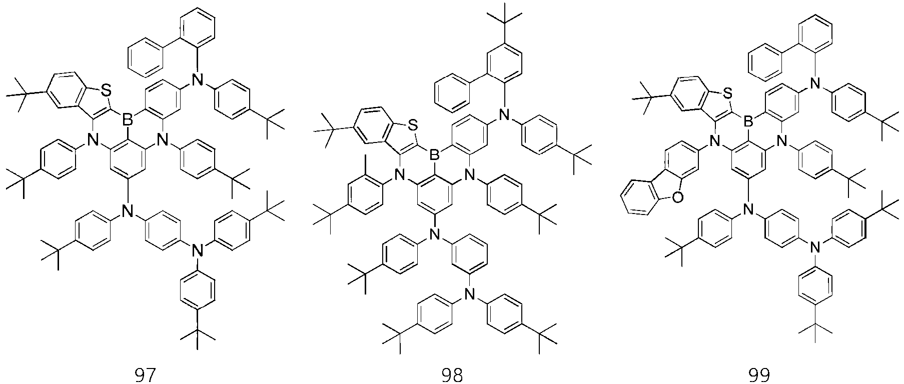

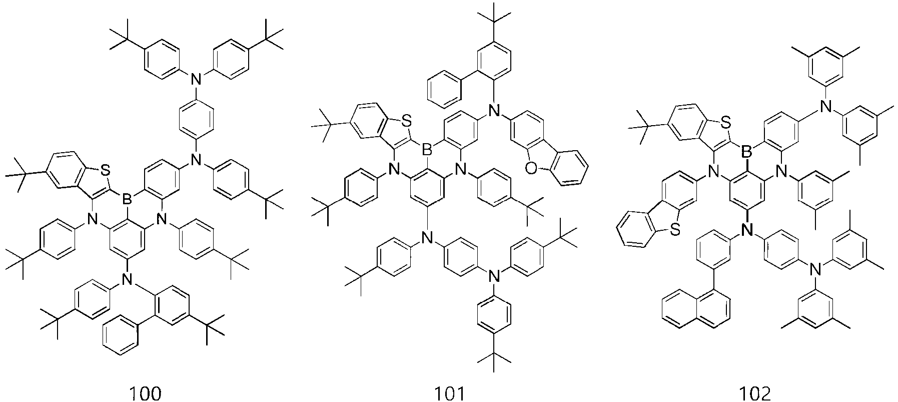

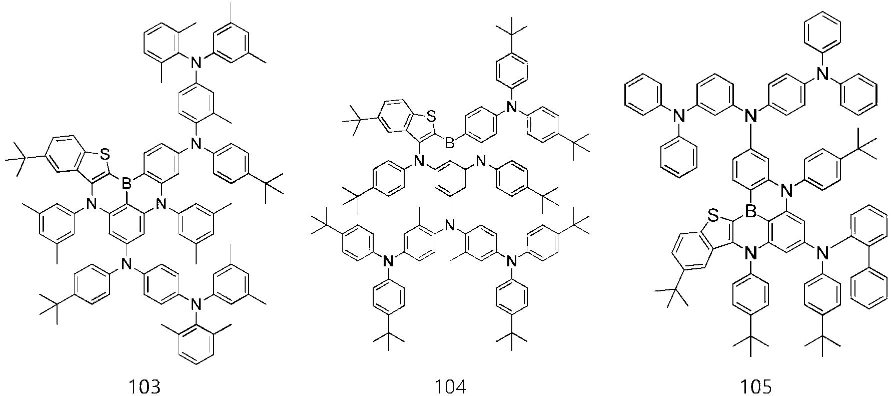

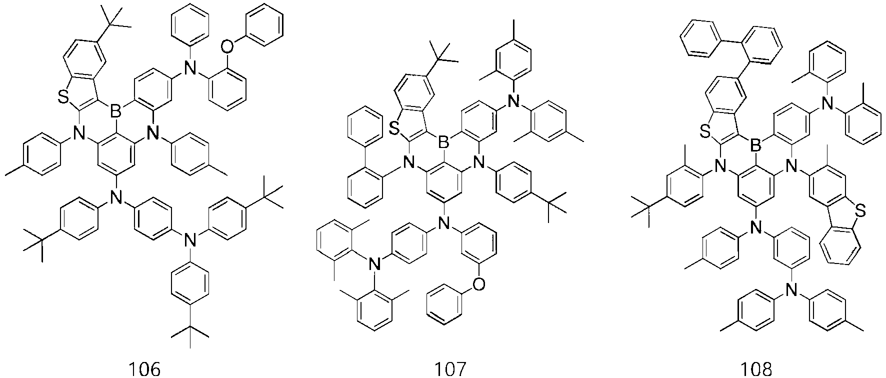

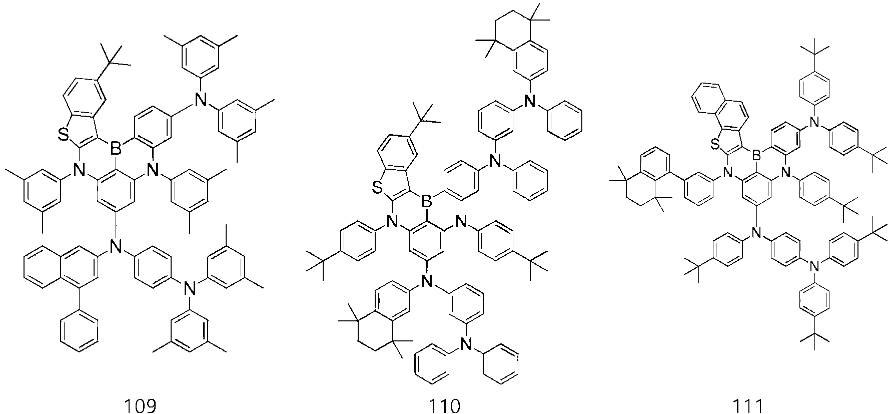

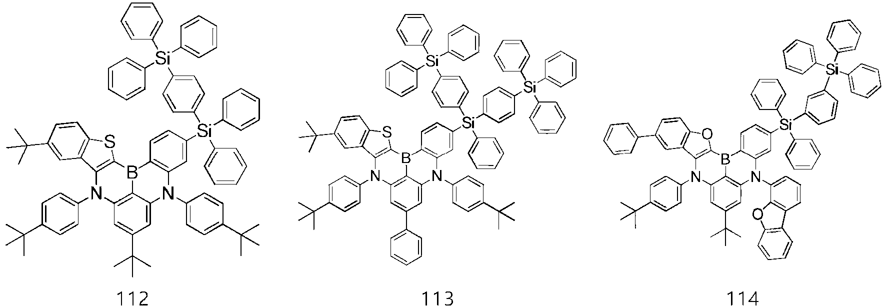

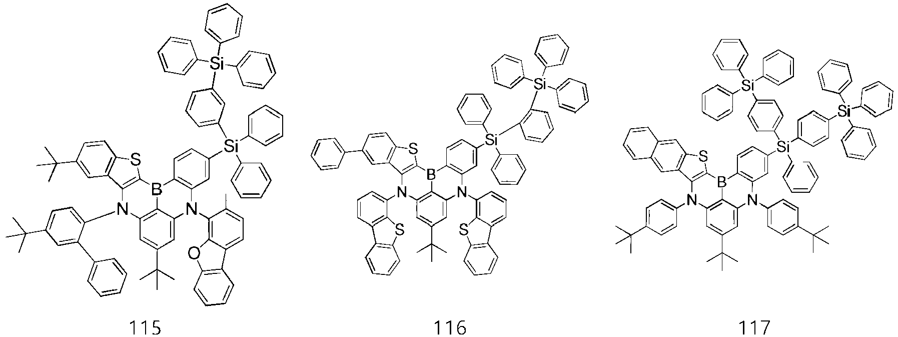

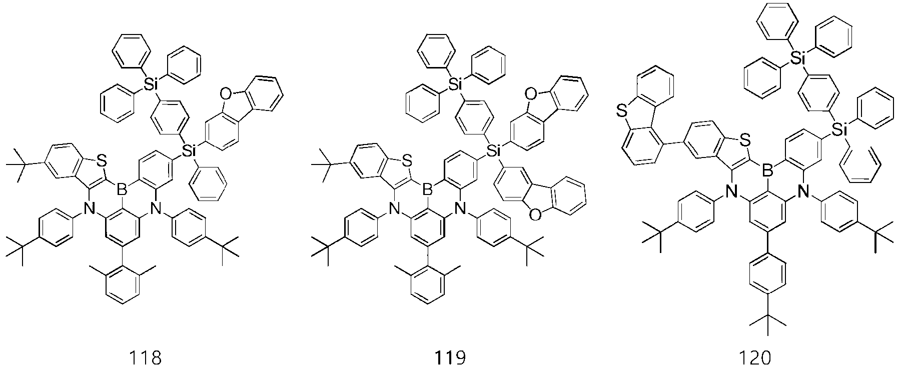

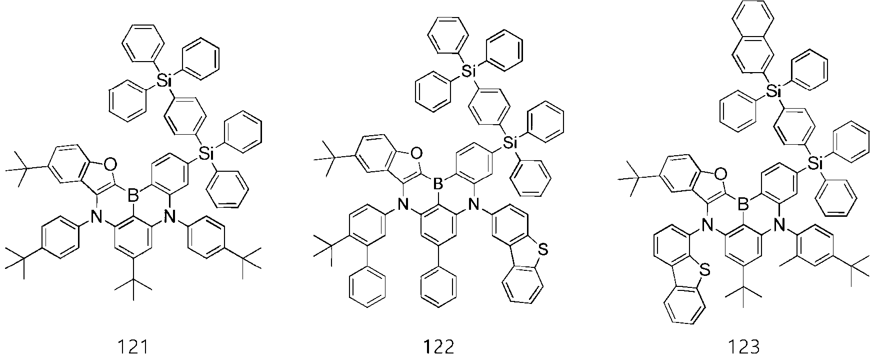

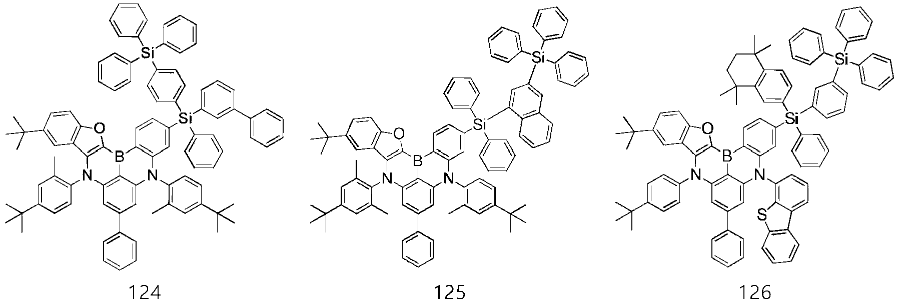

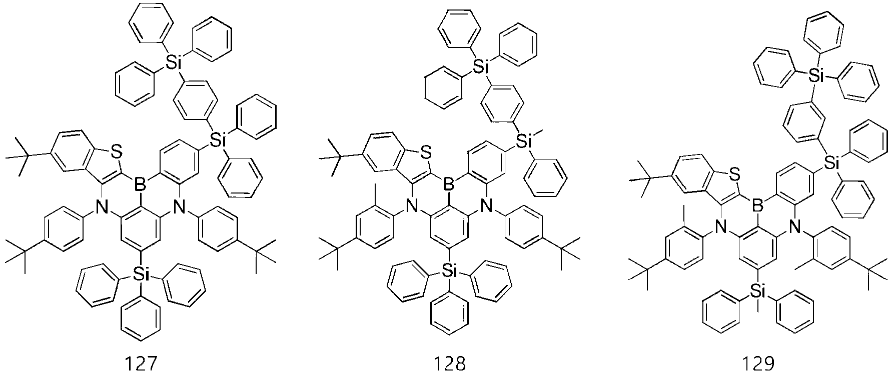

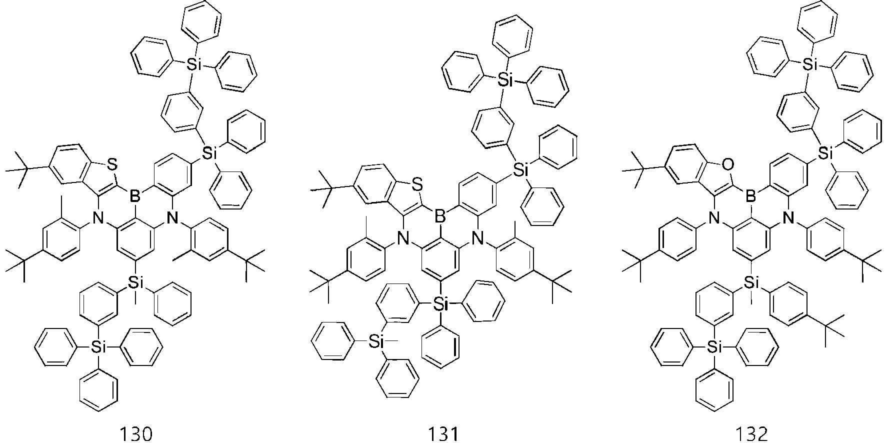

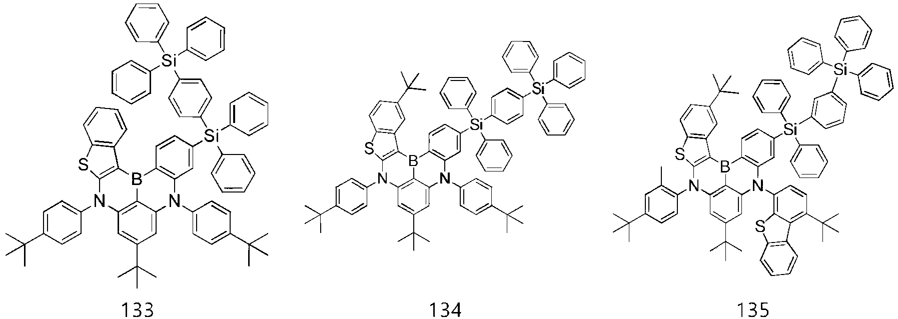

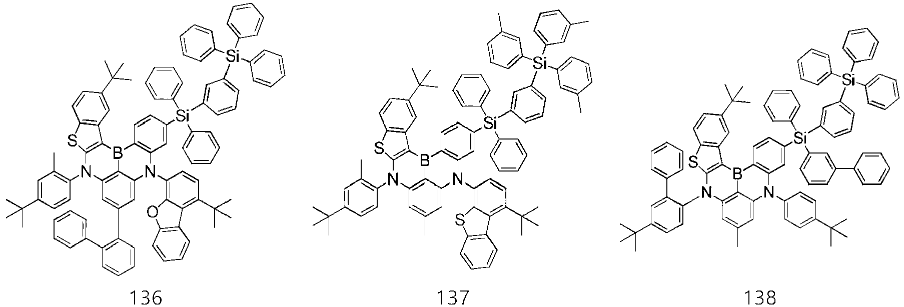

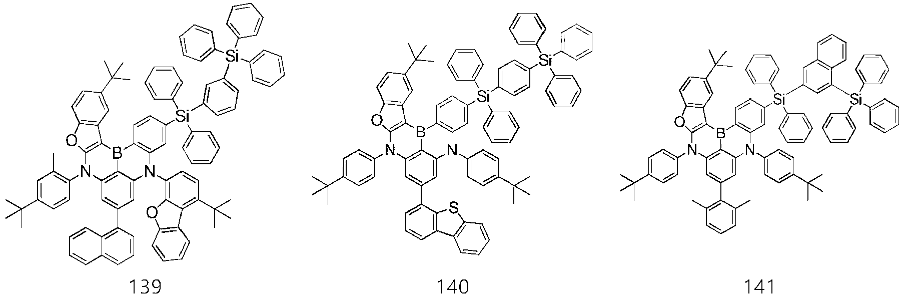

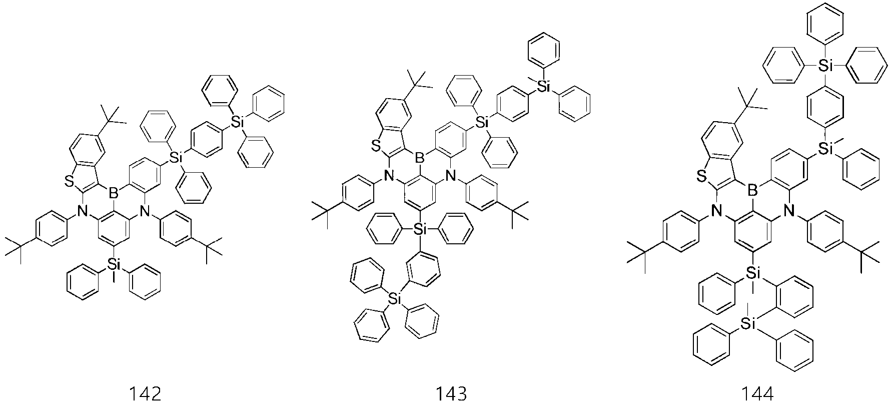

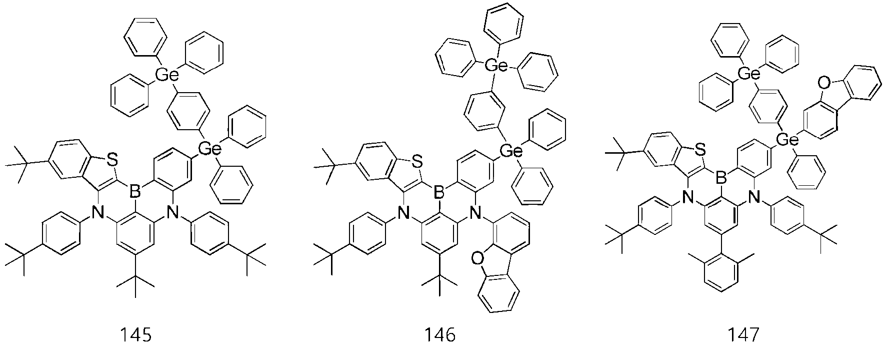

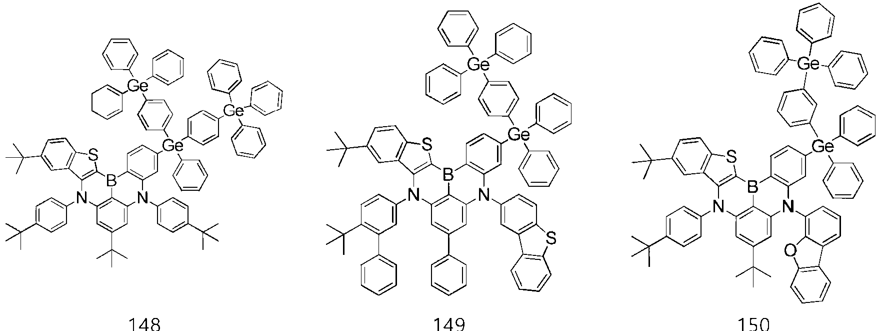

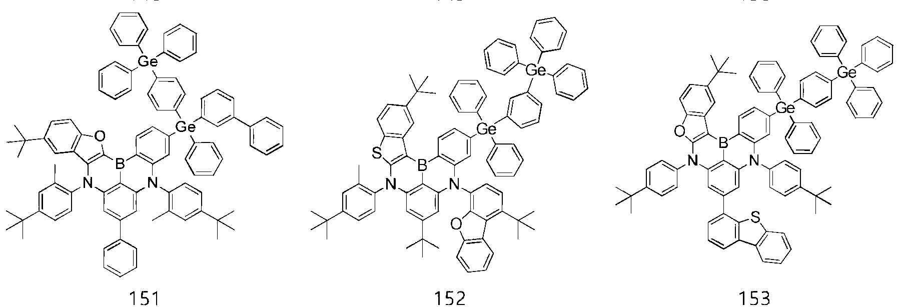

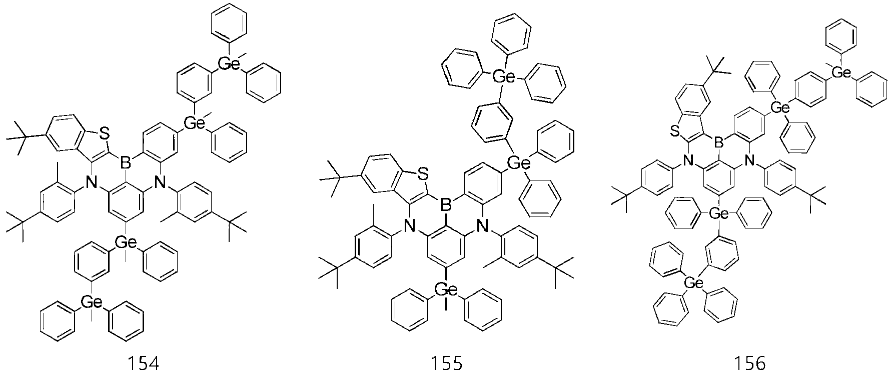

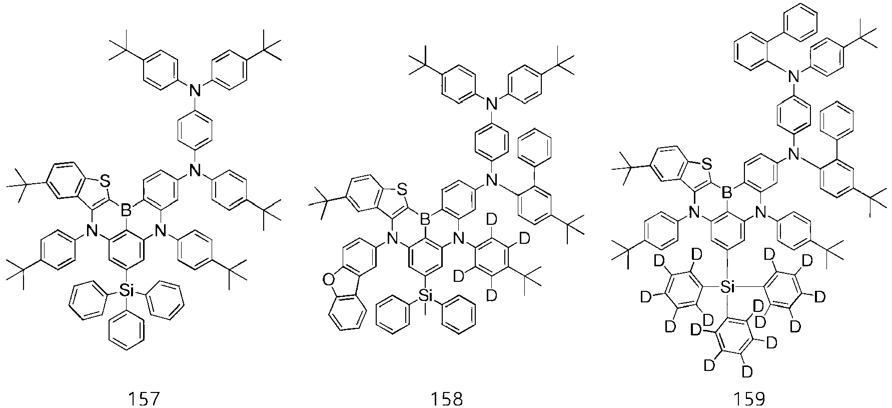

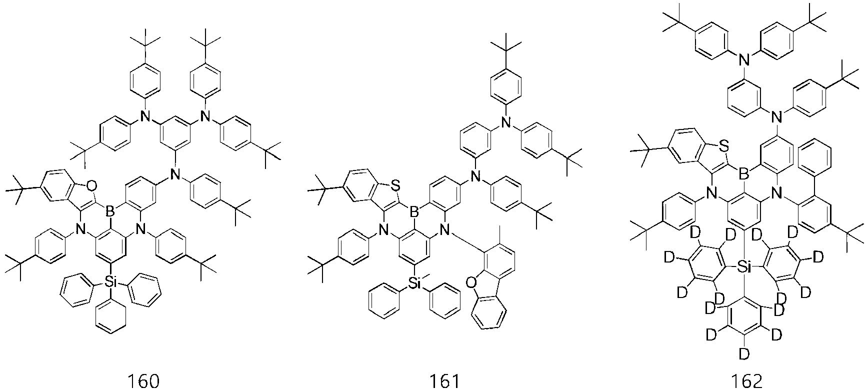

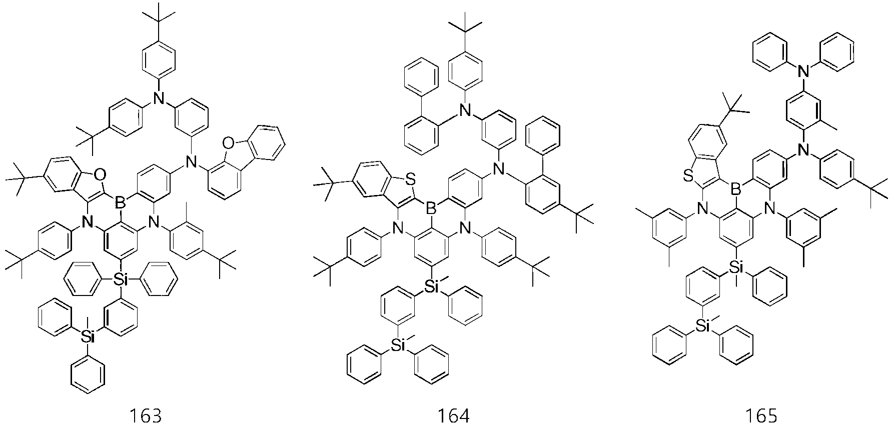

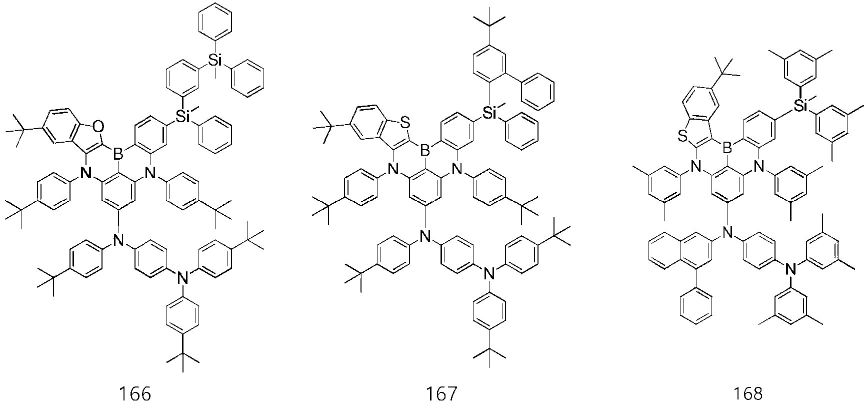

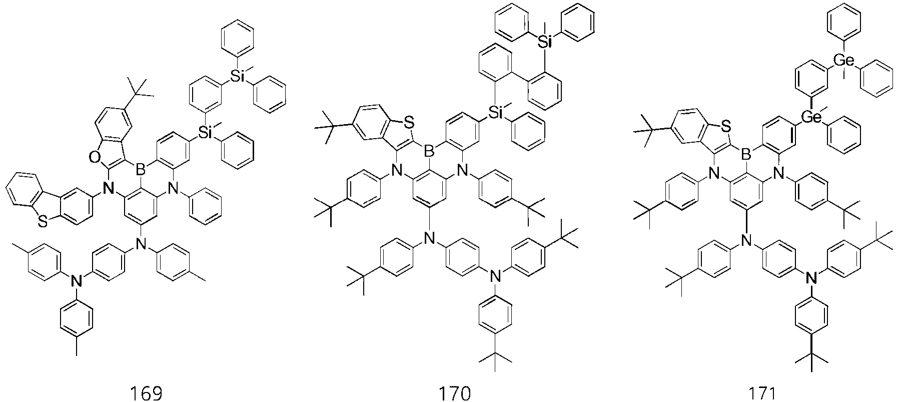

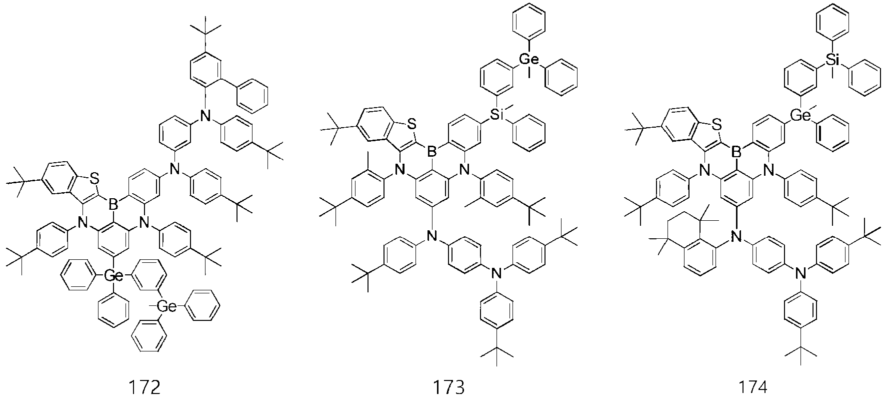

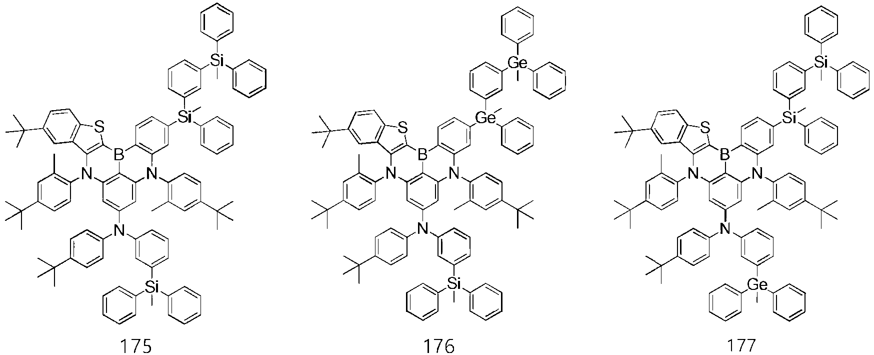

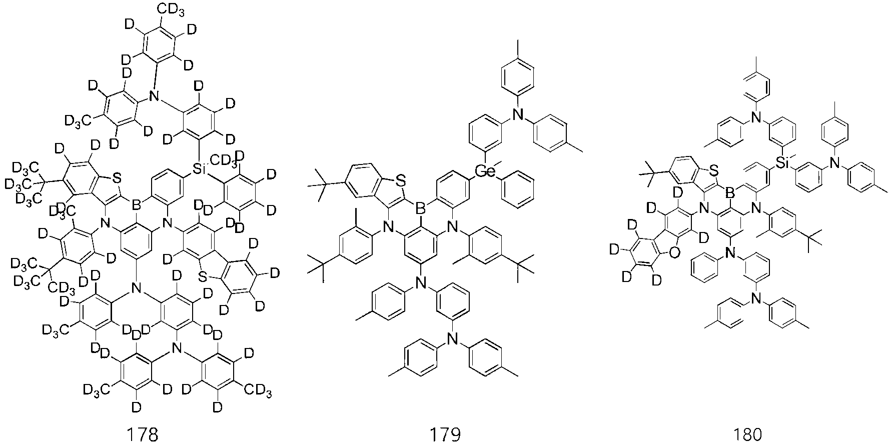

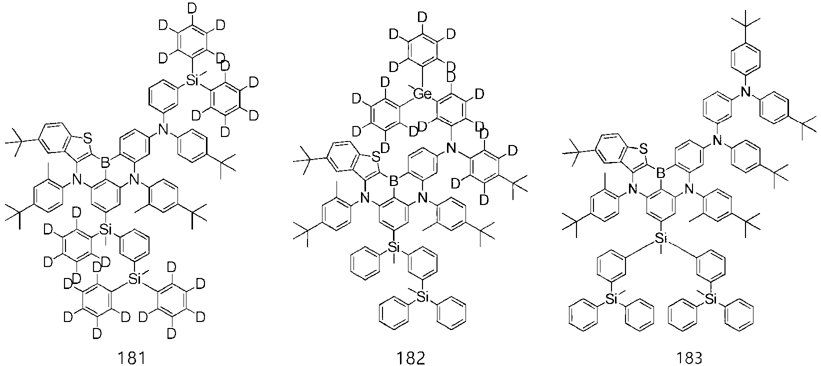

In addition, another aspect of the present invention relates to an organic light-emitting device including: a first electrode; a second electrode; and one or more organic layers interposed between the first electrode and the second electrode, wherein the organic layer, preferably a light-emitting layer including a host and a dopant, includes the compound represented by the following [Chemical Formula 1] or [Chemical Formula 2] defined above as a dopant material of the light-emitting layer.

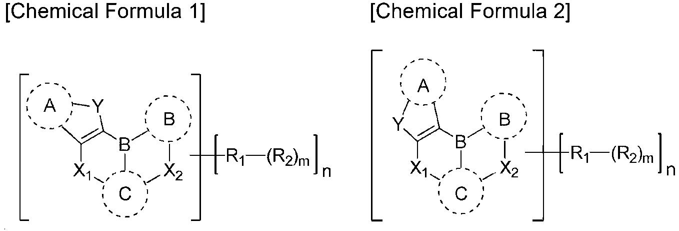

In addition, in the present invention, each light-emitting layer has a structure composed of a host and a dopant, and herein, the content of the dopant may be typically selected in a range of about 0.01 parts by weight to about 20 parts by weight based on about 100 parts by weight of the host, however, the dopant content is not limited thereto.

In addition, the light-emitting layer may further include various host and dopant materials in addition to the compound according to the present invention, and accordingly, in the light-emitting layer, one or more compounds different from each other may be mixed or co-deposited and used as the dopant material as well as the host material.

Thus, as the dopant, at least one other compound in addition to one polycyclic compound represented by [Chemical Formula 1] or [Chemical Formula 2] may be mixed or co-deposited and used, and at least one of the compounds mixed or co-deposited and used may be an organometallic compound.

In addition, the organic light-emitting device according to a specific embodiment of the present invention may include at least one anthracene compound represented by the following [Chemical Formula 3] as the host.

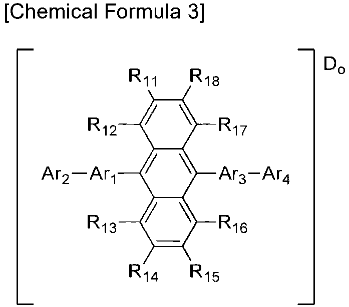

In [Chemical Formula 3], R₁₁ to R₁₈ are the same as or different from each other, and each independently selected from hydrogen, deuterium, tritium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted cyclic group in which a C₃-C₃₀ aliphatic ring and a C₅-C₃₀ aromatic ring are fused, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group.

Ar₁ and Ar₃ are the same as or different from each other, and each independently a single bond, or selected from a substituted or unsubstituted C₆-C₃₀ arylene group, a substituted or unsubstituted C₅-C₃₀ heteroarylene group, and a substituted or unsubstituted divalent cyclic group in which a C₃-C₃₀ aliphatic ring and a C₅-C₃₀ aromatic ring are fused.

Ar₂ and Ar₄ are the same as or different from each other, and each independently selected from a substituted or unsubstituted C₆-C₅₀ aryl group, a substituted or unsubstituted C₃-C₃₀ cycloalkyl group, a substituted or unsubstituted C₃-C₃₀ heterocycloalkyl group, a substituted or unsubstituted C₂-C₅₀ heteroaryl group, and a substituted or unsubstituted cyclic group in which a C₃-C₃₀ aliphatic ring and a C₅-C₃₀ aromatic ring are fused.

Dₒ refers to the number of hydrogen atoms in [Chemical Formula 3] substituted with deuterium or tritium, and o is an integer of 0 to 50.

The 'substituted' in the 'substituted or unsubstituted' in [Chemical Formula 3] means being substituted with one or more substituents selected from the group consisting of deuterium, tritium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a cyclic group in which a C₃-C₂₄ aliphatic ring and a C₅-C₂₄ aromatic ring are fused, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, and when there are two or more substituents, they are the same as or different from each other, and at least one hydrogen atom in each of the substituents may be substituted with deuterium or tritium.

In addition, the organic light-emitting device according to a specific embodiment of the present invention may include at least one anthracene compound represented by the following [Chemical Formula 3-1] as the host.

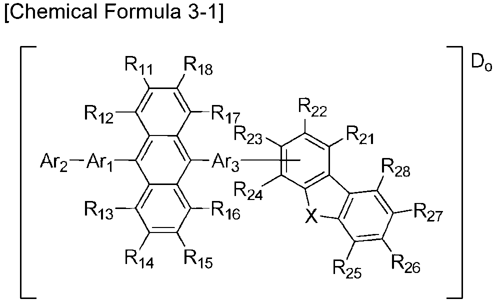

In [Chemical Formula 3-1], X is O or S, Ar₁ and Ar₃ are the same as or different from each other, and each independently a single bond, or selected from a substituted or unsubstituted C₆-C₃₀ arylene group, a substituted or unsubstituted C₅-C₃₀ heteroarylene group, and a substituted or unsubstituted divalent cyclic group in which a C₃-C₃₀ aliphatic ring and a C₅-C₃₀ aromatic ring are fused.

Ar₂ is selected from a substituted or unsubstituted C₆-C₅₀ aryl group, a substituted or unsubstituted C₃-C₃₀ cycloalkyl group, a substituted or unsubstituted C₃-C₃₀ heterocycloalkyl group, a substituted or unsubstituted C₂-C₅₀ heteroaryl group, and a substituted or unsubstituted cyclic group in which a C₃-C₃₀ aliphatic ring and a C₅-C₃₀ aromatic ring are fused.

One of R₂₁ to R₂₄ is a single bond linked to Ar₃.

The remaining substituents among R₁₁ to R₁₈ and R₂₁ to R₂₈, excluding the single bond linked to Ar₃ are the same as or different from each other, and each independently selected from hydrogen, deuterium, tritium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted cyclic group in which a C₃-C₃₀ aliphatic ring and a C₅-C₃₀ aromatic ring are fused, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group.

Two or more adjacent substituents among R₂₁ to R₂₈ may be linked to each other to form an alicyclic or aromatic monocyclic or polycyclic ring, and the carbon atoms in the formed alicyclic or aromatic monocyclic or polycyclic ring may be substituted with at least one heteroatom selected from N, S and O.

Dₒ refers to the number of hydrogen atoms in [Chemical Formula 3-1] substituted with deuterium or tritium.

o is an integer of 0 to 50.

The 'substituted' in the 'substituted or unsubstituted' in [Chemical Formula 3-1] means being substituted with one, or two or more substituents selected from the group consisting of deuterium, tritium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a cyclic group in which a C₃-C₂₄ aliphatic ring and a C₅-C₂₄ aromatic ring are fused, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, or being substituted with a substituent in which two or more of the above-mentioned substituents are linked. Hydrogen atoms in the substituents may be substituted with one or more deuterium or tritium atoms, and two or more adjacent substituents may be linked to each other to further form an alicyclic or aromatic monocyclic or polycyclic ring.

According to one embodiment of the present invention, the anthracene compound represented by [Chemical Formula 3] may be more specifically any one selected from compounds represented by the following chemical formulae.

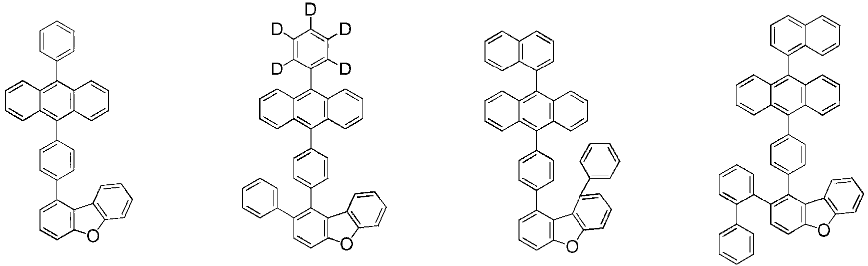

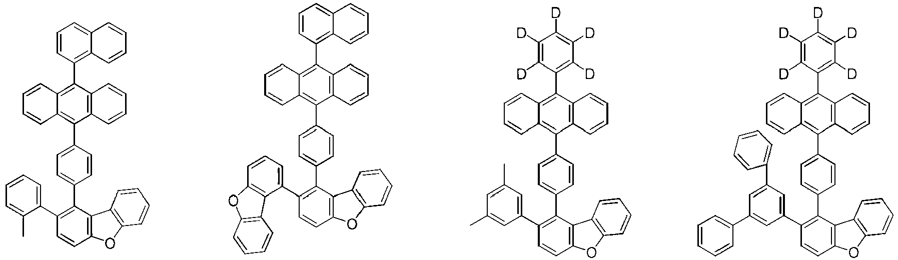

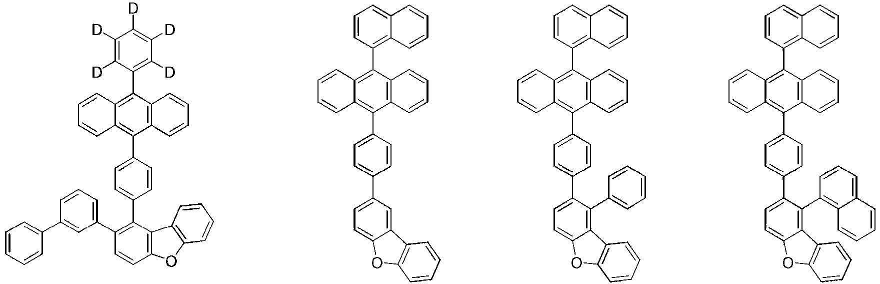

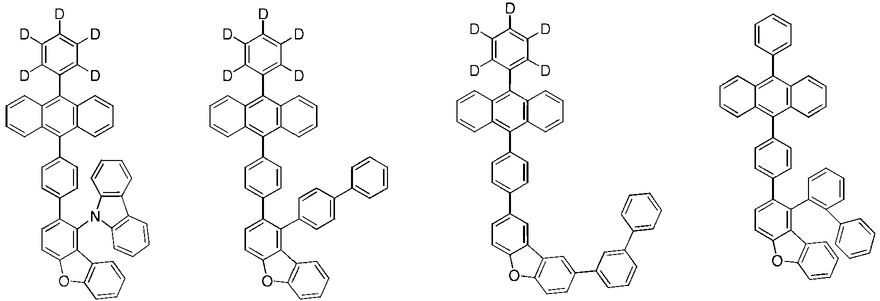

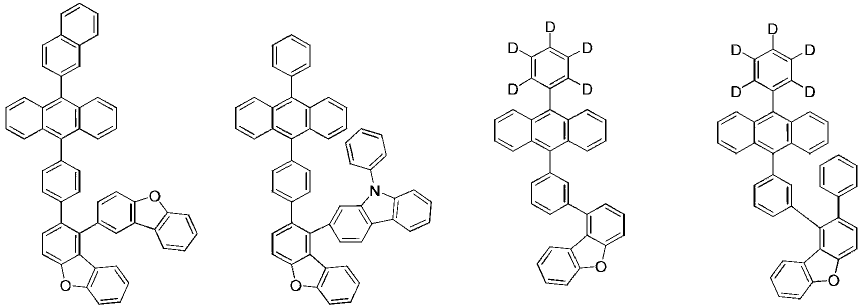

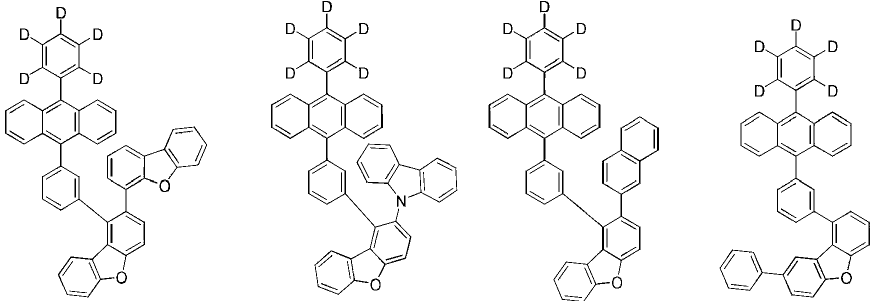

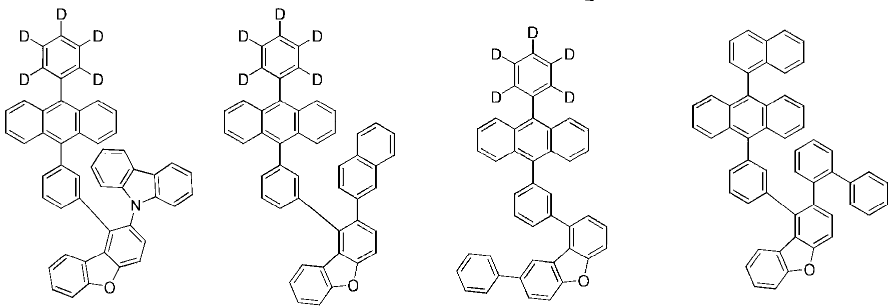

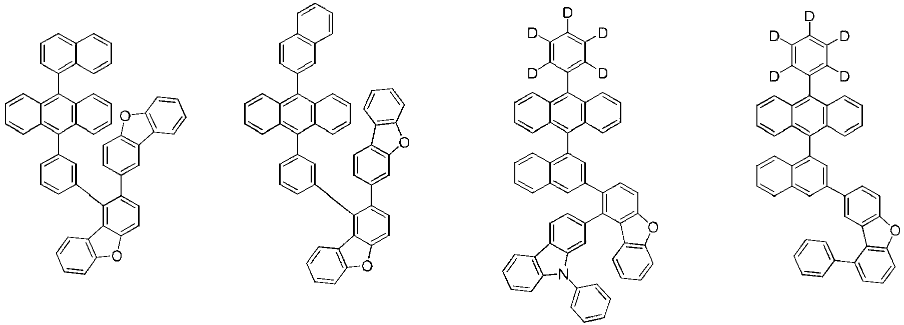

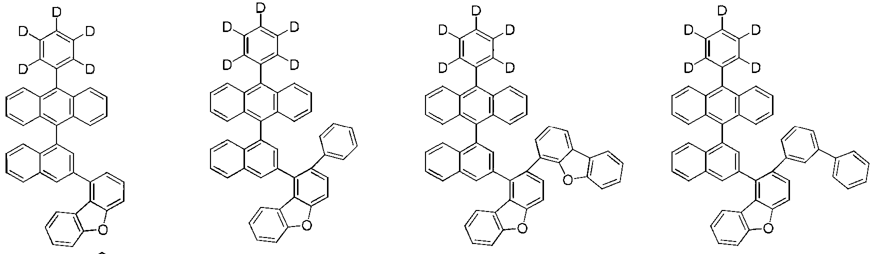

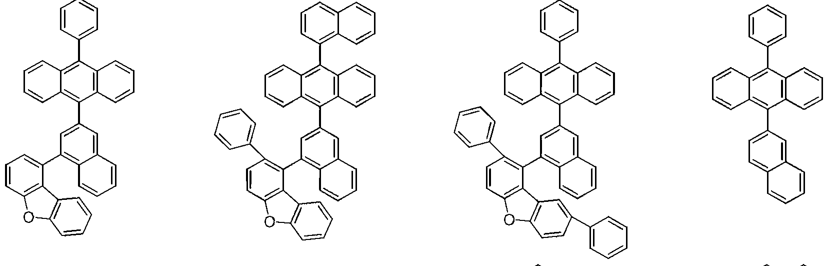

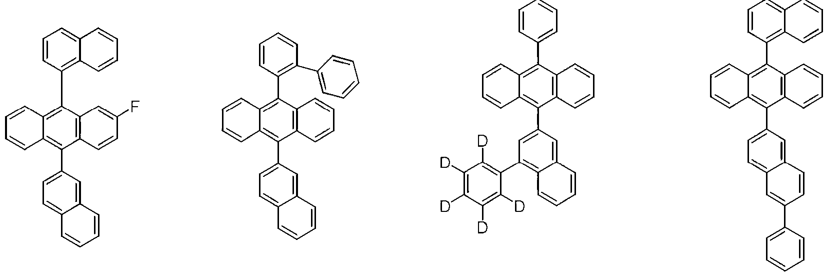

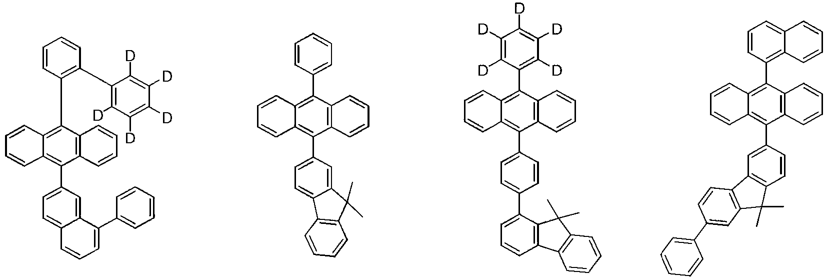

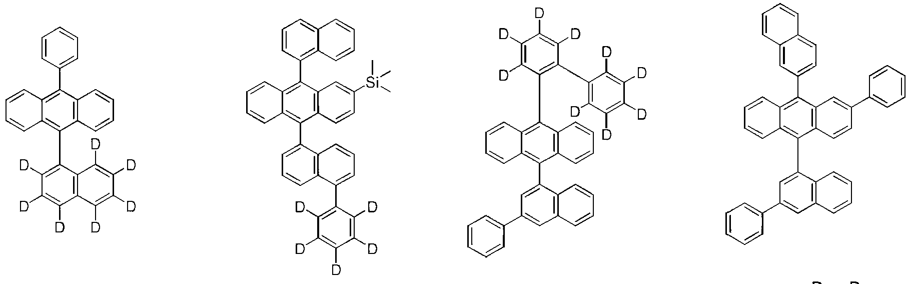

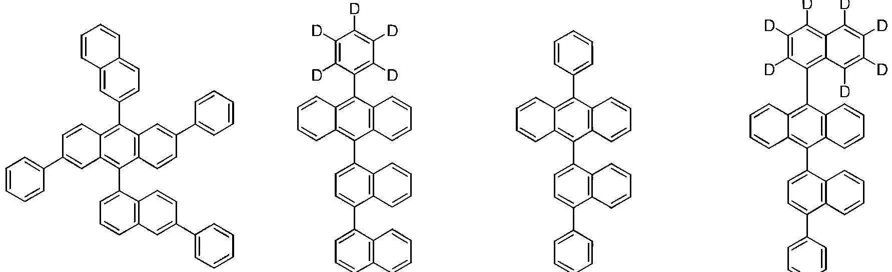

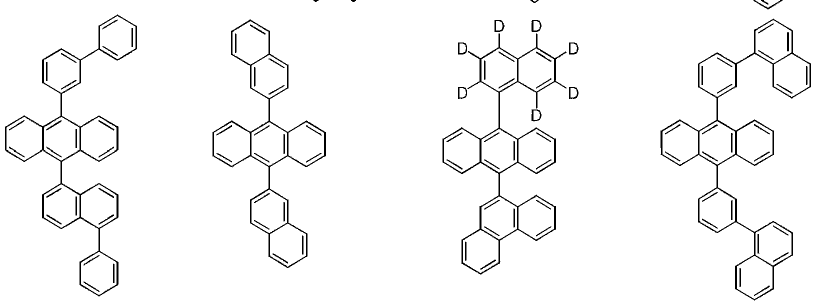

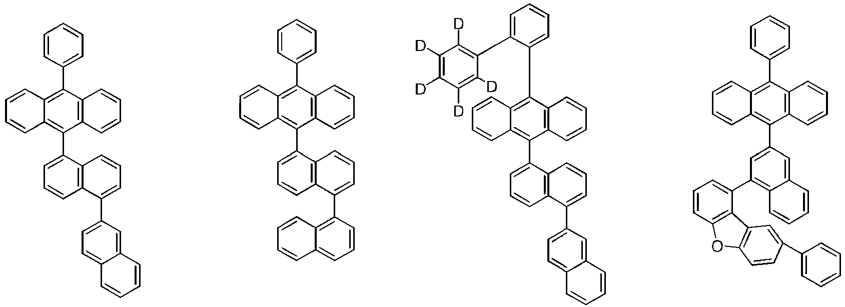

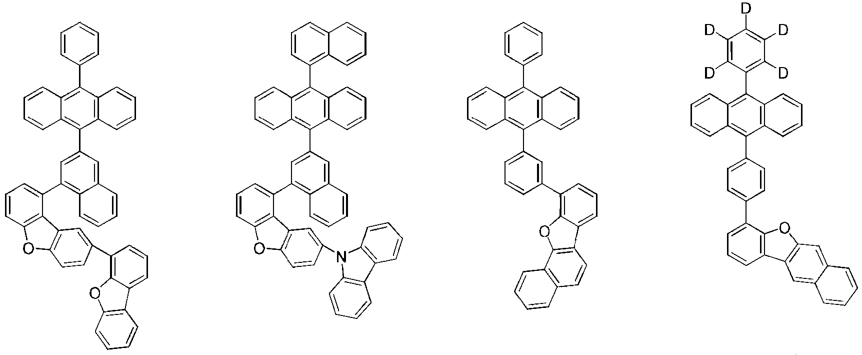

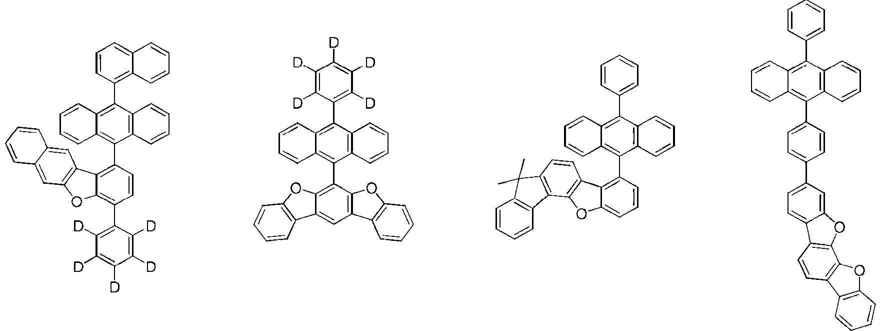

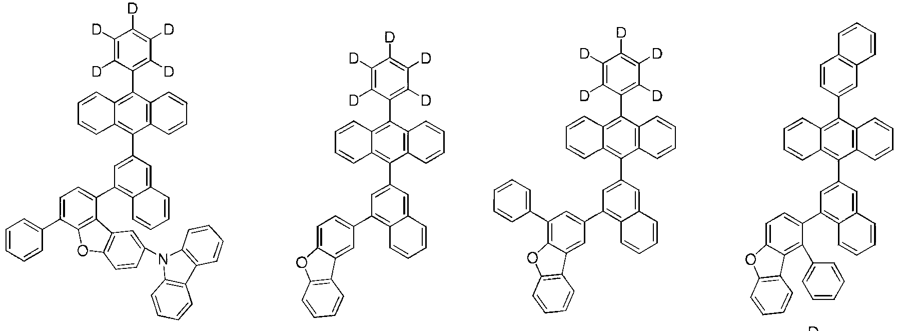

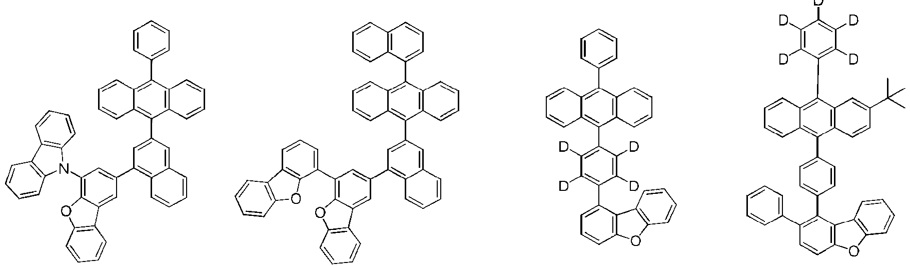

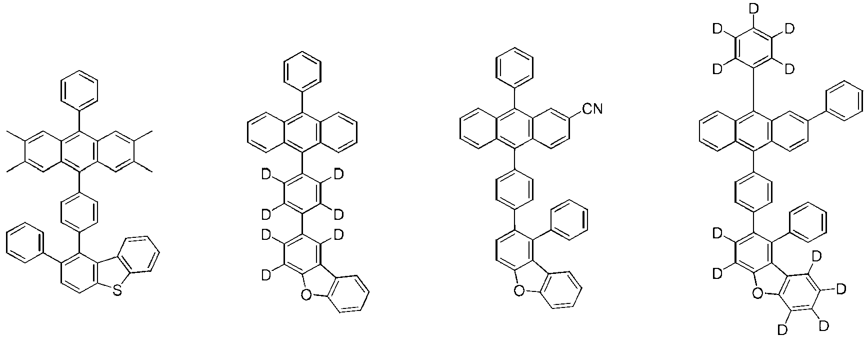

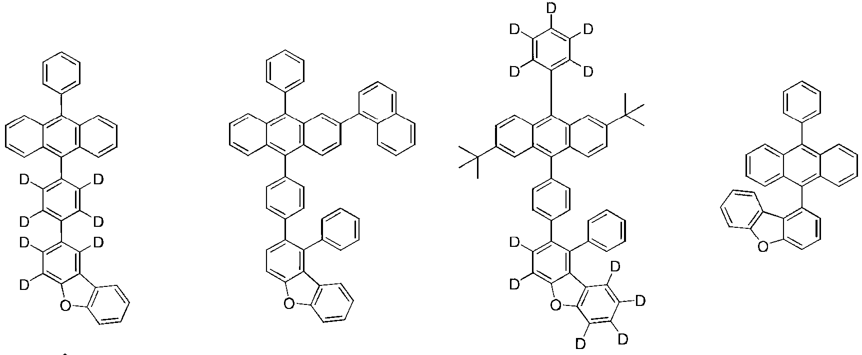

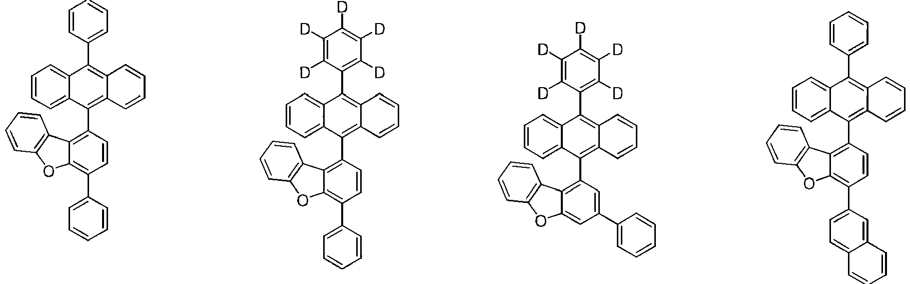

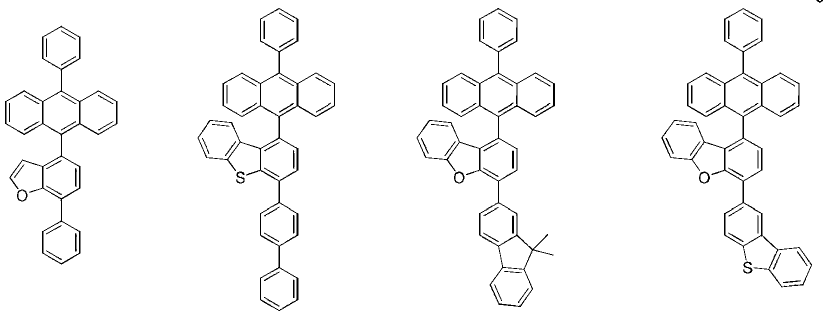

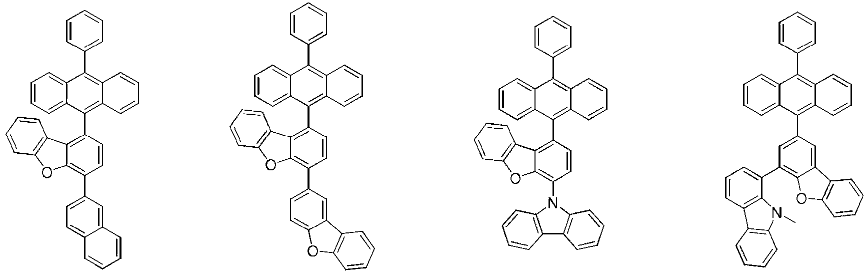

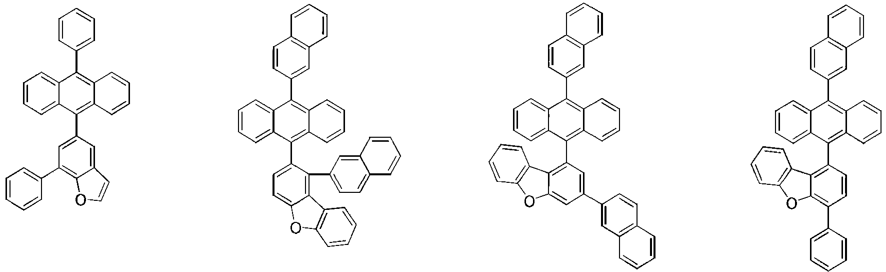

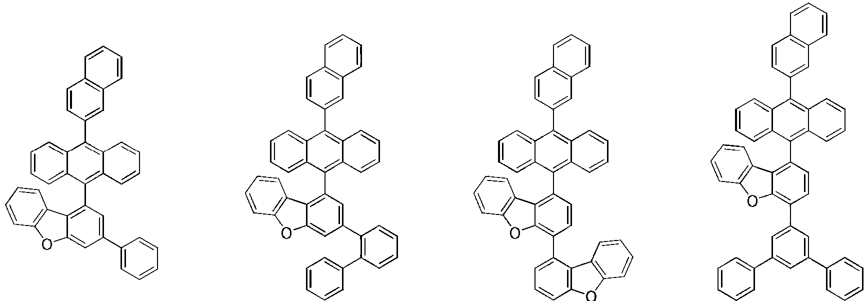

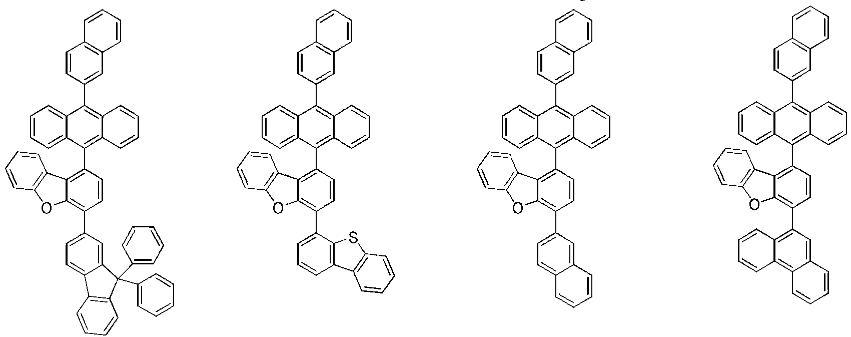

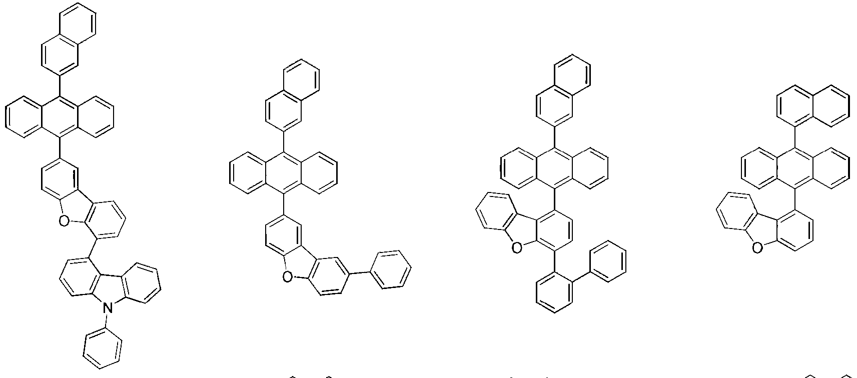

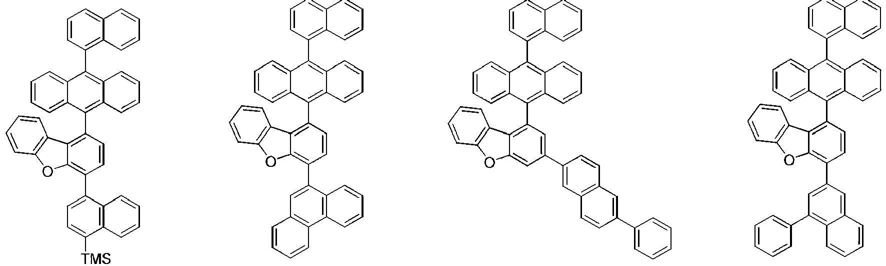

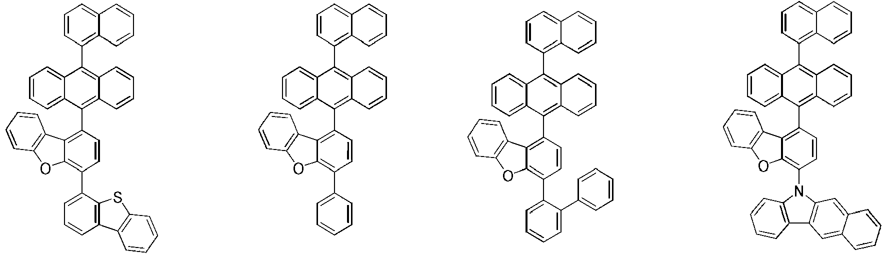

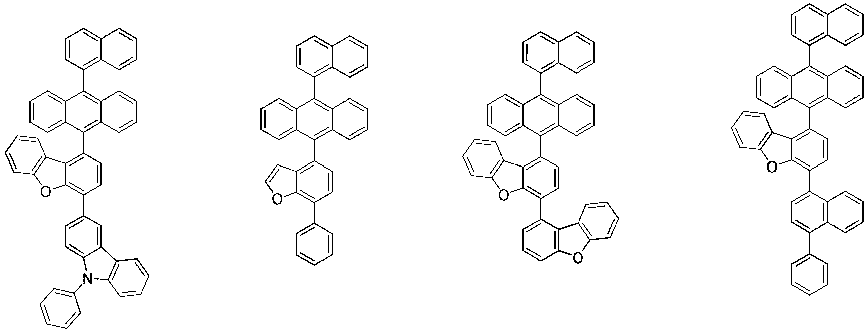

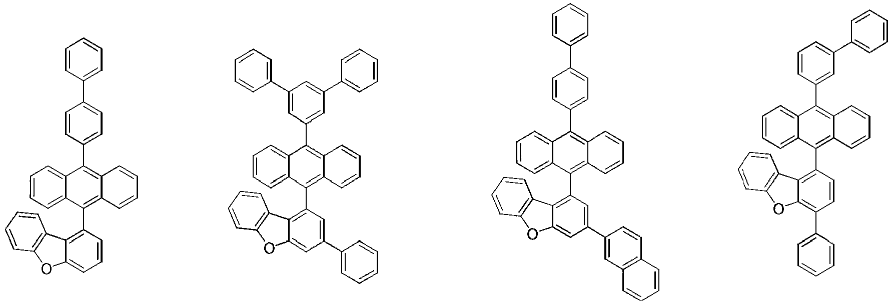

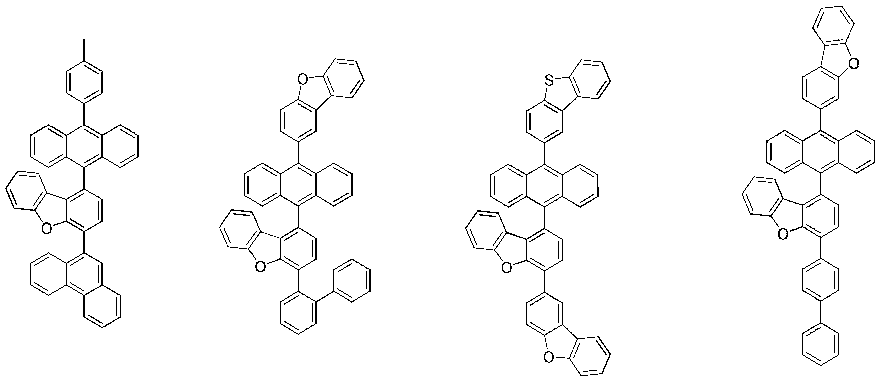

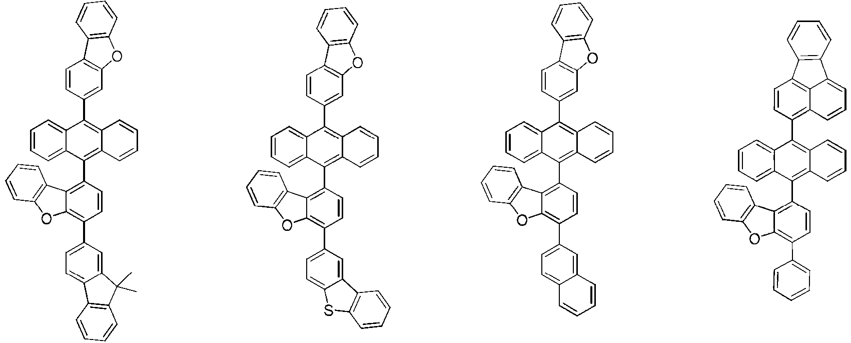

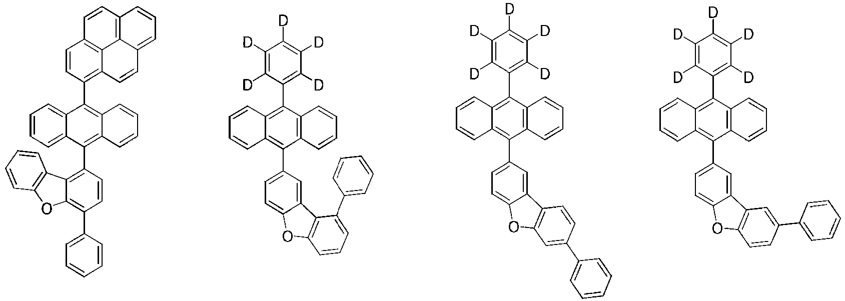

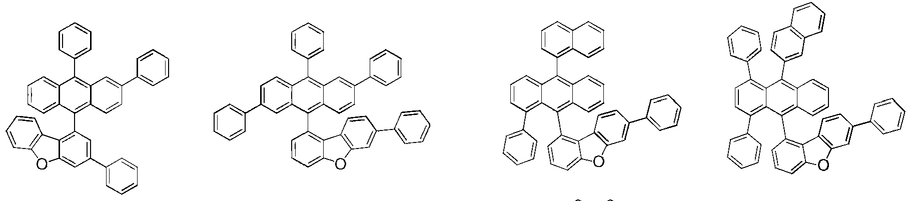

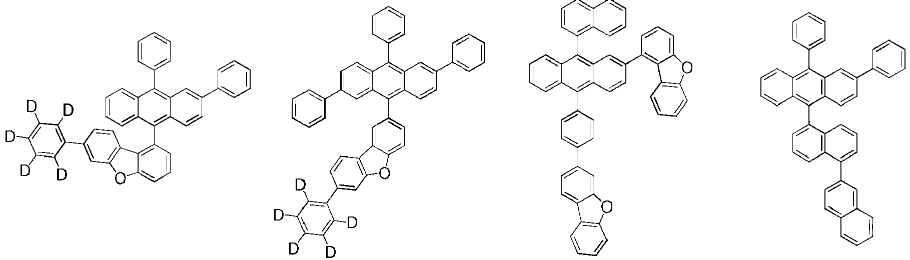

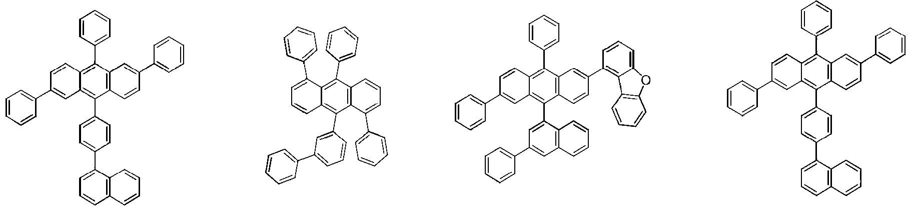

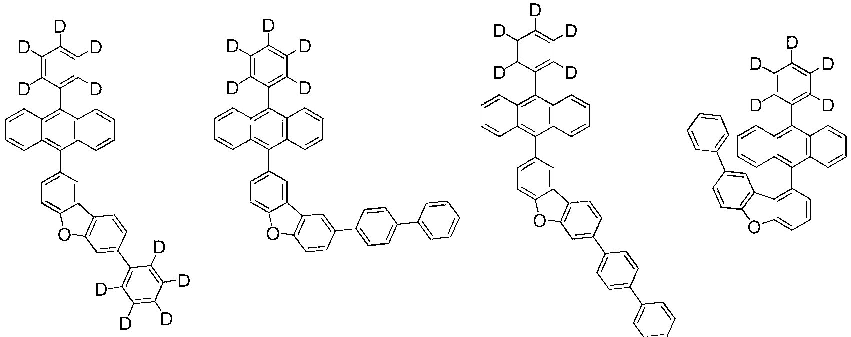

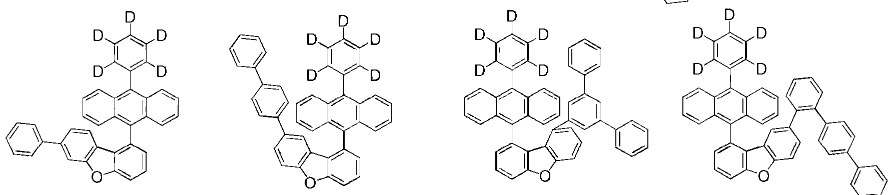

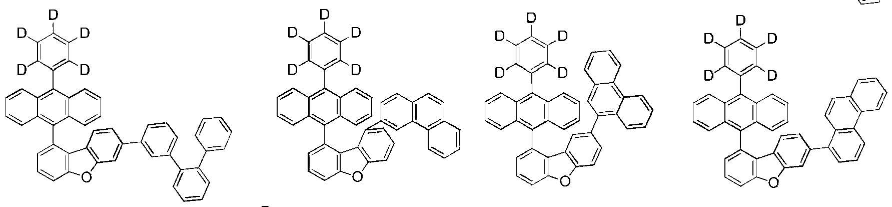

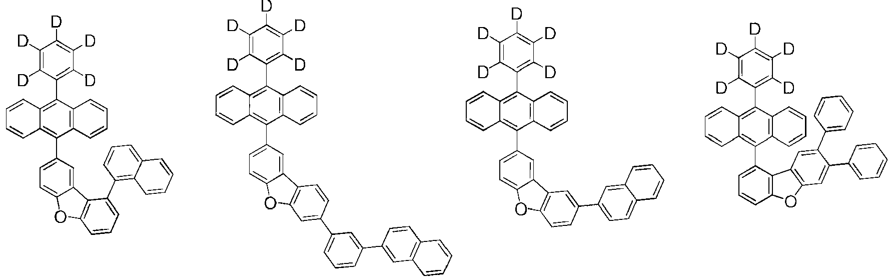

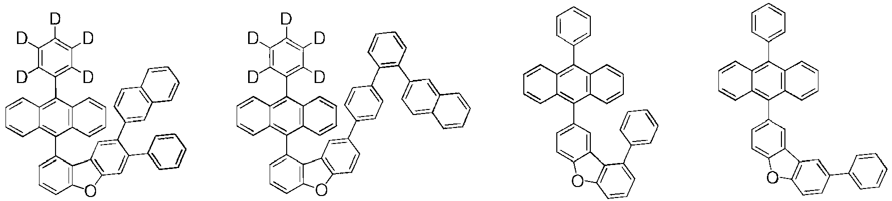

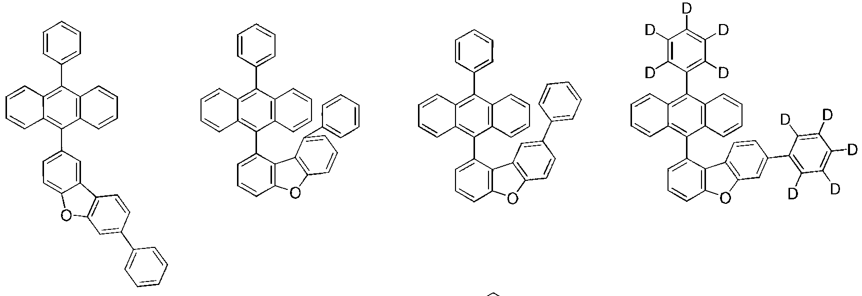

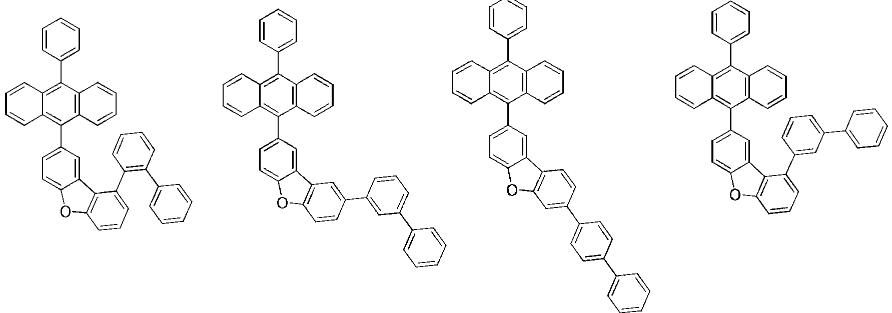

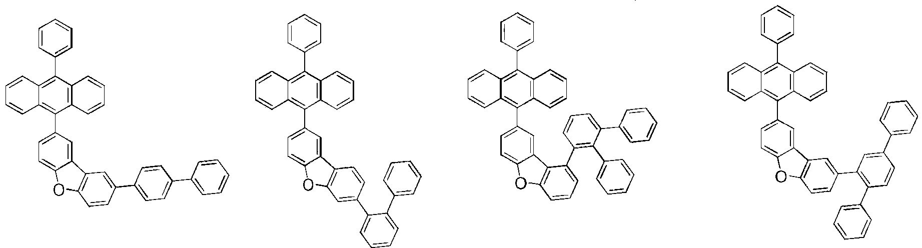

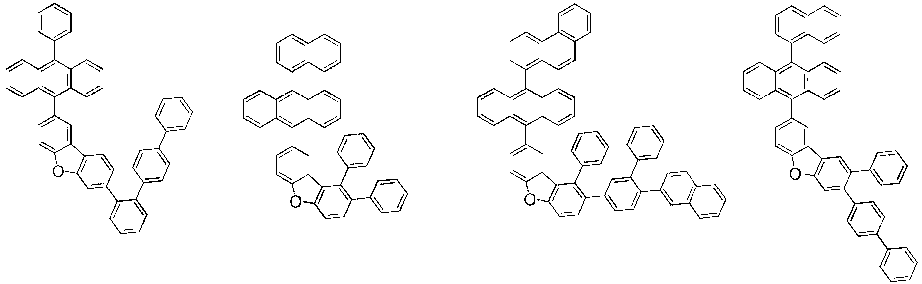

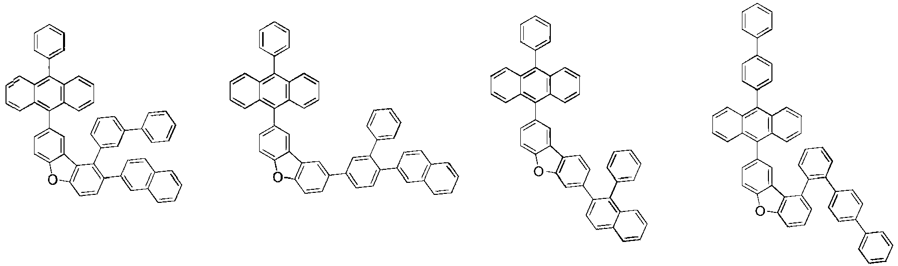

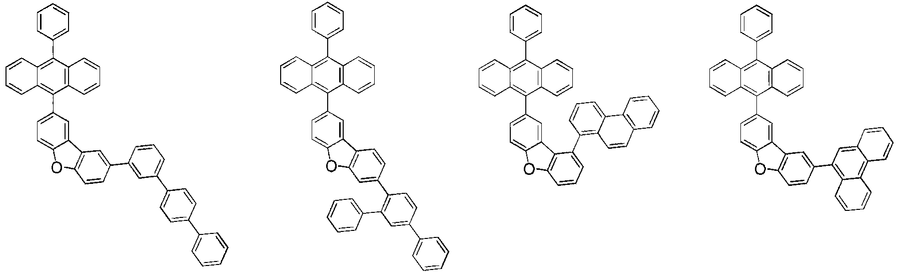

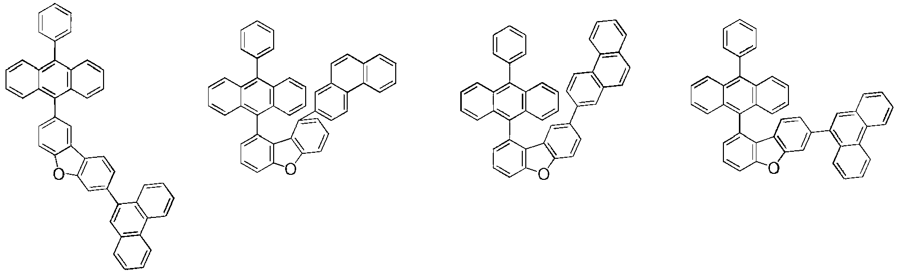

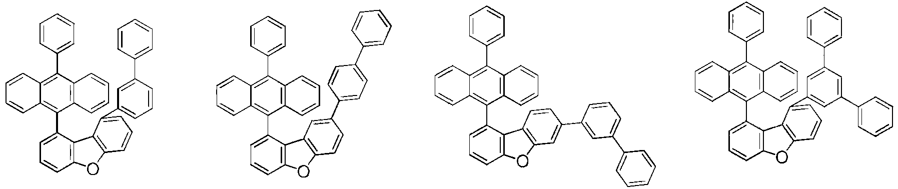

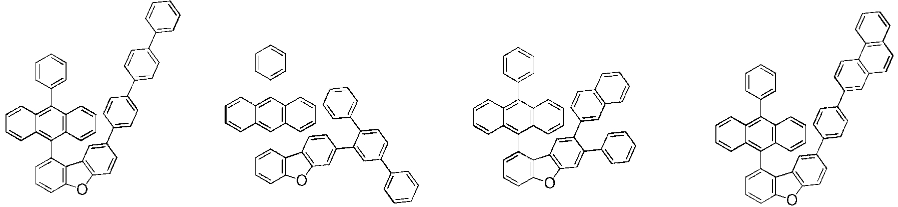

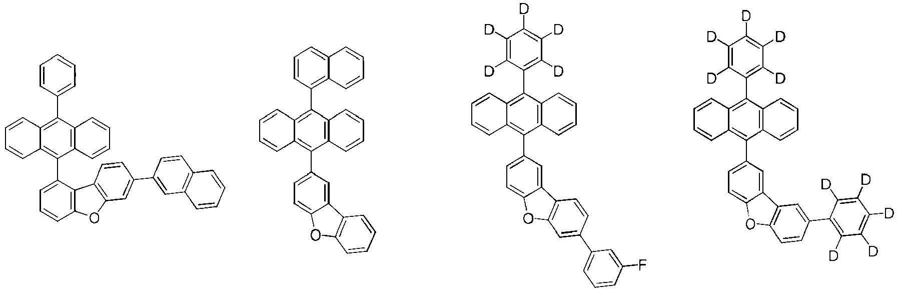

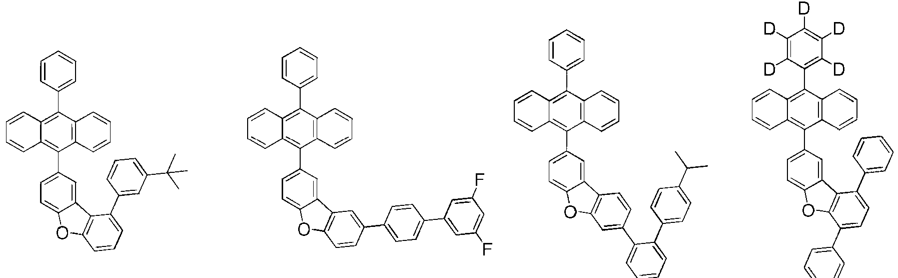

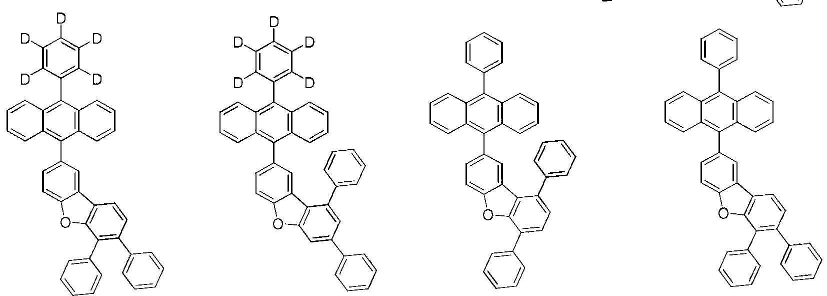

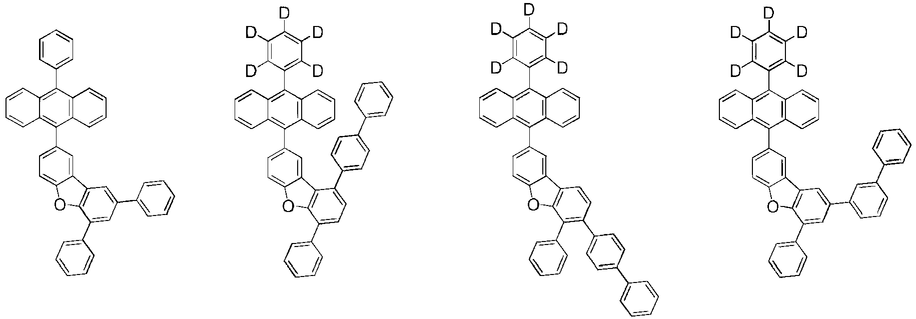

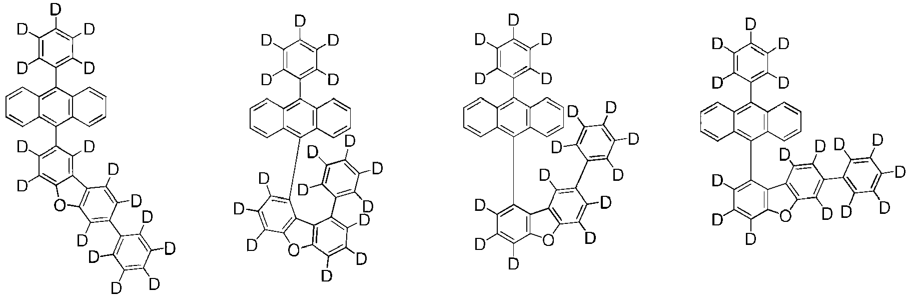

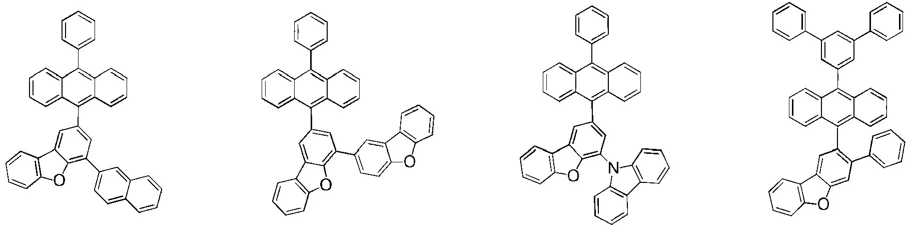

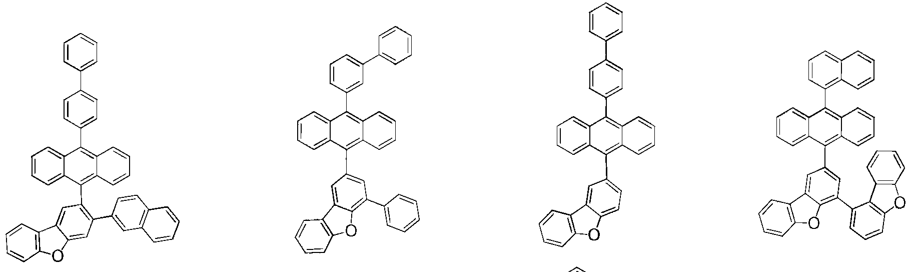

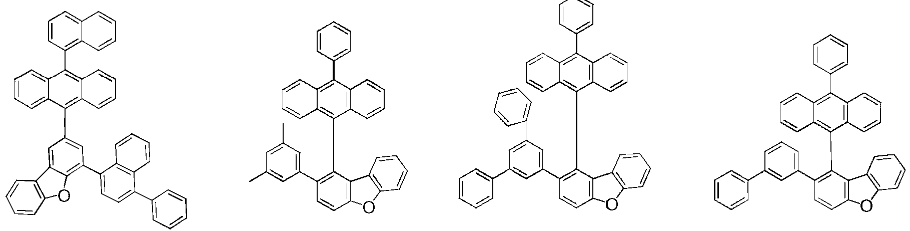

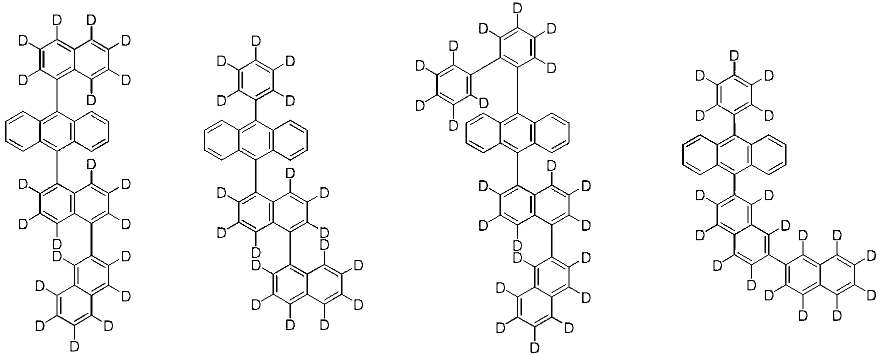

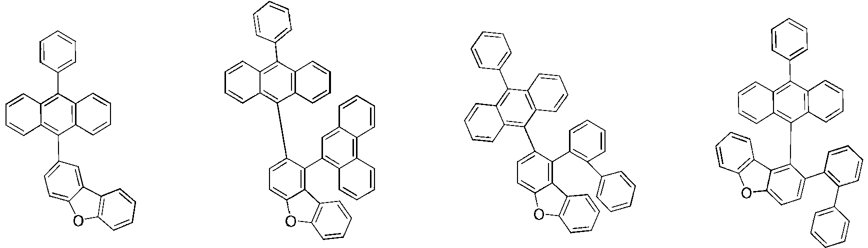

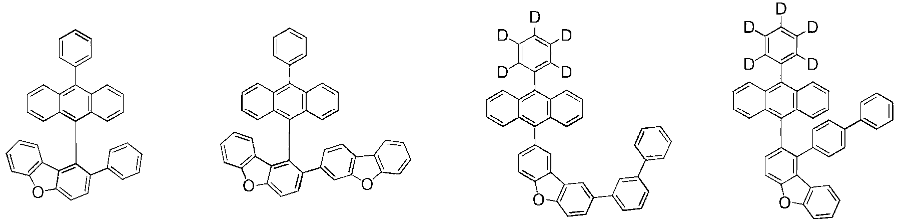

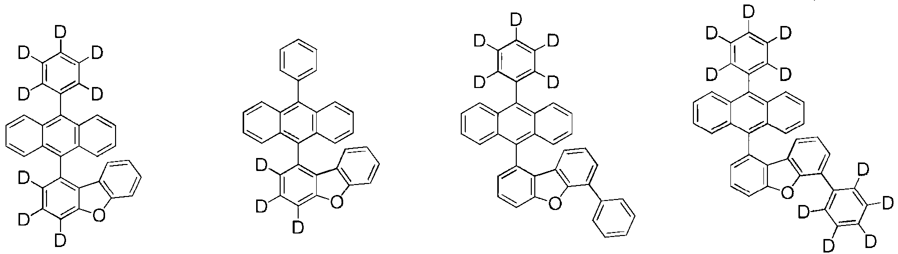

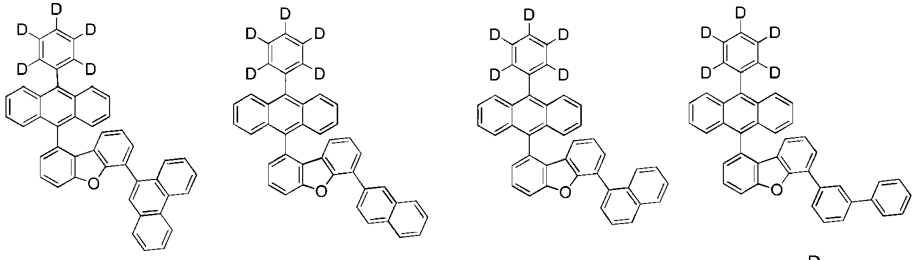

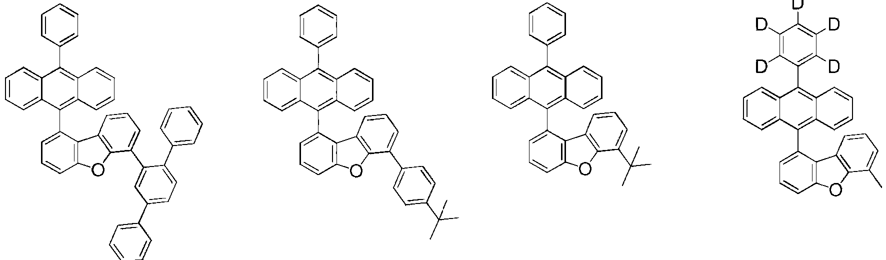

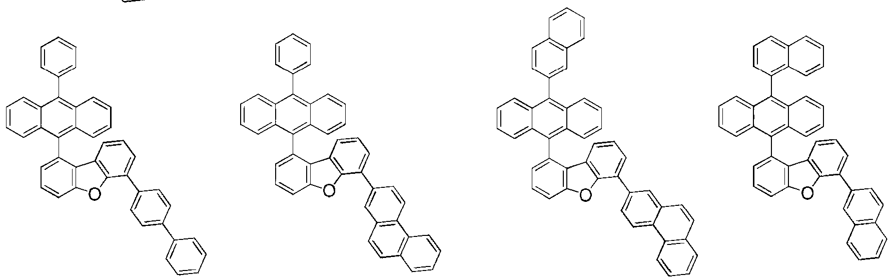

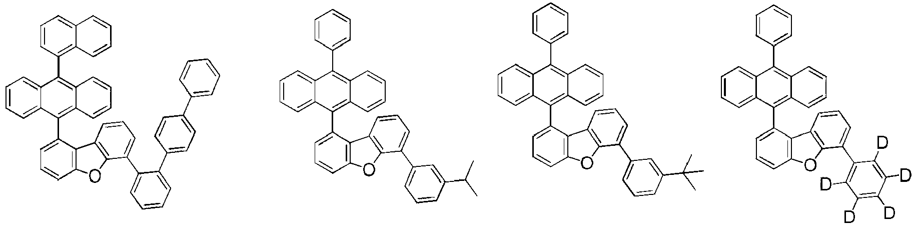

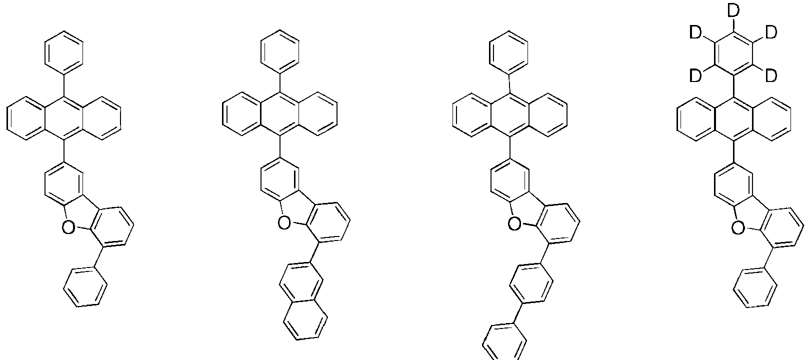

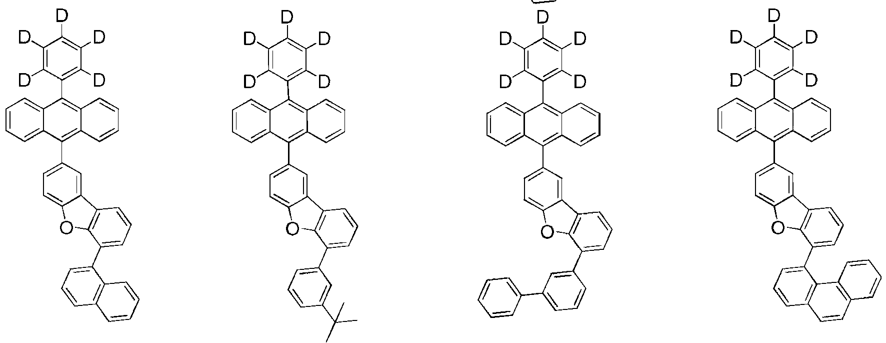

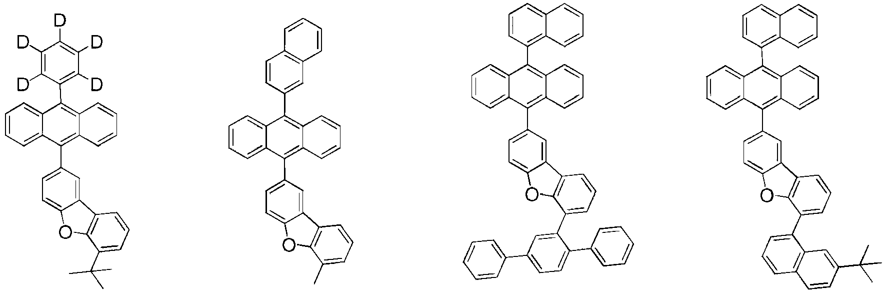

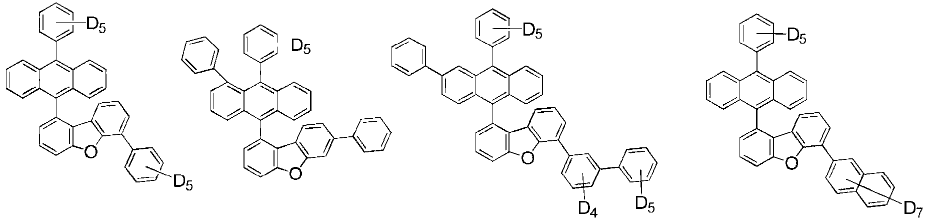

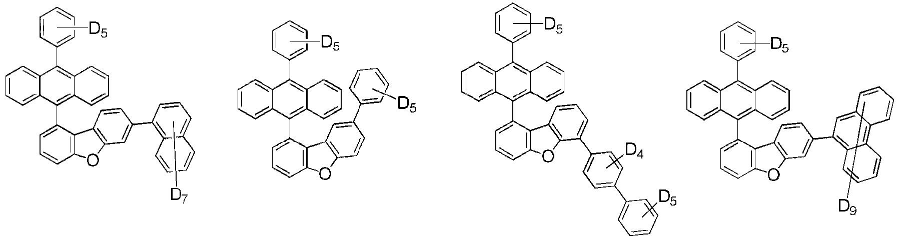

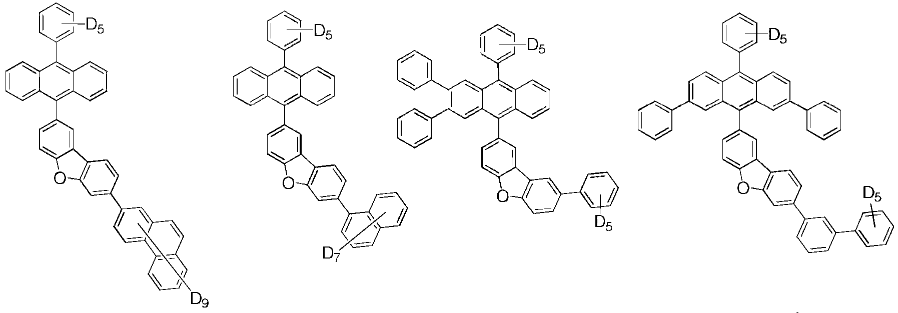

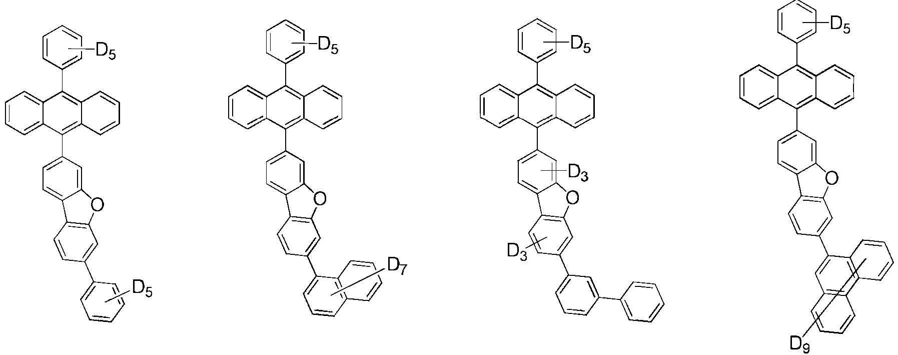

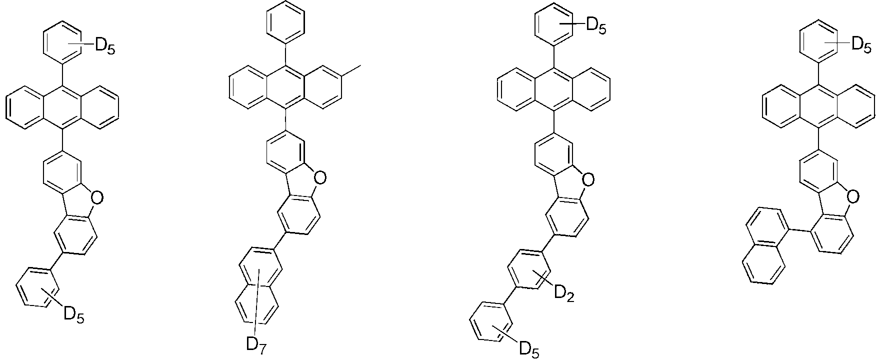

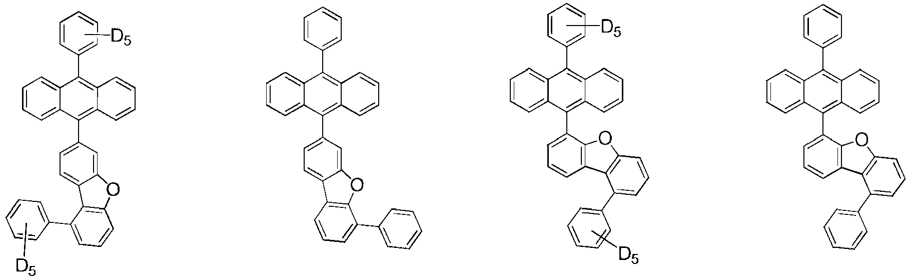

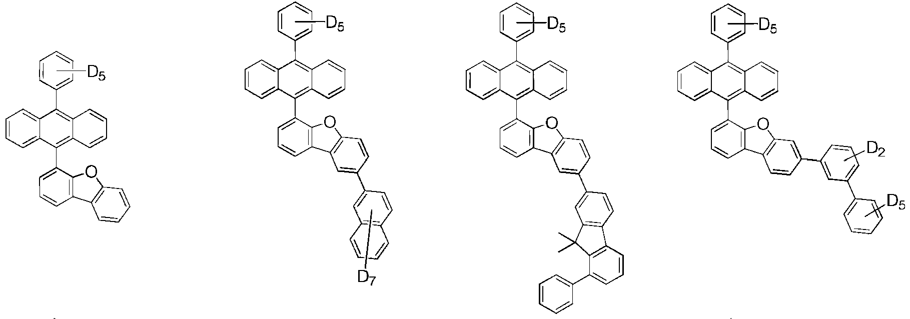

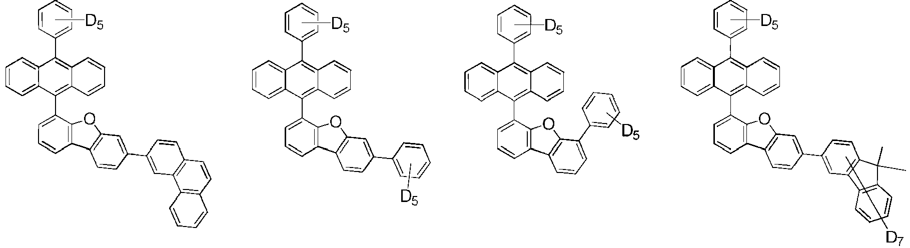

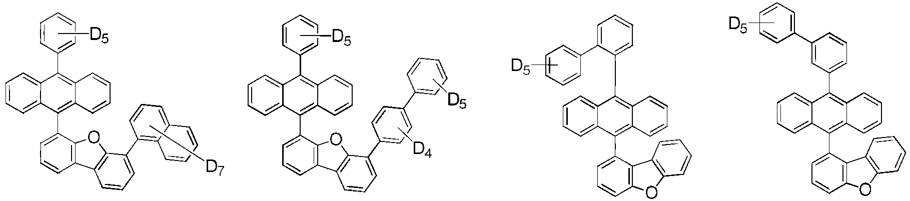

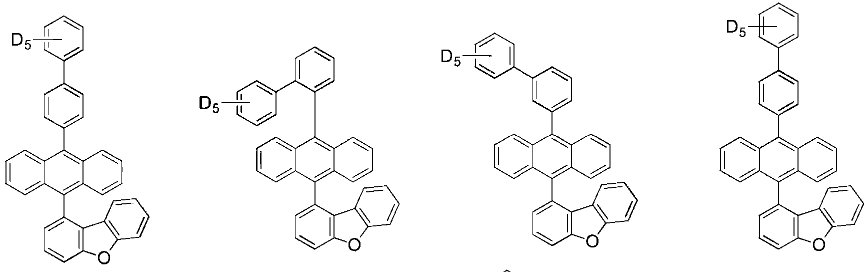

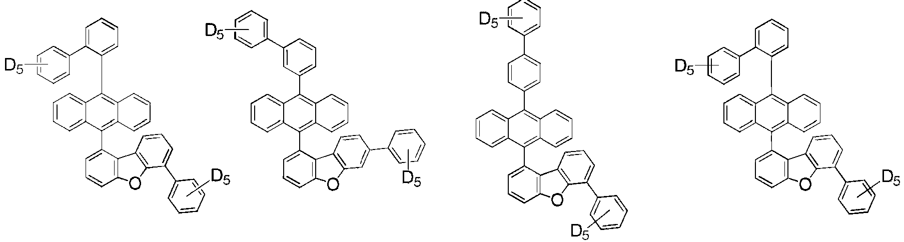

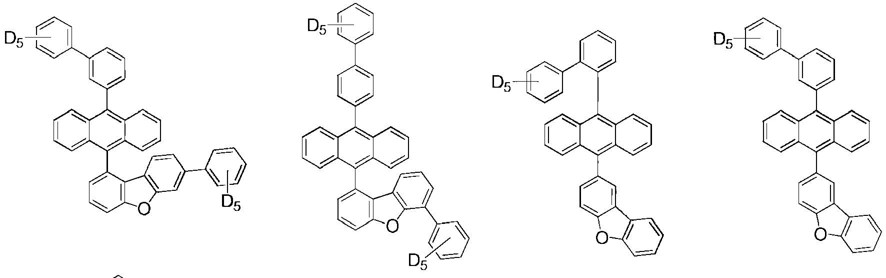

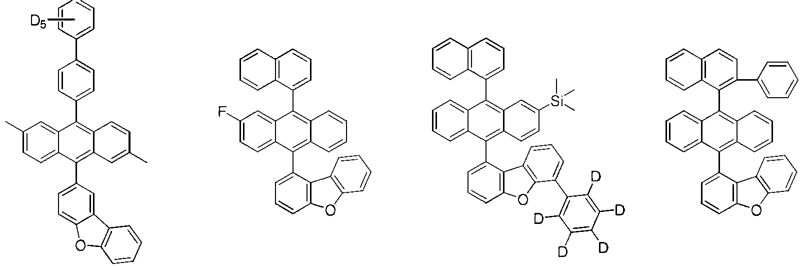

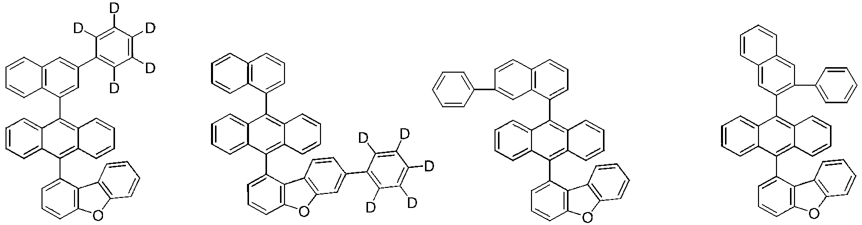

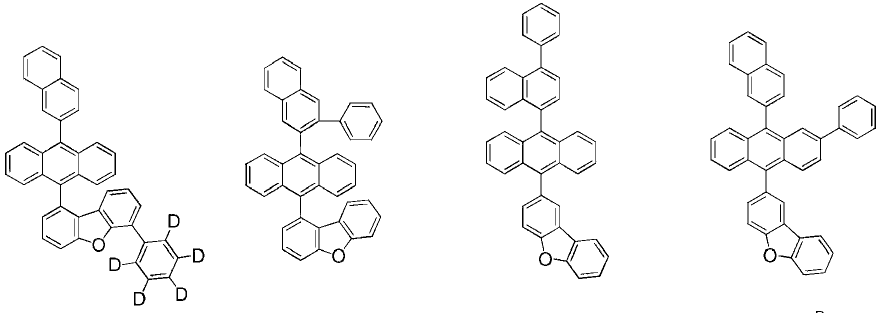

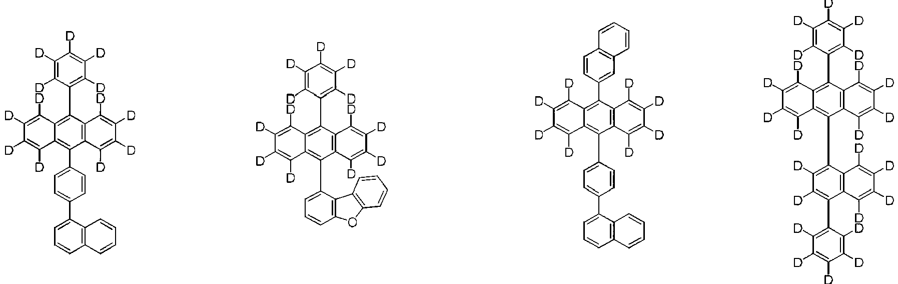

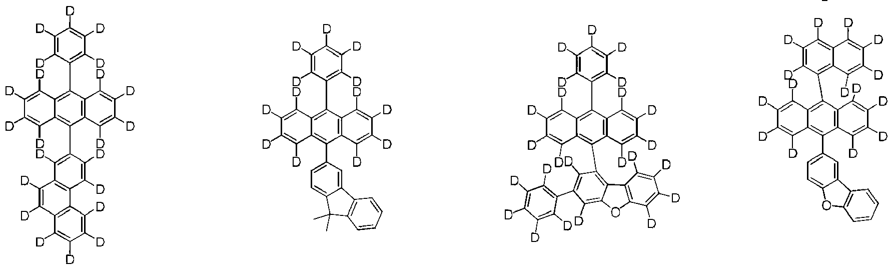

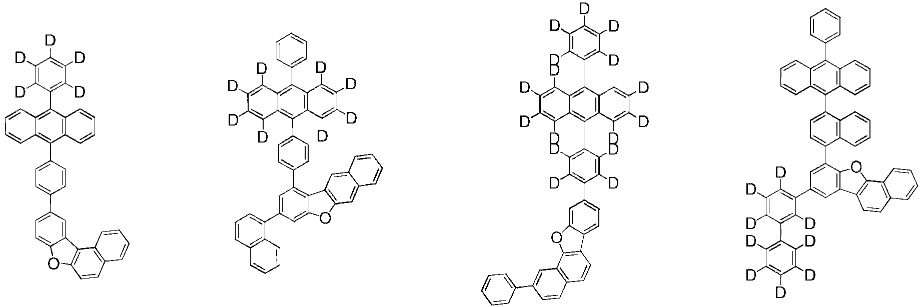

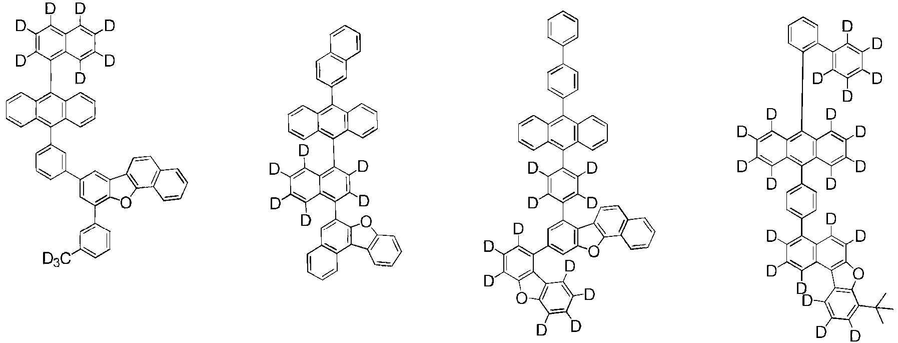

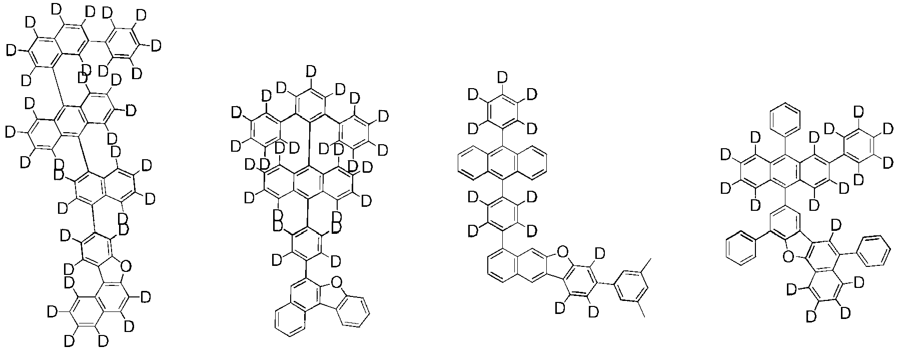

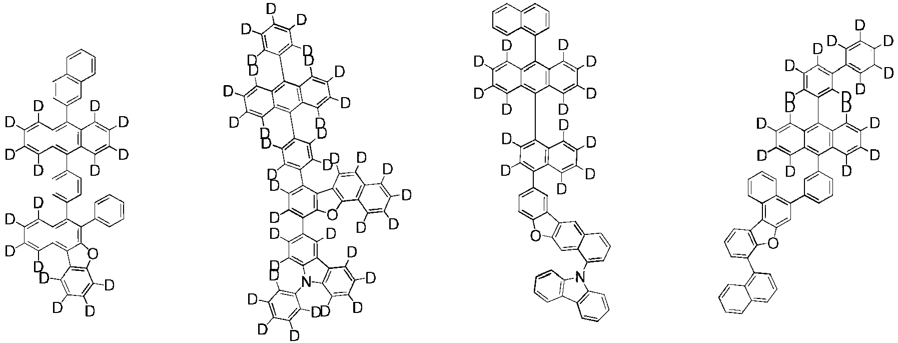

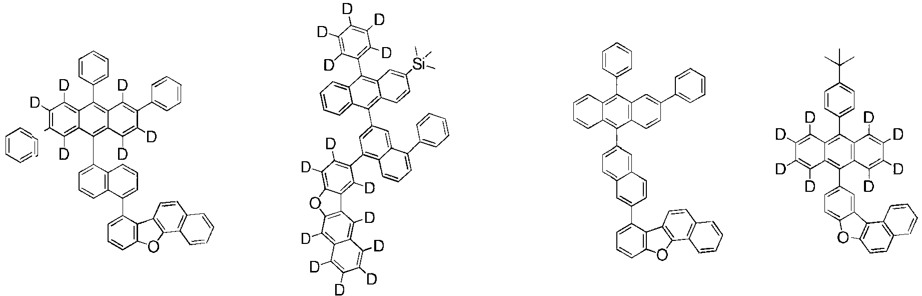

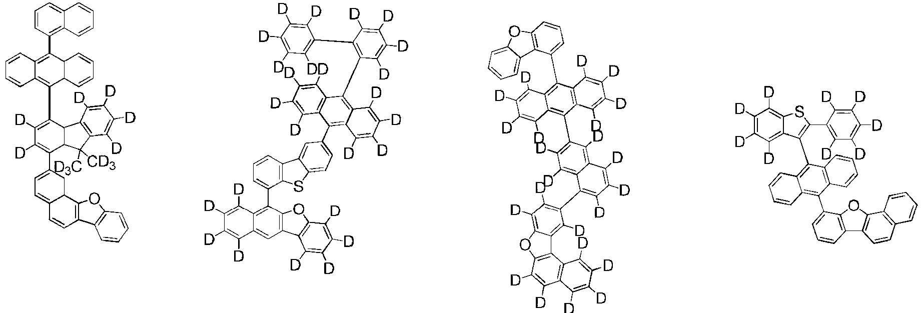

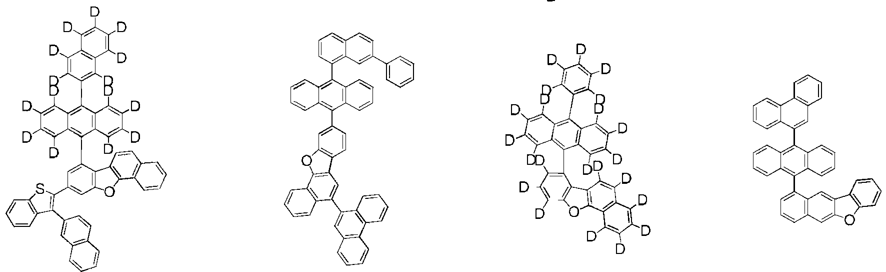

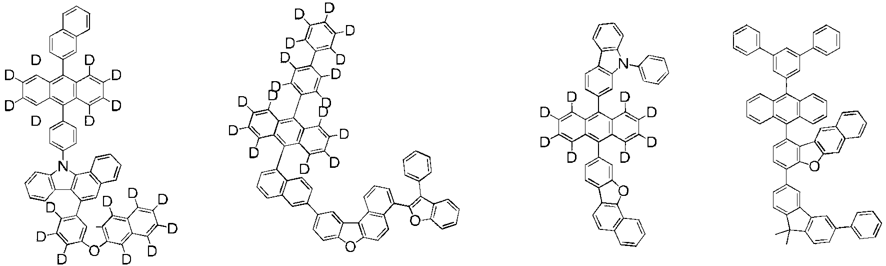

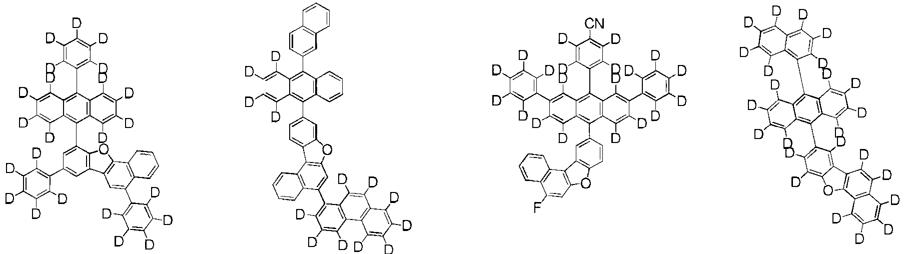

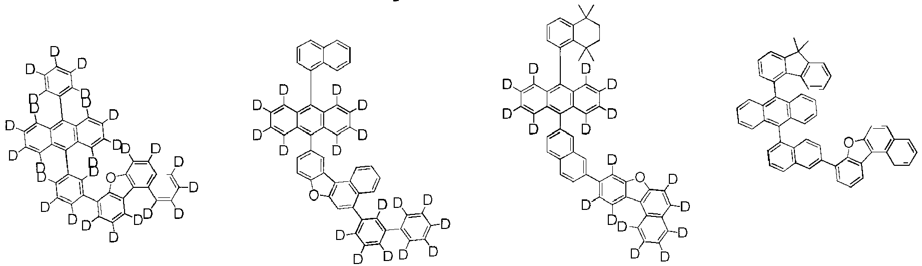

The organic layer of the organic light-emitting device according to the present invention may be formed in a single layer structure, but may be formed in a multilayer structure in which two or more organic layers are laminated. For example, the organic layer may have a structure including a hole injection layer, a hole transport layer, a hole blocking layer, a light-emitting layer, an electron blocking layer, an electron transport layer, an electron injection layer and the like. However, the structure is not limited thereto, and may also include a smaller or larger number of organic layers, and a preferred organic material layer structure of the organic light-emitting device according to the present invention will be described in more detail in examples described below.

Hereinafter, one embodiment of the organic light-emitting device according to the present invention will be described in more detail.

The organic light-emitting device of the present invention includes an anode, a hole transport layer, a light-emitting layer, an electron transport layer and a cathode. As necessary, the organic light-emitting device of the present invention may further include a hole injection layer between the anode and the hole transport layer, and an electron injection layer between the electron transport layer and the cathode. In addition thereto, one or two intermediate layers may be further formed, a hole blocking layer or an electron blocking layer may be further formed, and as described above, organic layers having various functions such as a capping layer may be further included depending on the device properties.

Meanwhile, the specific structure of the organic light-emitting device according to one embodiment of the present invention, a method for manufacturing the same, and the materials of each organic layer may be examined as follows.

First, a material for an anode electrode is coated on a substrate to form an anode. Herein, substrates used in common organic light-emitting devices may be used as the substrate, and organic substrates or transparent plastic substrates having excellent transparency, surface smoothness, handling readiness and waterproofness are preferred. As the material for an anode electrode, indium tin oxide (ITO), indium zinc oxide (IZO), tin oxide (SnO₂), zinc oxide (ZnO) or the like, which is transparent and has excellent conductivity, is used.

A hole injection layer material is coated on the anode electrode by vacuum thermal deposition or spin coating to form a hole injection layer. Then, a hole transport layer material is coated on the hole injection layer by vacuum thermal deposition or spin coating to form a hole transport layer.

The hole injection layer material is not particularly limited as long as it is commonly used in the art. Examples thereof may include 4,4',4"-tris(2-naphthylphenyl-phenylamino)triphenylamine (2-TNATA), N,N'-di(1-naphthyl)-N,N'-diphenylbenzidine (NPD), N,N'-diphenyl-N,N'-bis(3-methylphenyl)-1,1'-biphenyl-4,4'-diamine (TPD), N,N'-diphenyl-N,N'-bis(4-(phenyl-m-tolylamino)phenyl)biphenyl-4,4'-diamine (DNTPD), 1,4,5,8,9,11-hexaazatriphenylenehexacarbonitrile (HAT-CN), and the like.

The hole transport layer material is not particularly limited as well as long as it is commonly used in the art. Examples thereof may include N,N'-bis(3-methylphenyl)-N,N'-diphenyl-(1,1-biphenyl)-4,4'-diamine (TPD), N,N'-di(naphthalen-1-yl)-N,N'-diphenylbenzidine (α-NPD) and the like.

Subsequently, a hole auxiliary layer and a light-emitting layer are laminated on the hole transport layer. The light-emitting layer may be used either alone, or the first light-emitting layer and the second light-emitting layer may each be laminated using a vacuum deposition method or a spin coating method. Herein, as a host material in the first light-emitting layer or the second light-emitting layer in the organic light-emitting device, the compound represented by [Chemical Formula 3] may be used, and as a dopant material in the first light-emitting layer or the second light-emitting layer, the compound represented by [Chemical Formula 1] or [Chemical Formula 2] may be used. Materials constituting these are as described above. In addition, as a method for forming the light-emitting layer, one or a plurality of first host materials and a dopant material are deposited (co-deposited) from a plurality of different deposition sources to form a thin film, or a plurality of the hosts (for example, first host material and second host material) are pre-mixed, and the mixed hosts may be co-deposited using a deposition source different from that of the dopant.

Herein, when each host is separately laminated using a plurality of different deposition sources, there is a disadvantage in that the manufacturing process becomes complicated, however, since the thin film is formed without the respective materials being brought into contact with each other in advance, deterioration in device properties caused by interactions between different types of compounds, which occurs when they are pre-mixed in a single deposition source, may be prevented. On the other hand, when they are pre-mixed, there is an advantage in that the manufacturing apparatus or manufacturing process may be simplified.

A hole blocking layer may be optionally formed as a thin film on the light-emitting layer using a method of vacuum deposition or spin coating. When holes pass through an organic light-emitting layer and flow into a cathode, lifespan and efficiency of a device are reduced, and the hole blocking layer performs a role of preventing this problem by using a material having a very low highest occupied molecular orbital (HOMO) level. The hole blocking material used herein is not particularly limited, but needs to have higher ionization potential than a light-emitting compound while having an electron transport ability. Representative examples thereof may include BAlq, BCP, TPBI and the like.

As a material used for the hole blocking layer, BAlq, BCP, Bphen, TPBI, TAZ, BeBq₂, OXD-7, Liq and the like may be used, however, the material is not limited thereto.

After depositing an electron transport layer on the hole blocking layer using a method of vacuum deposition or spin coating, an electron injection layer is formed thereon, and a metal for forming a cathode is vacuum thermal deposited on the electron injection layer to form a cathode, and as a result, the organic light-emitting device according to one embodiment of the present invention is completed.

Herein, as the metal for forming a cathode, lithium (Li), magnesium (Mg), aluminum (Al), aluminum-lithium (Al-Li), calcium (Ca), magnesium-indium (Mg-In), magnesium-silver (Mg-Ag) or the like may be used, and in order to obtain a top emission-type light-emitting device, a transmissive cathode using ITO or IZO may be used.

As a material for the electron transport layer, known electron transport materials functioning to stably transport electrons injected from the cathode may be used. Examples of the known electron transport material may include materials such as quinoline derivatives, particularly tris(8-quinolinolato)aluminum (Alq₃), TAZ, BAlq, beryllium bis(benzoquinolin-10-olate) (Bebq₂) and oxadiazole derivatives (PBD, BMD, BND and the like).

In addition, each of the organic layers may be formed using a monomolecular deposition method or solution process. Herein, the monomolecular deposition method refers to a method of forming a thin film by evaporating a material used for forming each of the layers through heating and the like under vacuum or reduced pressure, and the solution process refers to a method of forming a thin film by mixing a material used for forming each of the layers with a solvent, and then applying a method such as ink-jet printing, roll-to-roll coating, screen printing, spray coating, dip coating or spin coating on the mixture.

In addition, the organic light-emitting device of the present invention may be used in devices selected from flat-panel display devices, flexible display devices, stretchable display devices, monochromatic or white flat-panel lighting devices, monochromatic or white flexible lighting devices, display devices for vehicles, display devices for virtual or augmented reality, and the like.

Hereinafter, preferred synthesis examples of compounds and device examples are provided in order to help understand the present invention. However, the following examples are for illustrative purposes only, and the scope of the present invention is not limited thereby.

### Synthesis Example 1: Synthesis of [Compound 1]

### Synthesis Example 1-1: Synthesis of A-1

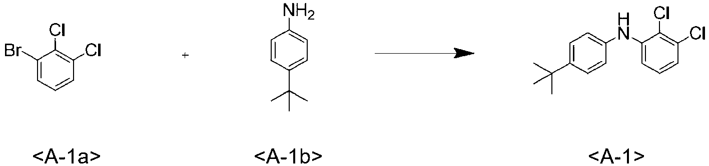

<A-1a> (20 g), <A-1b> (14.5 g), tris(dibenzylideneacetone)dipalladium(0) (1.62 g), bis(diphenylphosphino)-1,1'-binaphthyl (1.1 g), sodium tert-butoxide (17 g) and toluene (300 mL) were introduced to a reactor, and the mixture was stirred under reflux for 3 hours. The result was cooled to room temperature, ethyl acetate and water were introduced thereto, and then the organic layer was separated. The organic layer was purified by silica gel chromatography to obtain <A-1> (15.2 g, 58.3%).

### Synthesis Example 1-2: Synthesis of A-2

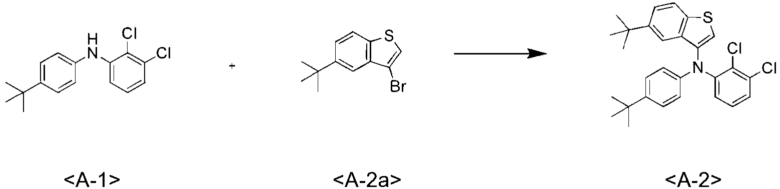

<A-1> (30 g), <A-2a> (38.4 g), bis(tri-tert-buthylphosphine)palladium(0) (1.04 g), sodium tert-butoxide (19.6 g) and toluene (430 mL) were introduced to a reactor, and then the mixture was stirred under reflux for 6 hours. The result was cooled to room temperature, then ethyl acetate and water were introduced thereto, and then the organic layer was separated. The organic layer was purified by silica gel chromatography to obtain <A-2> (43.5 g, 88.4%).

### Synthesis Example 1-3: Synthesis of A-3

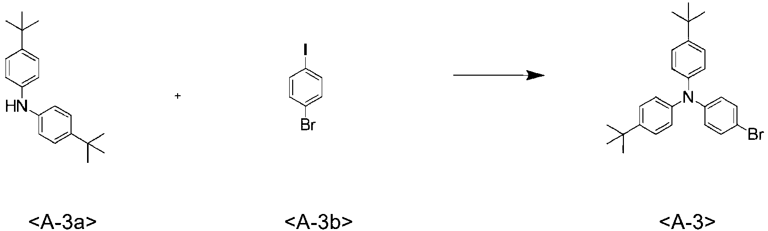

<A-3a> (20 g), <A-3b> (30.2 g), palladium(II) acetate (0.3 g), Xantphos (0.8 g), sodium tert-butoxide (10.3 g) and toluene (200 mL) were introduced to a reactor, and then the mixture was stirred under reflux for 6 hours. The result was cooled to room temperature, then ethyl acetate and water were introduced thereto, and then the organic layer was separated. The organic layer was purified by silica gel chromatography to obtain <A-3> (22.5 g, 72.6%).

### Synthesis Example 1-4: Synthesis of A-4

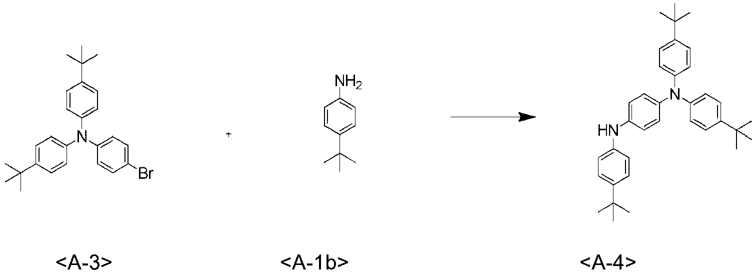

<A-4> was obtained by performing a synthesis in the same manner as in Synthesis Example 1-1, except that <A-3> was used instead of <A-1a>. (Yield 62.6%)

### Synthesis Example 1-5: Synthesis of A-5

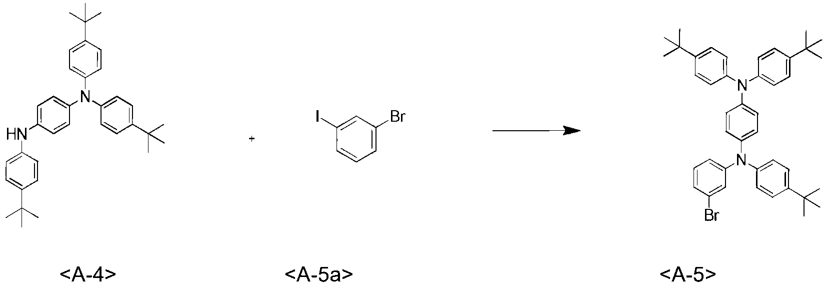

<A-5> was obtained by performing a synthesis in the same manner as in Synthesis Example 1-3, except that <A-4> was used instead of <A-3a>, and <A-5a> was used instead of <A-3b>. (Yield 68.7%)

### Synthesis Example 1-6: Synthesis of A-6

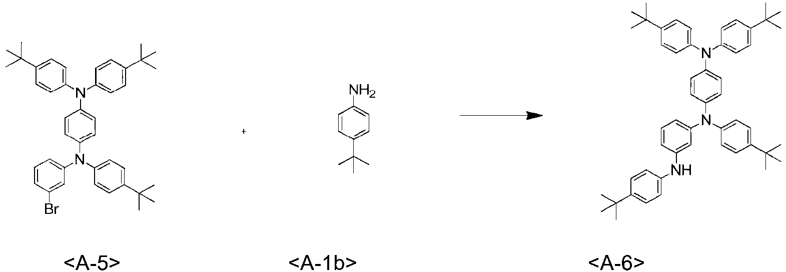

<A-6> was obtained by performing a synthesis in the same manner as in Synthesis Example 1-1, except that <A-5> was used instead of <A-1a>. (Yield 64.1%)

### Synthesis Example 1-7: Synthesis of A-7

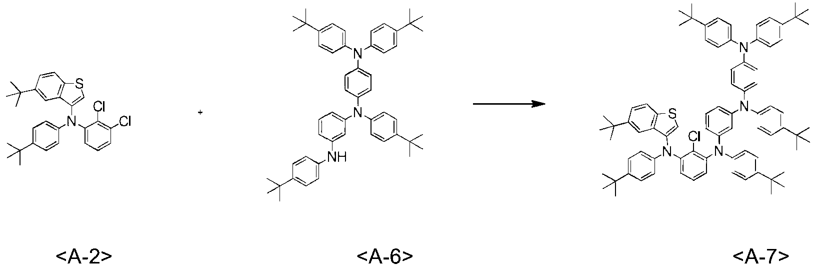

<A-7> was obtained by performing a synthesis in the same manner as in Synthesis Example 1-2, except that <A-6> was used instead of <A-1>, and <A-2> was used instead of <A-2a>. (Yield 89.7%)

### Synthesis Example 1-8: Synthesis of [Compound 1]

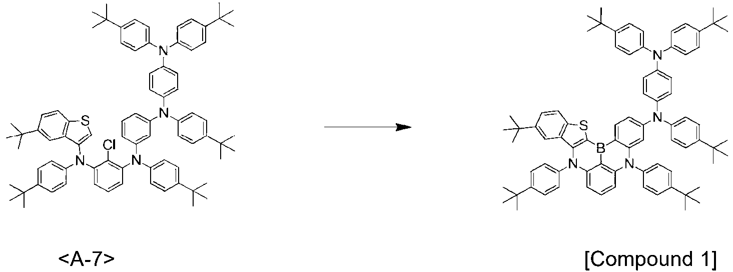

<A-7> (20 g) and tert-butylbenzene (200 mL) were introduced to a reactor, and then a 1.7 M tert-butyllithium pentane solution (24 mL) was added dropwise thereto at -78°C. The mixture was heated to 60°C and stirred for 2 hours, and pentane was completely removed by blowing nitrogen thereinto. After cooling the mixture to -78°C, boron tribromide (1.7 mL) was added dropwise thereto. The mixture was warmed to room temperature, then stirred for 2 hours, then cooled to 0°C, and then N,N-diisopropylethylamine (3 mL) was added dropwise thereto. The mixture was heated to 120°C, and then stirred for 16 hours. The mixture was cooled to room temperature, then a 10% aqueous sodium acetate solution and ethyl acetate were introduced thereto, and then the organic layer was separated and concentrated under reduced pressure. The result was purified by silica gel chromatography to obtain [Compound 1] (3 g, 15.4%).
MS (MALDI-TOF): m/z 1146.67 [M⁺]

### Synthesis Example 2: Synthesis of [Compound 16]

### Synthesis Example 2-1: Synthesis of B-1

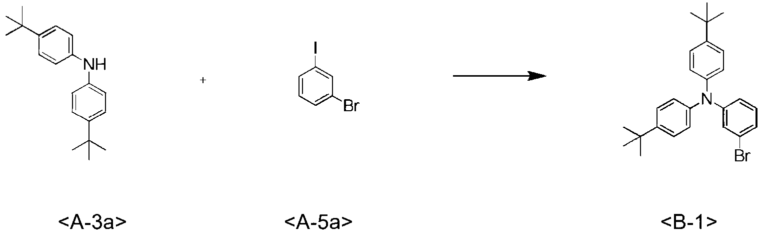

<B-1> was obtained by performing a synthesis in the same manner as in Synthesis Example 1-3, except that <A-5a> was used instead of <A-3b>. (Yield 74.2%)

### Synthesis Example 2-2: Synthesis of B-2

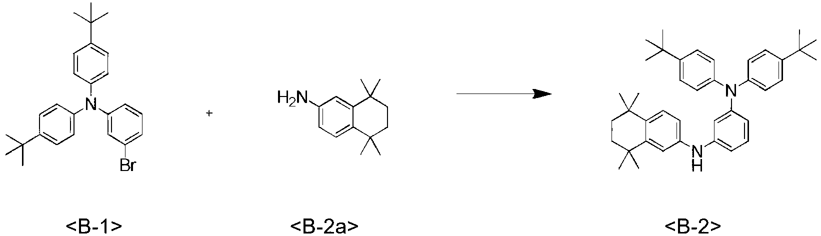

<B-2> was obtained by performing a synthesis in the same manner as in Synthesis Example 1-2, except that <B-2a> was used instead of <A-1>, and <B-1> was used instead of <A-2a>. (Yield 82.4%)

### Synthesis Example 2-3: Synthesis of B-3

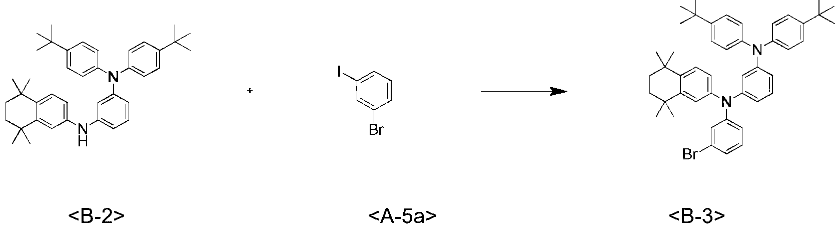

<B-3> was obtained by performing a synthesis in the same manner as in Synthesis Example 1-3, except that <B-2> was used instead of <A-3a>, and <A-5a> was used instead of <A-3b>. (Yield 68.7%)

### Synthesis Example 2-4: Synthesis of B-4

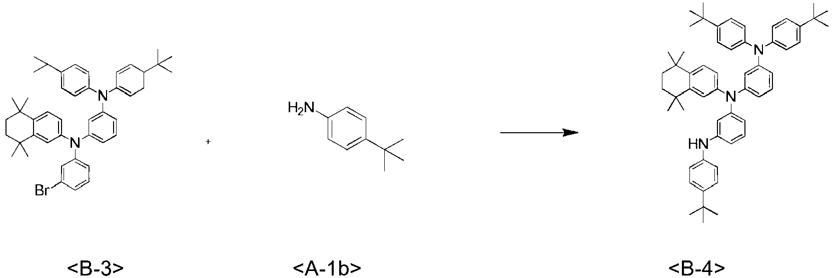

<B-4> was obtained by performing a synthesis in the same manner as in Synthesis Example 1-1, except that <B-3> was used instead of <A-1a>. (Yield 59.7%)

### Synthesis Example 2-5: Synthesis of B-5

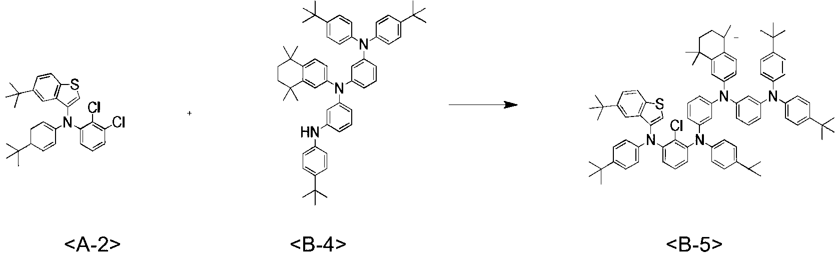

<B-5> was obtained by performing a synthesis in the same manner as in Synthesis Example 1-2, except that <B-4> was used instead of <A-1>, and <A-2> was used instead of <A-2a>. (Yield 87.6%)

### Synthesis Example 2-6: Synthesis of [Compound 16]

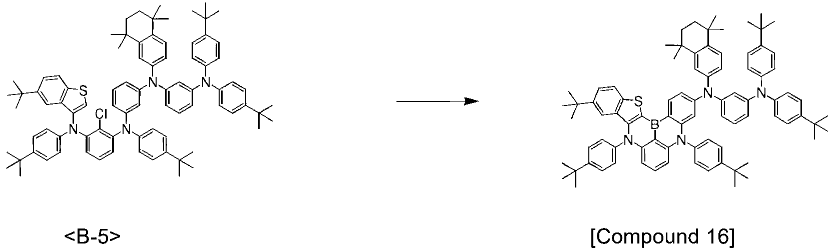

[Compound 16] was obtained by performing a synthesis in the same manner as in Synthesis Example 1-8, except that <B-5> was used instead of <A-7>. (Yield 13.9%)
MS (MALDI-TOF): m/z 1200.72 [M⁺]

### Synthesis Example 3: Synthesis of [Compound 20]

### Synthesis Example 3-1: Synthesis of C-1

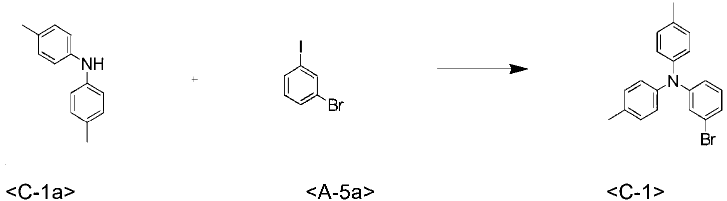

<C-1> was obtained by performing a synthesis in the same manner as in Synthesis Example 1-3, except that <C-1a> was used instead of <A-3a>, and <A-5a> was used instead of <A-3b>. (Yield 73.4%)

### Synthesis Example 3-2: Synthesis of C-2

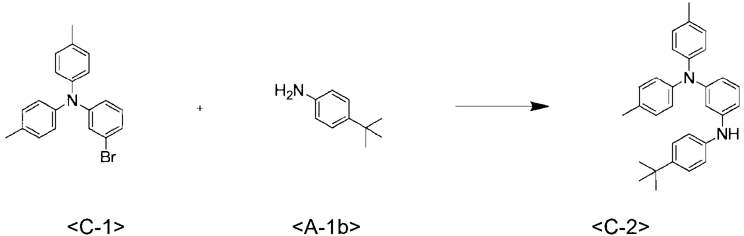

<C-2> was obtained by performing a synthesis in the same manner as in Synthesis Example 1-1, except that <C-1> was used instead of <A-1a>. (Yield 62.2%)

### Synthesis Example 3-3: Synthesis of C-3

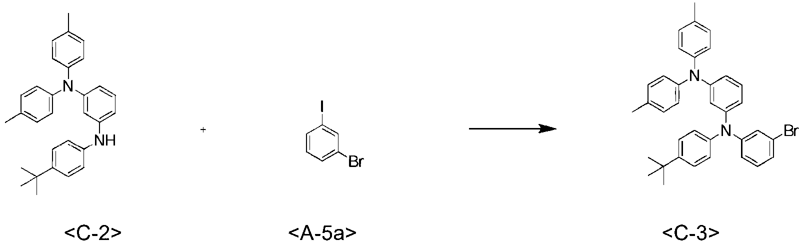

<C-3> was obtained by performing a synthesis in the same manner as in Synthesis Example 1-3, except that <C-2> was used instead of <A-3a>, and <A-5a> was used instead of <A-3b>. (Yield 69.5%)

### Synthesis Example 3-4: Synthesis of C-4

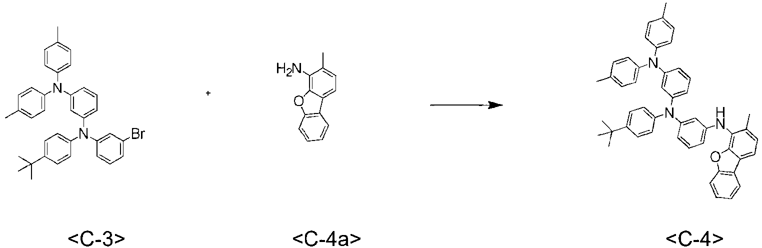

<C-4> was obtained by performing a synthesis in the same manner as in Synthesis Example 1-2, except that <C-4a> was used instead of <A-1>, and <C-3> was used instead of <A-2a>. (Yield 84.7%)

### Synthesis Example 3-5: Synthesis of C-5

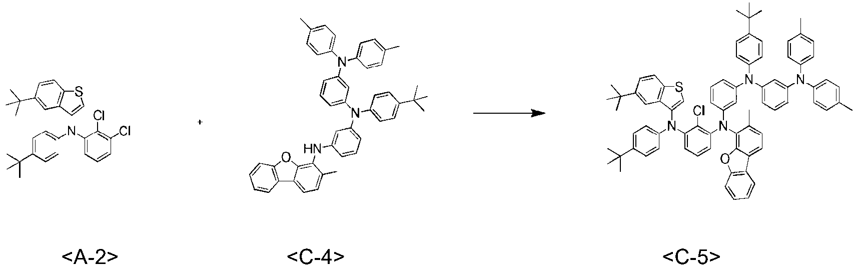

<C-5> was obtained by performing a synthesis in the same manner as in Synthesis Example 1-2, except that <C-4> was used instead of <A-1>, and <A-2> was used instead of <A-2a>. (Yield 86.7%)

### Synthesis Example 3-6: Synthesis of [Compound 20]

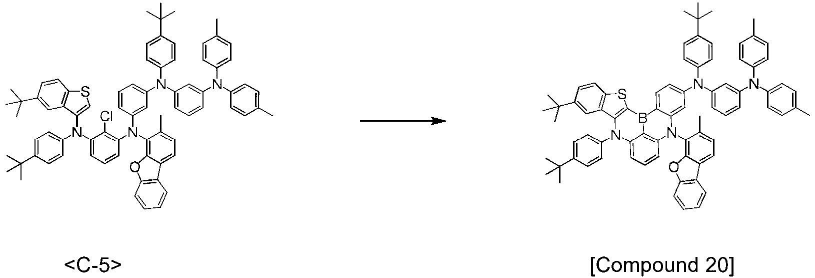

[Compound 20] was obtained by performing a synthesis in the same manner as in Synthesis Example 1-8, except that <C-5> was used instead of <A-7>. (Yield 14.1%)
MS (MALDI-TOF): m/z 1110.54 [M⁺]

### Synthesis Example 4: Synthesis of [Compound 48]

### Synthesis Example 4-1: Synthesis of D-1

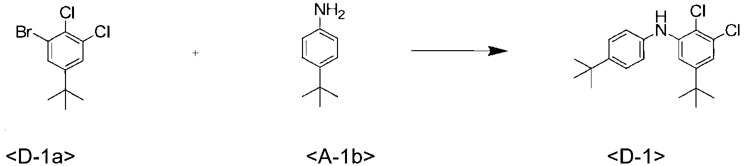

<D-1> was obtained by performing a synthesis in the same manner as in Synthesis Example 1-1, except that <D-1a> was used instead of <A-1a>. (Yield 60.1%)

### Synthesis Example 4-2: Synthesis of D-2

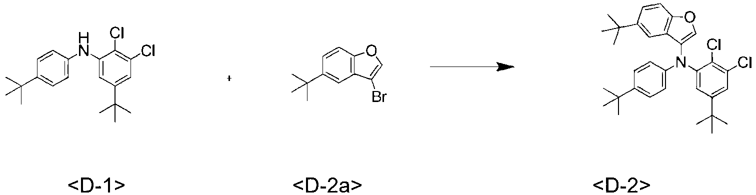

<D-2> was obtained by performing a synthesis in the same manner as in Synthesis Example 1-2, except that <D-1> was used instead of <A-1>, and <D-2a> was used instead of <A-2a>. (Yield 77.4%)

### Synthesis Example 4-3: Synthesis of D-3

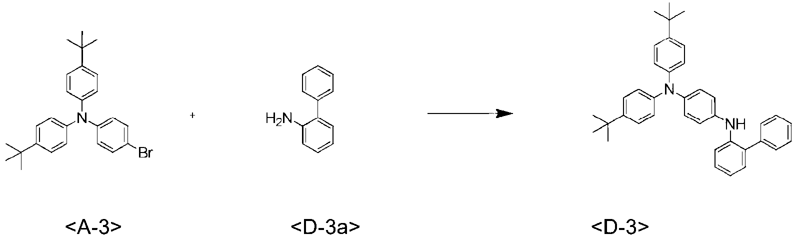

<D-3> was obtained by performing a synthesis in the same manner as in Synthesis Example 1-1, except that <A-3> was used instead of <A-1a>, and <D-3a> was used instead of <A-1b>. (Yield 57.7%)

### Synthesis Example 4-4: Synthesis of D-4

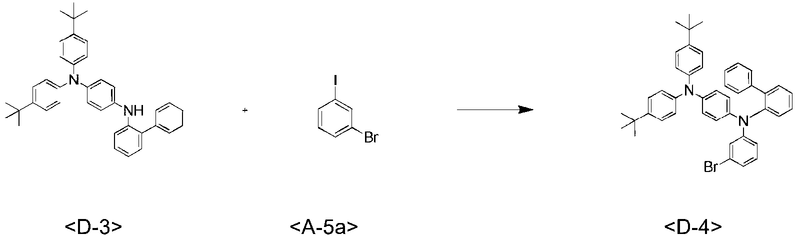

<D-4> was obtained by performing a synthesis in the same manner as in Synthesis Example 1-3, except that <D-3> was used instead of <A-3a>, and <A-5a> was used instead of <A-3b>. (Yield 68.6%)

### Synthesis Example 4-5: Synthesis of D-5

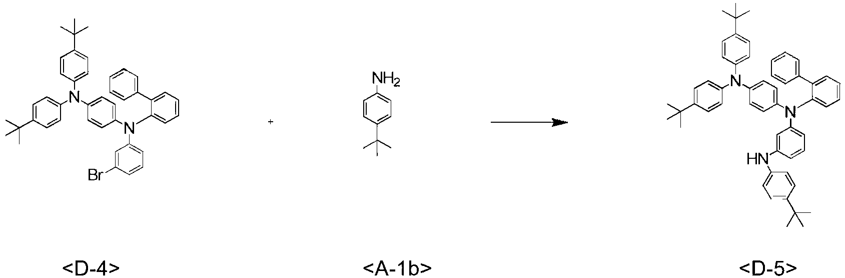

<D-5> was obtained by performing a synthesis in the same manner as in Synthesis Example 1-1, except that <D-4> was used instead of <A-1a>. (Yield 68.2%)

### Synthesis Example 4-6: Synthesis of D-6

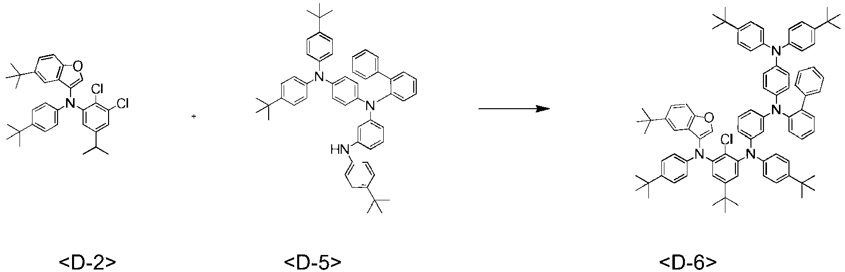

<D-6> was obtained by performing a synthesis in the same manner as in Synthesis Example 1-2, except that <D-5> was used instead of <A-1>, and <D-2> was used instead of <A-2a>. (Yield 90.2%)

### Synthesis Example 4-7: Synthesis of [Compound 48]

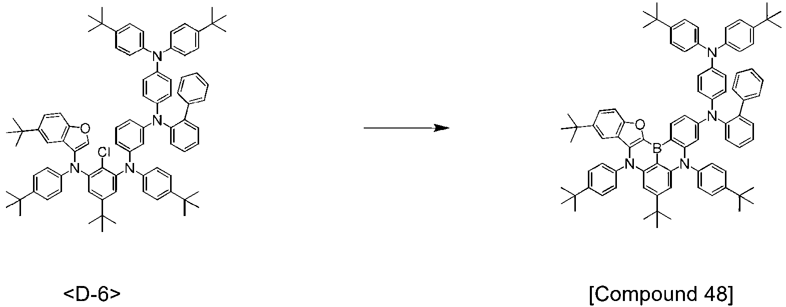

[Compound 48] was obtained by performing a synthesis in the same manner as in Synthesis Example 1-8, except that <D-6> was used instead of <A-7>. (Yield 10.6%)
MS (MALDI-TOF): m/z 1206.73 [M⁺]

### Synthesis Example 5: Synthesis of [Compound 49]

### Synthesis Example 5-1: Synthesis of E-1

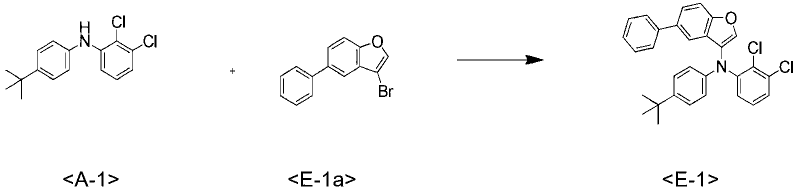

<E-1> was obtained by performing a synthesis in the same manner as in Synthesis Example 1-2, except that <E-1a> was used instead of <A-2a>. (Yield 78.2%)

### Synthesis Example 5-2: Synthesis of E-2

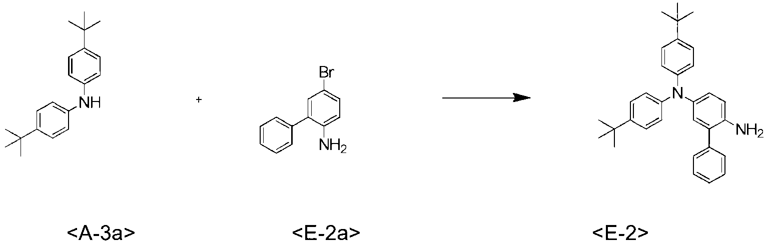

<E-2> was obtained by performing a synthesis in the same manner as in Synthesis Example 1-1, except that <E-2a> was used instead of <A-1a>, and <A-3a> was used instead of <A-1b>. (Yield 59.7%)

### Synthesis Example 5-3: Synthesis of E-3

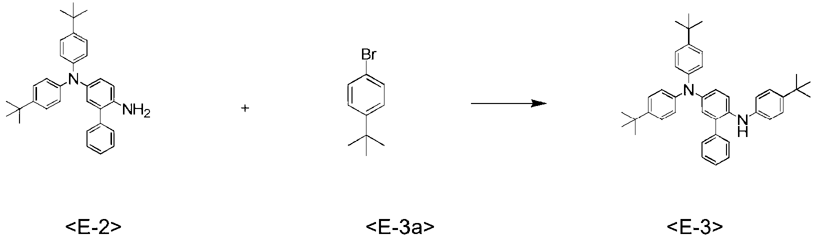

<E-3> was obtained by performing a synthesis in the same manner as in Synthesis Example 1-1, except that <E-3a> was used instead of <A-1a>, and <E-2> was used instead of <A-1b>. (Yield 62.7%)

### Synthesis Example 5-4: Synthesis of E-4

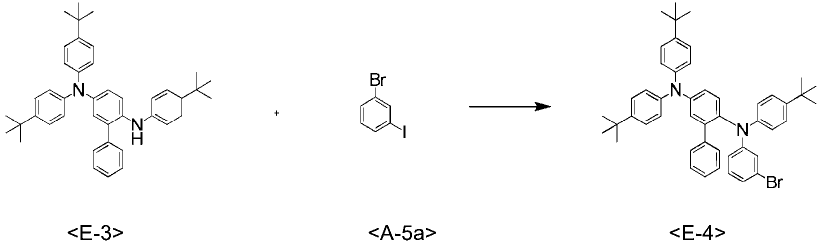

<E-4> was obtained by performing a synthesis in the same manner as in Synthesis Example 1-3, except that <E-3> was used instead of <A-3a>, and <A-5a> was used instead of <A-3b>. (Yield 70.7%)

### Synthesis Example 5-5: Synthesis of E-5

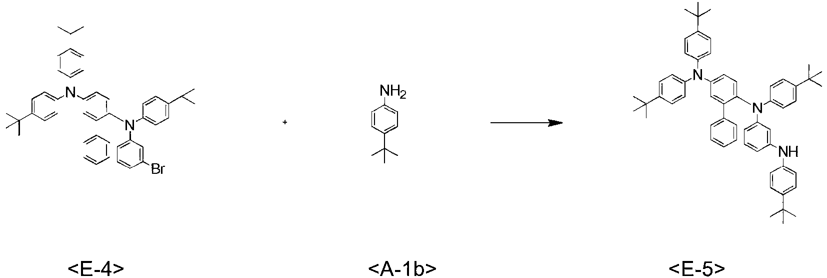

<E-5> was obtained by performing a synthesis in the same manner as in Synthesis Example 1-1, except that <E-4> was used instead of <A-1a>. (Yield 61.5%)

### Synthesis Example 5-6: Synthesis of E-6

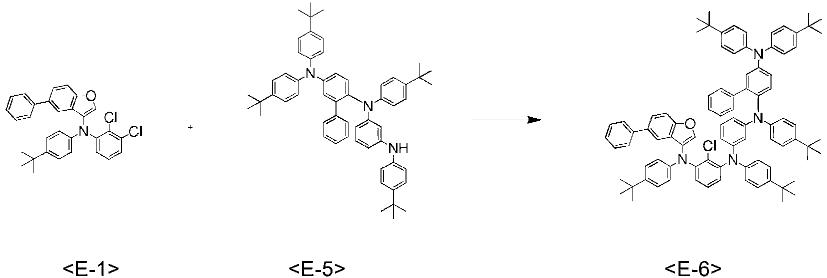

<E-6> was obtained by performing a synthesis in the same manner as in Synthesis Example 1-2, except that <E-5> was used instead of <A-1>, and <E-1> was used instead of <A-2a>. (Yield 85.7%)

### Synthesis Example 5-7: Synthesis of [Compound 49]

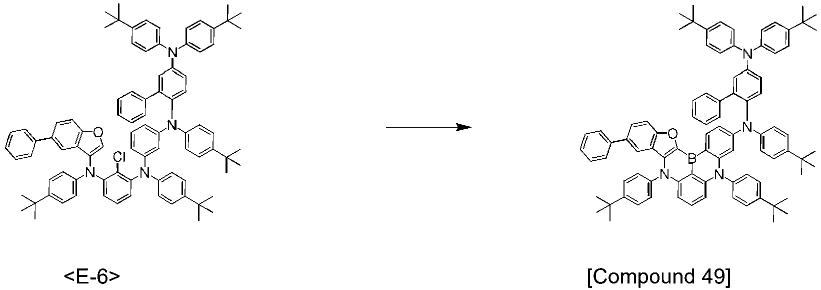

[Compound 49] was obtained by performing a synthesis in the same manner as in Synthesis Example 1-8, except that <E-6> was used instead of <A-7>. (Yield 11.5%)
MS (MALDI-TOF): m/z 1226.70 [M⁺]

### Synthesis Example 6: Synthesis of [Compound 55]

### Synthesis Example 6-1: Synthesis of F-1

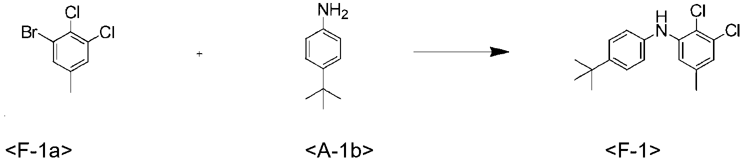

<F-1> was obtained by performing a synthesis in the same manner as in Synthesis Example 1-1, except that <F-1a> was used instead of <A-1a>. (Yield 57.7%)

### Synthesis Example 6-2: Synthesis of F-2

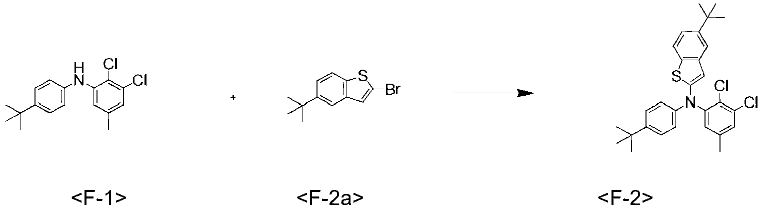

<F-2> was obtained by performing a synthesis in the same manner as in Synthesis Example 1-2, except that <F-1> was used instead of <A-1>, and <F-2a> was used instead of <A-2a>. (Yield 71.8%)

### Synthesis Example 6-3: Synthesis of F-3

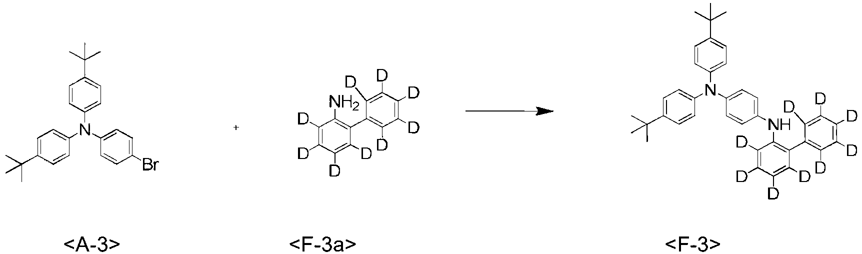

<F-3> was obtained by performing a synthesis in the same manner as in Synthesis Example 1-1, except that <A-3> was used instead of <A-1a>, and <F-3a> was used instead of <A-1b>. (Yield 55.7%)

### Synthesis Example 6-4: Synthesis of F-4

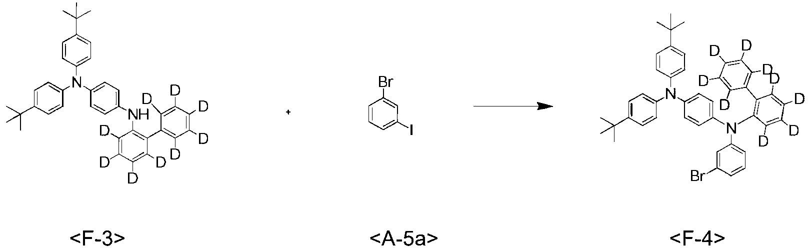

<F-4> was obtained by performing a synthesis in the same manner as in Synthesis Example 1-3, except that <F-3> was used instead of <A-3a>, and <A-5a> was used instead of <A-3b>. (Yield 68.7%)

### Synthesis Example 6-5: Synthesis of F-5

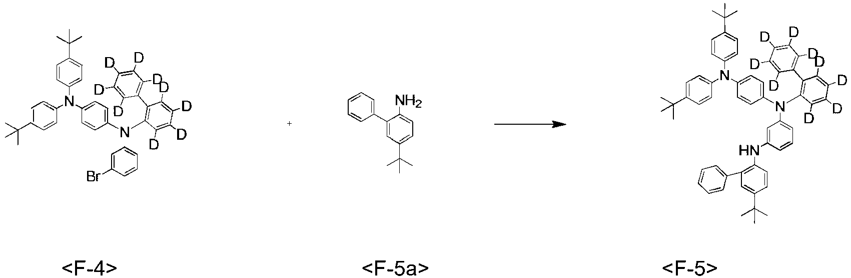

<F-5> was obtained by performing a synthesis in the same manner as in Synthesis Example 1-1, except that <F-4> was used instead of <A-1a>, and <F-5a> was used instead of <A-1b>. (Yield 62.2%)

### Synthesis Example 6-6: Synthesis of F-6

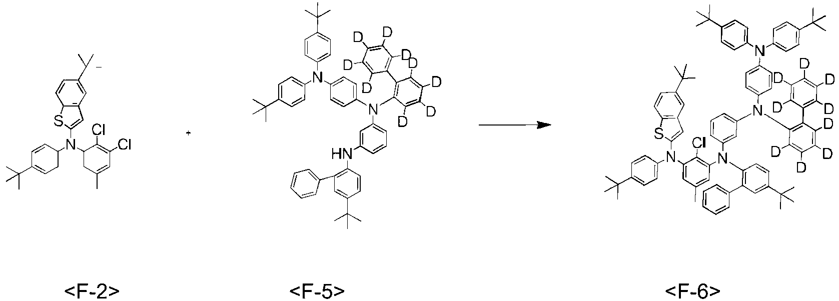

<F-6> was obtained by performing a synthesis in the same manner as in Synthesis Example 1-2, except that <F-5> was used instead of <A-1>, and <F-2> was used instead of <A-2a>. (Yield 76.4%)

### Synthesis Example 6-7: Synthesis of [Compound 55]

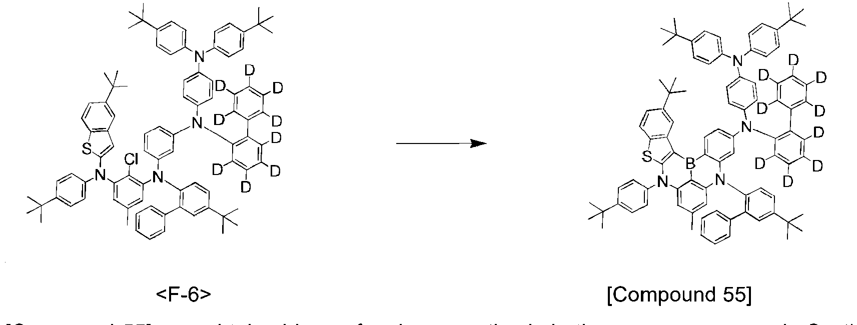

[Compound 55] was obtained by performing a synthesis in the same manner as in Synthesis Example 1-8, except that <F-6> was used instead of <A-7>. (Yield 10.2%)
MS (MALDI-TOF): m/z 1265.75 [M⁺]

### Synthesis Example 7: Synthesis of [Compound 67]

### Synthesis Example 7-1: Synthesis of G-1

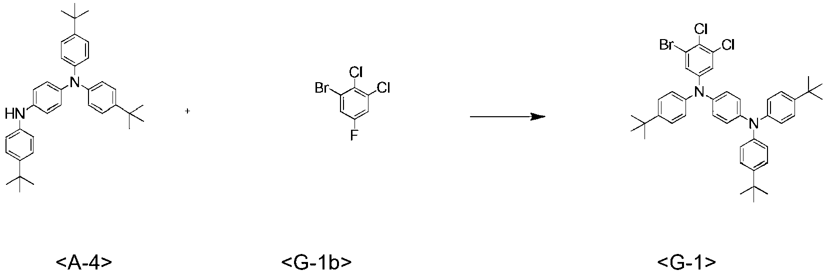

<A-4> (15 g), <G-1b> (6.2 g), cesium carbonate (19.4 g), potassium hydroxide (0.8 g) and dimethylformaldehyde (100 mL) were introduced to a reactor, and the mixture was heated and stirred at 140°C for 24 hours. After the reaction was terminated, the result was cooled to room temperature, and then the organic layer was separated, dried with anhydrous magnesium sulfate and then concentrated under reduced pressure. The result was purified by silica gel chromatography to obtain <G-1> (15 g, 69.3%).

### Synthesis Example 7-2: Synthesis of G-2

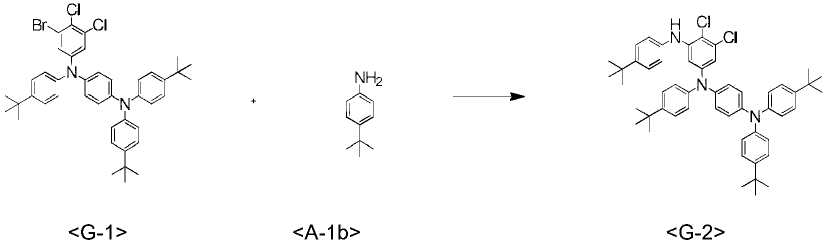

<G-2> was obtained by performing a synthesis in the same manner as in Synthesis Example 1-1, except that <G-1> was used instead of <A-1a>. (Yield 61.6%)

### Synthesis Example 7-3: Synthesis of G-3

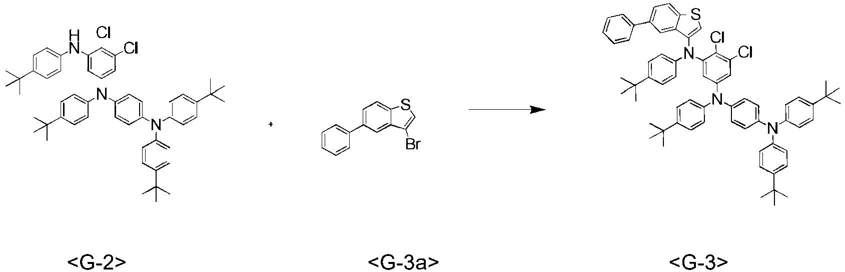

<G-3> was obtained by performing a synthesis in the same manner as in Synthesis Example 1-2, except that <G-2> was used instead of <A-1>, and <G-3a> was used instead of <A-2a>. (Yield 86.5%)

### Synthesis Example 7-4: Synthesis of G-4

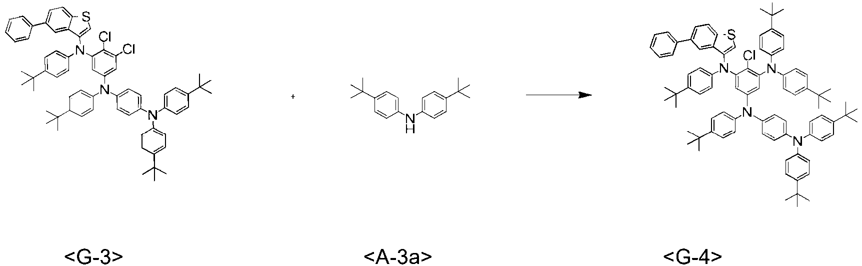

<G-4> was obtained by performing a synthesis in the same manner as in Synthesis Example 1-2, except that <A-3a> was used instead of <A-1>, and <G-3> was used instead of <A-2a>. (Yield 91.6%)

### Synthesis Example 7-5: Synthesis of [Compound 67]

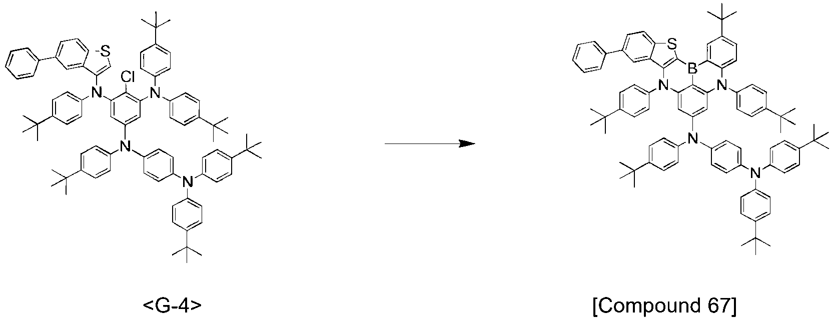

[Compound 67] was obtained by performing a synthesis in the same manner as in Synthesis Example 1-8, except that <G-4> was used instead of <A-7>. (Yield 15.7%)
MS (MALDI-TOF): m/z 1222.71 [M⁺]

### Synthesis Example 8: Synthesis of [Compound 98]

### Synthesis Example 8-1: Synthesis of H-1

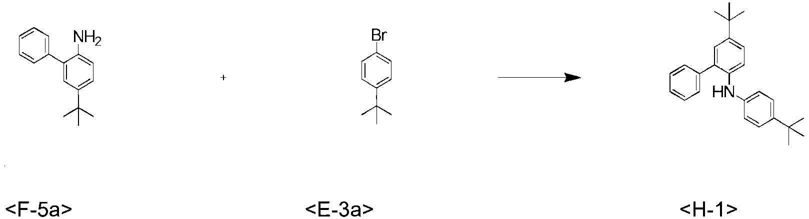

<H-1> was obtained by performing a synthesis in the same manner as in Synthesis Example 1-1, except that <E-3a> was used instead of <A-1a>, and <F-5a> was used instead of <A-1b>. (Yield 64.4%)

### Synthesis Example 8-2: Synthesis of H-2

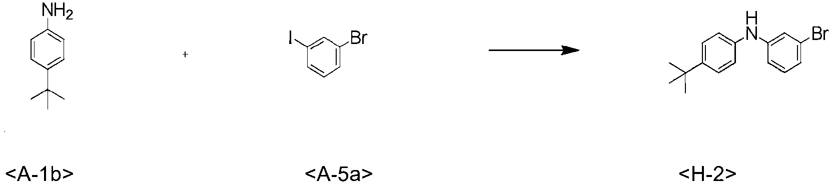

<H-2> was obtained by performing a synthesis in the same manner as in Synthesis Example 1-3, except that <A-1b> was used instead of <A-3a>, and <A-5a> was used instead of <A-3b>. (Yield 74.6%)

### Synthesis Example 8-3: Synthesis of H-3

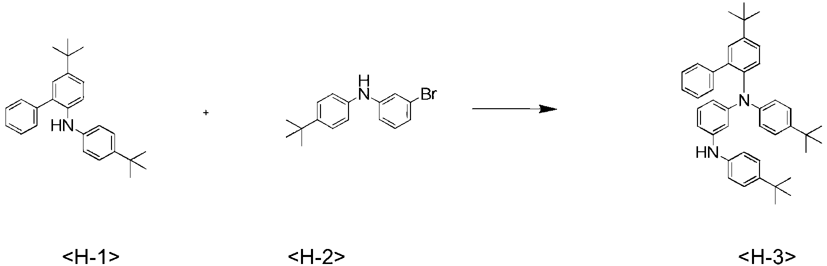

<H-3> was obtained by performing a synthesis in the same manner as in Synthesis Example 1-1, except that <H-2> was used instead of <A-1a>, and <H-1> was used instead of <A-1b>. (Yield 61.6%)

### Synthesis Example 8-4: Synthesis of H-4

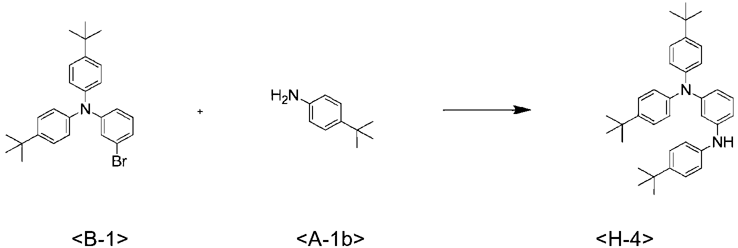

<H-4> was obtained by performing a synthesis in the same manner as in Synthesis Example 1-1, except that <B-1> was used instead of <A-1a>. (Yield 60.9%)

### Synthesis Example 8-5: Synthesis of H-5

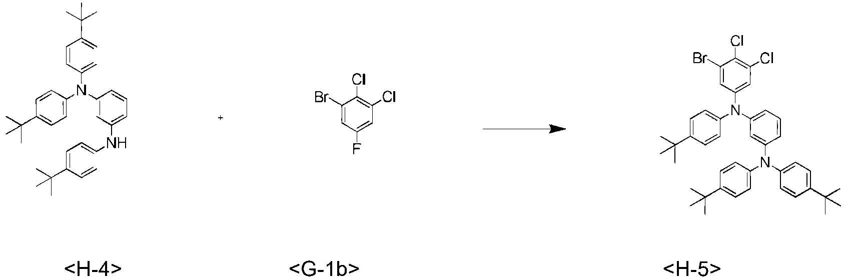

<H-5> was obtained by performing a synthesis in the same manner as in Synthesis Example 7-1, except that <H-5> was used instead of <G-1a>. (Yield 70.1%)

### Synthesis Example 8-6: Synthesis of H-6

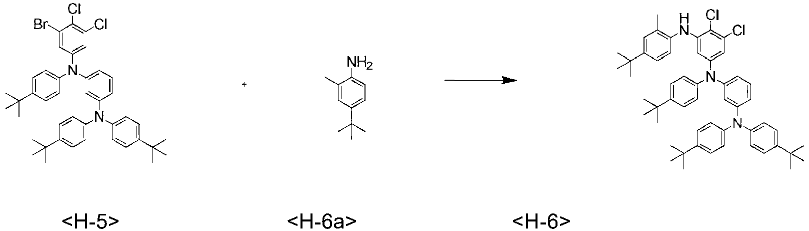

<H-6> was obtained by performing a synthesis in the same manner as in Synthesis Example 1-1, except that <H-5> was used instead of <A-1a>, and <H-6a> was used instead of <A-1b>. (Yield 56.8%)

### Synthesis Example 8-7: Synthesis of H-7

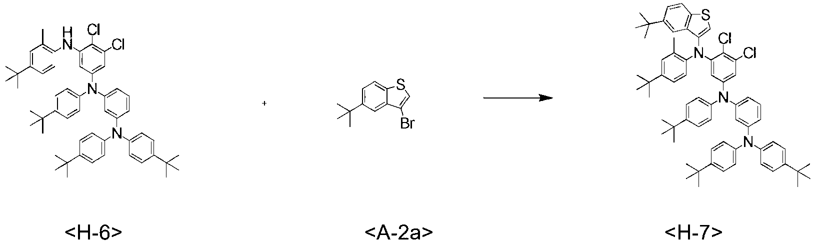

<H-7> was obtained by performing a synthesis in the same manner as in Synthesis Example 1-2, except that <H-6> was used instead of <A-1>. (Yield 87.6%)

### Synthesis Example 8-8: Synthesis of H-8

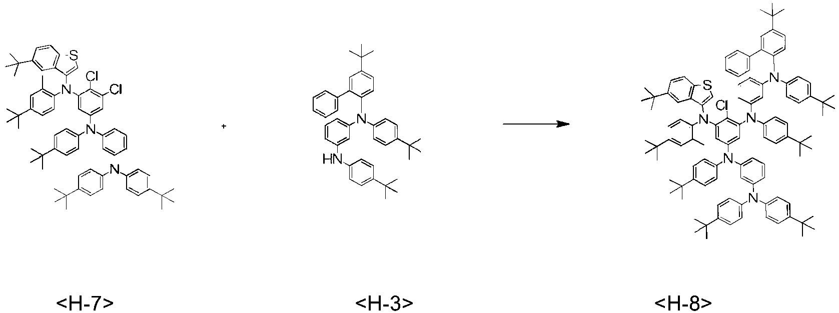

<H-8> was obtained by performing a synthesis in the same manner as in Synthesis Example 1-2, except that <H-3> was used instead of <A-1>, and <H-7> was used instead of <A-2a>. (Yield 85.3%)

### Synthesis Example 8-9: Synthesis of [Compound 98]

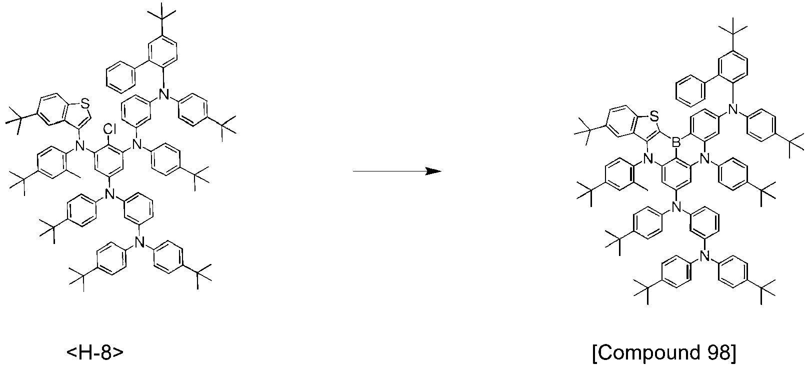

[Compound 98] was obtained by performing a synthesis in the same manner as in Synthesis Example 1-8, except that <H-8> was used instead of <A-7>. (Yield 13.3%)
MS (MALDI-TOF): m/z 1515.92 [M⁺]

### Synthesis Example 9: Synthesis of [Compound 114]

### Synthesis Example 9-1: Synthesis of I-1

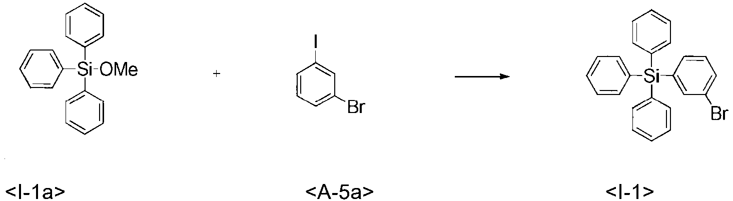

<A-5a> (23.4 g) and THF (260 mL) were introduced to a reactor under a nitrogen atmosphere, and after cooling the mixture to -78°C, 1.6 M n-butyllithium (60 mL) was slowly added dropwise thereto. The mixture was stirred for 1 hour, and then <I-1a> (20 g) dissolved in THF (120 mL) was introduced thereto. The mixture was further stirred for 1 hour and stirred for 12 hours at room temperature. After the reaction was terminated, the result was extracted with water, and the organic layer was concentrated under reduced pressure and then separated by silica gel chromatography to obtain <I-1> (14.4 g, 50.3%).

### Synthesis Example 9-2: Synthesis of I-2

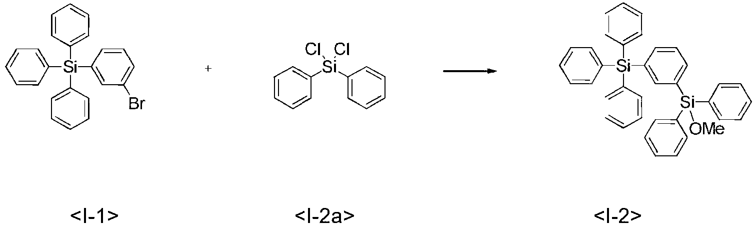

<I-1> (39.4 g) and THF (400 mL) were introduced to a reactor under a nitrogen atmosphere, and after cooling the mixture to -78°C, 1.6 M n-butyllithium (220 mL) was slowly added dropwise thereto. The mixture was stirred for 1 hour, and then <I-2a> (20 g) was introduced thereto. The mixture was further stirred for 1 hour and stirred for 12 hours at room temperature. After the reaction was terminated, a mixture of methanol (64 mL) and triethylamine (32 mL) was introduced thereto, and the result was extracted with water after 10 minutes. The organic layer was concentrated under reduced pressure, and then separated by silica gel chromatography to obtain <I-2> (30.5 g, 70.4%).

### Synthesis Example 9-3: Synthesis of I-3

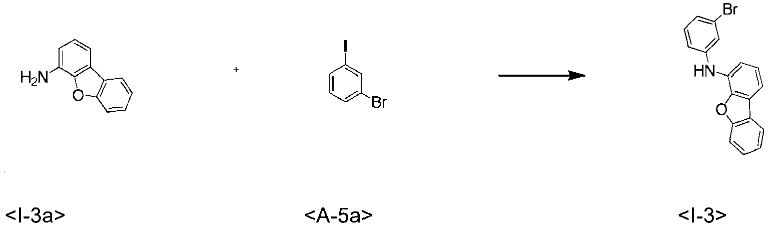

<I-3> was obtained by performing a synthesis in the same manner as in Synthesis Example 1-3, except that <I-3a> was used instead of <A-3a>, and <A-5a> was used instead of <A-3b>. (Yield 74.7%)

### Synthesis Example 9-4: Synthesis of I-4

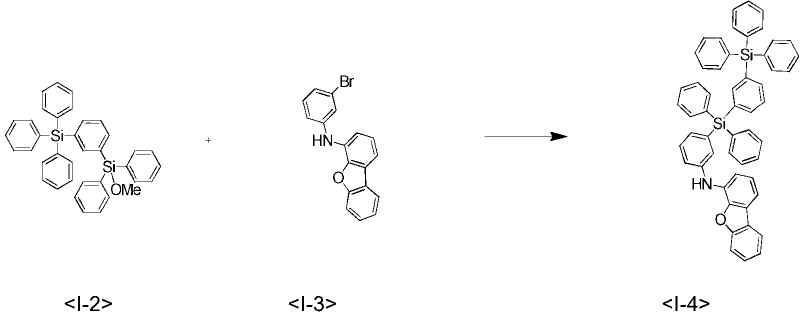

<I-4> was obtained by performing a synthesis in the same manner as in Synthesis Example 9-1, except that <I-2> was used instead of <I-1a>, and <I-3> was used instead of <A-5a>. (Yield 48.5%)

### Synthesis Example 9-5: Synthesis of I-5

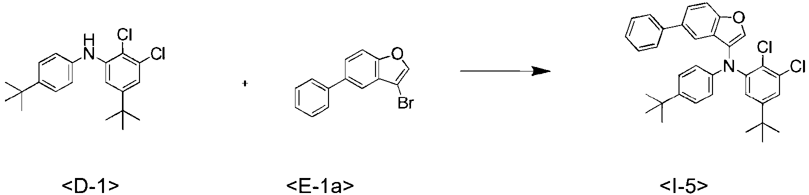

<I-5> was obtained by performing a synthesis in the same manner as in Synthesis Example 1-2, except that <D-1> was used instead of <A-1a>, and <E-1a> was used instead of <A-2a>. (Yield 77.7%)

### Synthesis Example 9-6: Synthesis of I-6

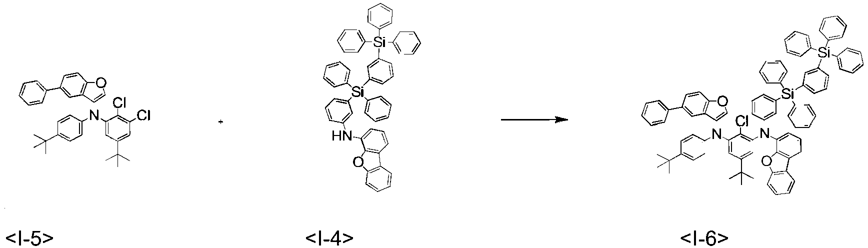

<I-6> was obtained by performing a synthesis in the same manner as in Synthesis Example 1-2, except that <I-4> was used instead of <A-1>, and <I-5> was used instead of <A-2a>. (Yield 86.8%)

### Synthesis Example 9-7: Synthesis of [Compound 114]

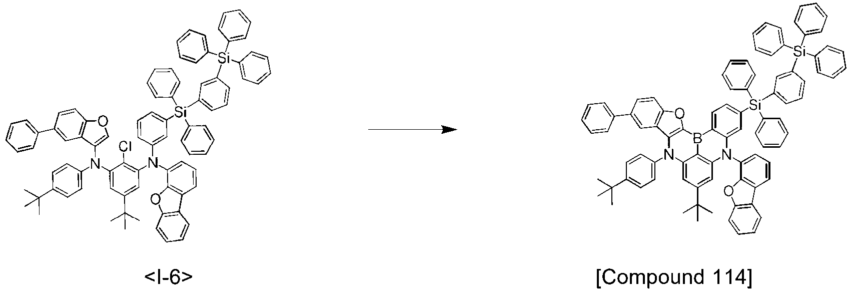

[Compound 114] was obtained by performing a synthesis in the same manner as in Synthesis Example 1-8, except that <I-6> was used instead of <A-7>. (Yield 14.6%)
MS (MALDI-TOF): m/z 1254.51 [M⁺]

### Synthesis Example 10: Synthesis of [Compound 129]

### Synthesis Example 10-1: Synthesis of J-1

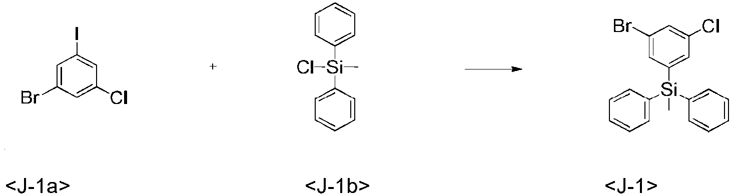

<J-1b> (15.4 g) and THF (100 mL) were introduced to a reactor, and then a 1.6 M n-butyllithium solution (39.4 mL) was added dropwise thereto at -78°C. The mixture was stirred for 2 hours at -78°C, and then <J-1a> (20 g) dissolved in THF (100 mL) was slowly introduced thereto. The mixture was warmed to room temperature, and then stirred for 16 hours. Ethyl acetate and water were introduced thereto, and then the organic layer was separated. The organic layer was purified by silica gel chromatography to obtain <J-1> (17.2 g, 70.4%).

### Synthesis Example 10-2: Synthesis of J-2

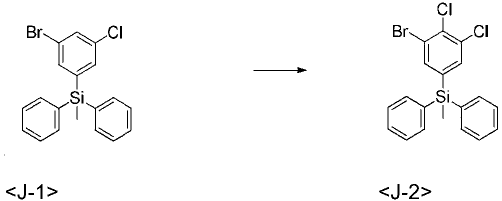

<J-1> (15 g) and THF (150 mL) were introduced to a reactor, and then a 2 M lithium diisopropylamide solution (19.4 mL) was added dropwise thereto at -78°C. The mixture was stirred for 3 hours at -78°C, and then hexachloroethane was slowly introduced thereto. The mixture was warmed to room temperature, and then stirred for 16 hours. Ethyl acetate and water were introduced thereto, and then the organic layer was separated. The organic layer was purified by silica gel chromatography to obtain <J-2> (11.5 g, 70.4%).

### Synthesis Example 10-3: Synthesis of J-3

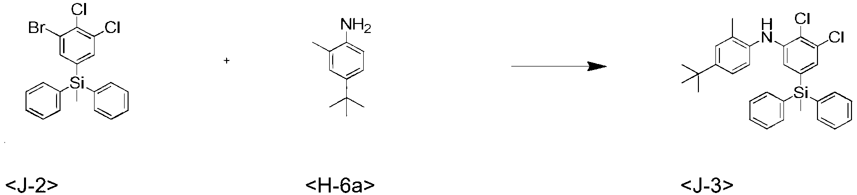

<J-3> was obtained by performing a synthesis in the same manner as in Synthesis Example 1-1, except that <J-2> was used instead of <A-1a>, and <H-6a> was used instead of <A-1b>. (Yield 58.2%)

### Synthesis Example 10-4: Synthesis of J-4

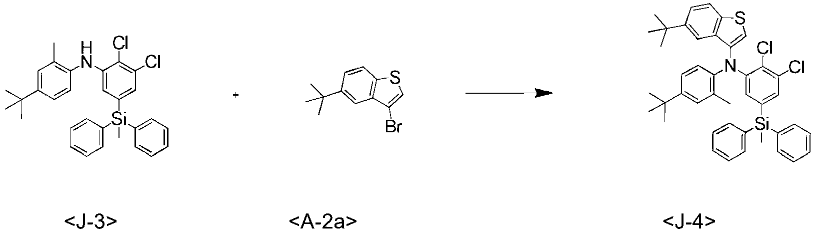

<J-4> was obtained by performing a synthesis in the same manner as in Synthesis Example 1-2, except that <J-3> was used instead of <A-1>. (Yield 86.8%)

### Synthesis Example 10-5: Synthesis of J-5

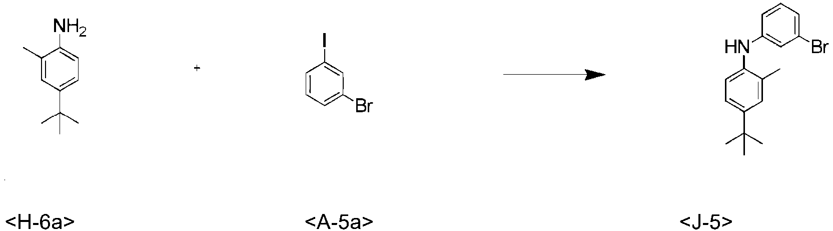

<J-5> was obtained by performing a synthesis in the same manner as in Synthesis Example 1-3, except that <H-6a> was used instead of <A-3a>, and <A-5a> was used instead of <A-3b>. (Yield 75.1%)

### Synthesis Example 10-6: Synthesis of J-6

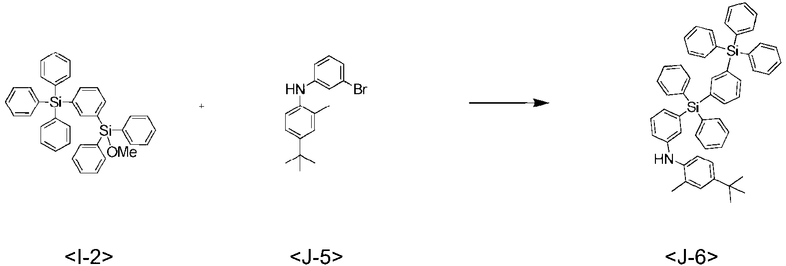

<J-6> was obtained by performing a synthesis in the same manner as in Synthesis Example 9-1, except that <I-2> was used instead of <I-1a>, and <J-5> was used instead of <A-5a>. (Yield 49.6%)

### Synthesis Example 10-7: Synthesis of J-7

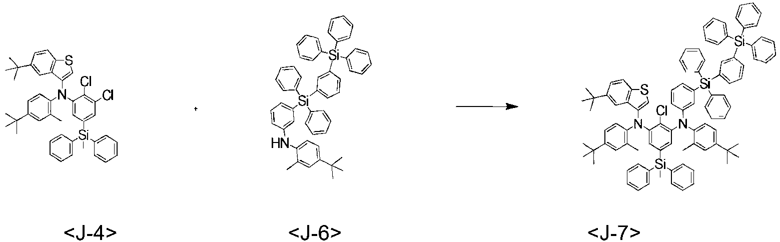

<J-7> was obtained by performing a synthesis in the same manner as in Synthesis Example 1-2, except that <J-6> was used instead of <A-1>, and <J-4> was used instead of <A-2a>. (Yield 84.6%)

### Synthesis Example 10-8: Synthesis of [Compound 129]

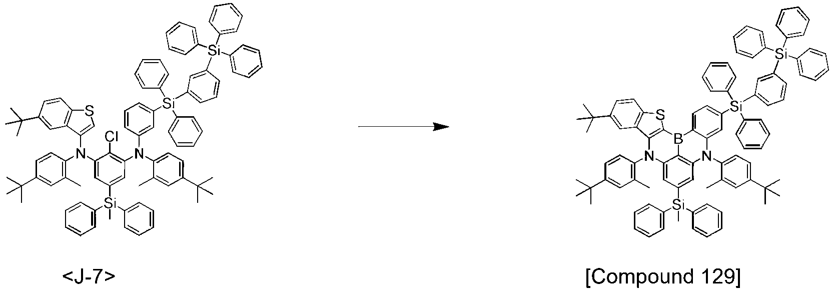

[Compound 129] was obtained by performing a synthesis in the same manner as in Synthesis Example 1-8, except that <J-7> was used instead of <A-7>. (Yield 13.8%)
MS (MALDI-TOF): m/z 1384.61 [M⁺]

### Synthesis Example 11: Synthesis of [Compound 1401

### Synthesis Example 11-1: Synthesis of K-1

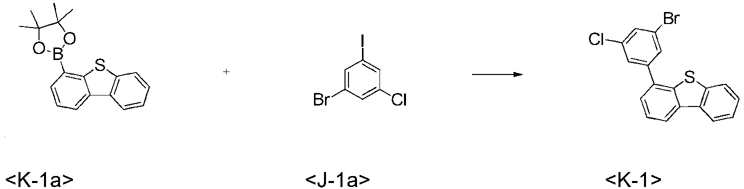

<K-1a> (15 g), <J-1a> (16.6 g), Pd(PPh₃)₄ (1.7 g), K₂CO₃ (16.7 g), THF (160 mL) and water (50 mL) were introduced to a reactor under a nitrogen atmosphere, and the mixture was heated and refluxed for 12 hours. After the reaction was terminated, the result was extracted with water to separate the layers. The organic layer was concentrated under reduced pressured, and then separated by silica gel chromatography to obtain <K-1> (14.8 g, 81.9%).

### Synthesis Example 11-2: Synthesis of K-2

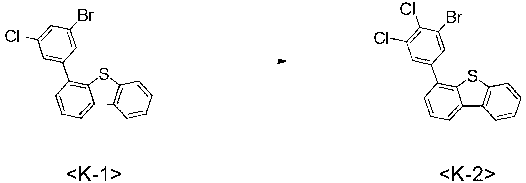

<K-2> was obtained by performing a synthesis in the same manner as in Synthesis Example 10-2, except that <K-1> was used instead of <J-1>. (Yield 71.6%)

### Synthesis Example 11-3: Synthesis of K-3

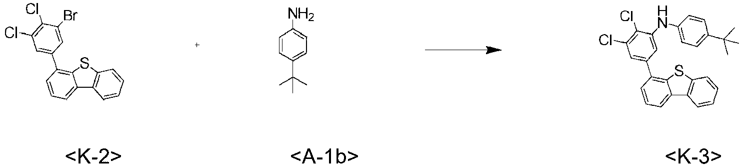

<K-3> was obtained by performing a synthesis in the same manner as in Synthesis Example 1-1, except that <K-2> was used instead of <A-1a>. (Yield 60.8%)

### Synthesis Example 11-4: Synthesis of K-4

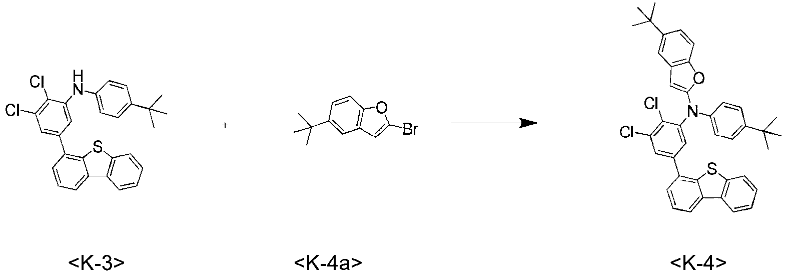

<K-4> was obtained by performing a synthesis in the same manner as in Synthesis Example 1-2, except that <K-3> was used instead of <A-1>, and <K-4a> was used instead of <A-2a>. (Yield 72.4%)

### Synthesis Example 11-5: Synthesis of K-5

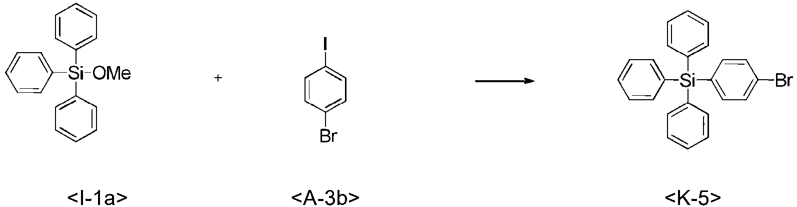

<K-5> was obtained by performing a synthesis in the same manner as in Synthesis Example 9-1, except that <A-3b> was used instead of <A-5a>. (Yield 51.6%)

### Synthesis Example 11-6: Synthesis of K-6

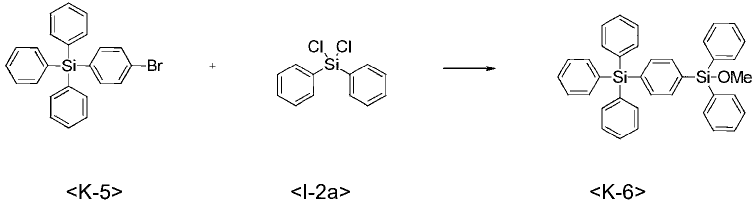

<K-6> was obtained by performing a synthesis in the same manner as in Synthesis Example 9-2, except that <K-5> was used instead of <I-1>. (Yield 68.9%)

### Synthesis Example 11-7: Synthesis of K-7

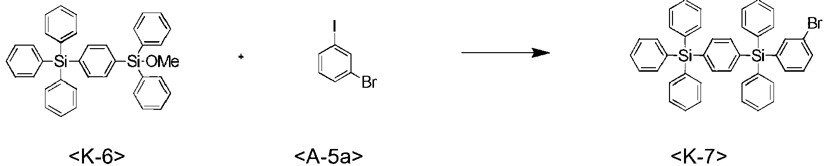

<K-7> was obtained by performing a synthesis in the same manner as in Synthesis Example 9-1, except that <K-6> was used instead of <I-1a>. (Yield 52.7%)

### Synthesis Example 11-8: Synthesis of K-8

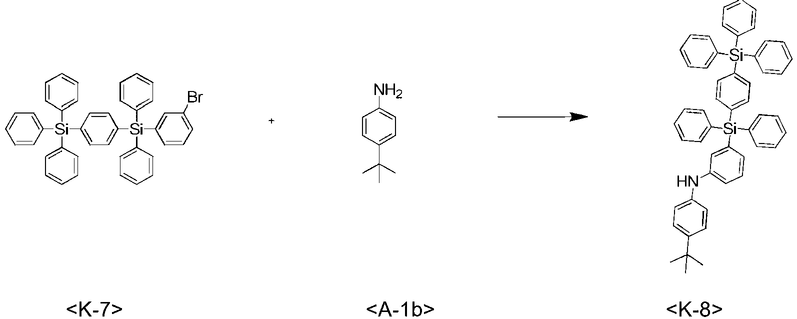

<K-8> was obtained by performing a synthesis in the same manner as in Synthesis Example 1-1, except that <K-7> was used instead of <A-1a>. (Yield 61.8%)

### Synthesis Example 11-9: Synthesis of K-9

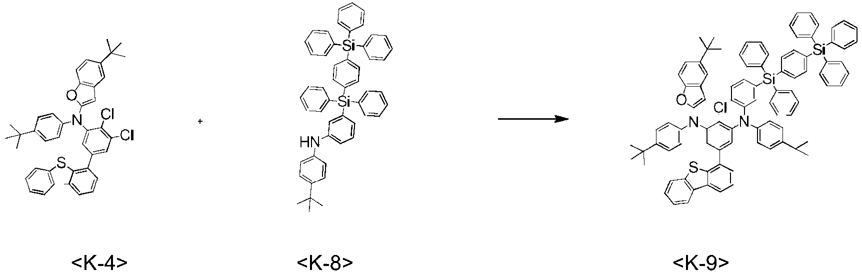

<K-9> was obtained by performing a synthesis in the same manner as in Synthesis Example 1-2, except that <K-8> was used instead of <A-1>, and <K-4> was used instead of <A-2a>. (Yield 74.7%)

### Synthesis Example 11-10: Synthesis of [Compound 140]

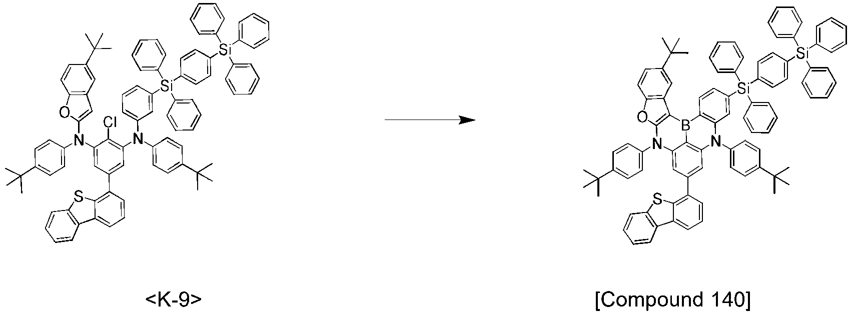

[Compound 140] was obtained by performing a synthesis in the same manner as in Synthesis Example 1-8, except that <K-9> was used instead of <A-7>. (Yield 9.8%)
MS (MALDI-TOF): m/z 1326.55 [M⁺]

### Synthesis Example 12: Synthesis of [Compound 154]

### Synthesis Example 12-1: Synthesis of L-1

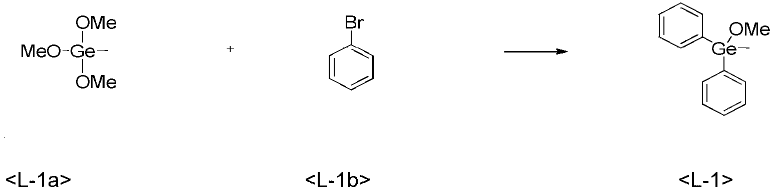

<L-1> was obtained by performing a synthesis in the same manner as in Synthesis Example 9-1, except that <L-1a> was used instead of <I-1a>, and <L-1b> was used instead of <A-5a>. (Yield 74.7%)

### Synthesis Example 12-2: Synthesis of L-2

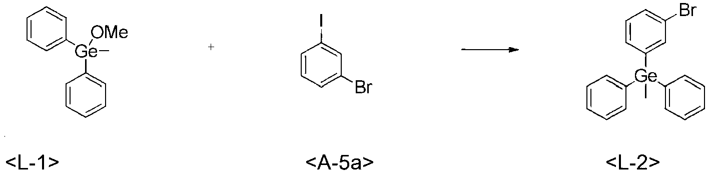

<L-2> was obtained by performing a synthesis in the same manner as in Synthesis Example 9-1, except that <L-1> was used instead of <I-1a>. (Yield 47.8%)

### Synthesis Example 12-3: Synthesis of L-3

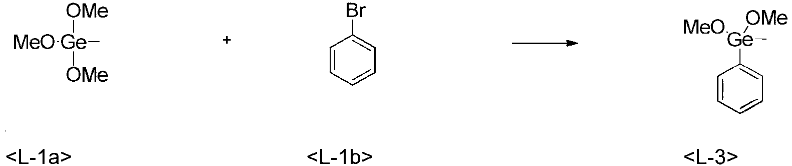

<L-3> was obtained by performing a synthesis in the same manner as in Synthesis Example 9-1, except that <L-1a> was used instead of <I-1a>, and <L-1b> was used instead of <A-5a>. (Yield 72%)

### Synthesis Example 12-4: Synthesis of L-4

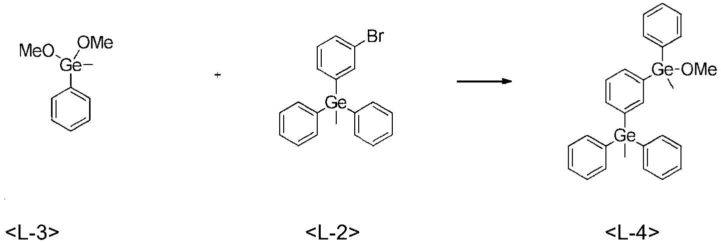

<L-4> was obtained by performing a synthesis in the same manner as in Synthesis Example 9-1, except that <L-3> was used instead of <I-1a>, and <L-2> was used instead of <A-5a>. (Yield 73.1%)

### Synthesis Example 12-5: Synthesis of L-5

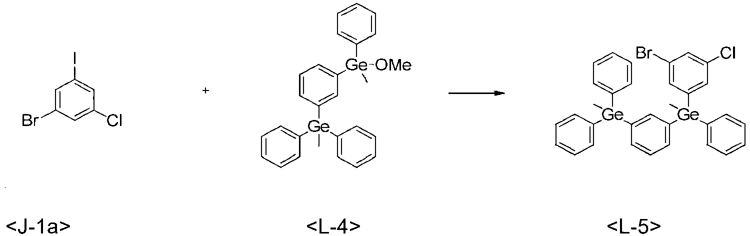

<L-5> was obtained by performing a synthesis in the same manner as in Synthesis Example 9-1, except that <L-4> was used instead of <I-1a>, and <J-1a> was used instead of <A-5a>. (Yield 52.4%)

### Synthesis Example 12-6: Synthesis of L-6

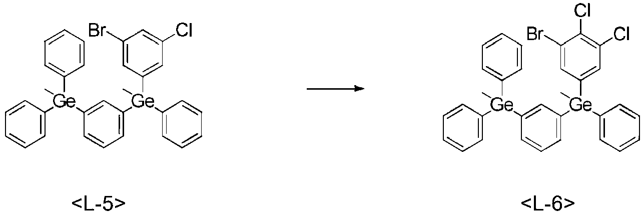

<L-6> was obtained by performing a synthesis in the same manner as in Synthesis Example 10-2, except that <L-5> was used instead of <J-1>. (Yield 71.1%)

### Synthesis Example 12-7: Synthesis of L-7

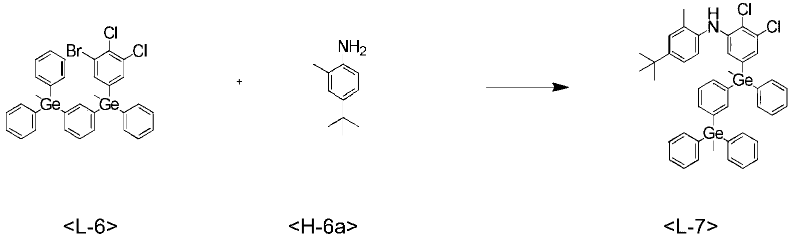

<L-7> was obtained by performing a synthesis in the same manner as in Synthesis Example 1-1, except that <L-6> was used instead of <A-1a>, and <H-6a> was used instead of <A-1b>. (Yield 57.4%)

### Synthesis Example 12-8: Synthesis of L-8

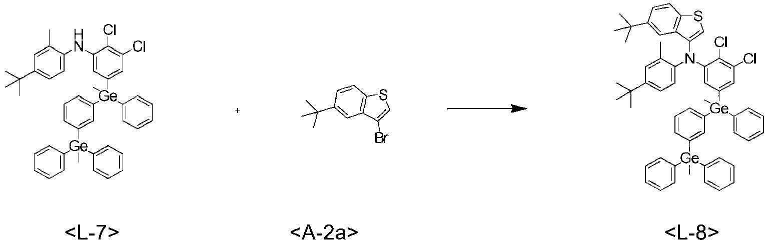

<L-8> was obtained by performing a synthesis in the same manner as in Synthesis Example 1-2, except that <L-7> was used instead of <A-1>. (Yield 89.1%)

### Synthesis Example 12-9: Synthesis of L-9

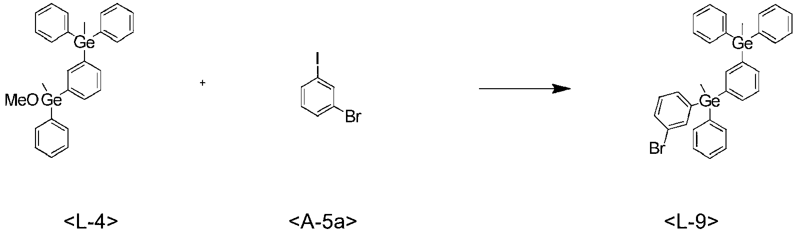

<L-9> was obtained by performing a synthesis in the same manner as in Synthesis Example 9-1, except that <L-4> was used instead of <I-1a>. (Yield 51.1%)

### Synthesis Example 12-10: Synthesis of L-10

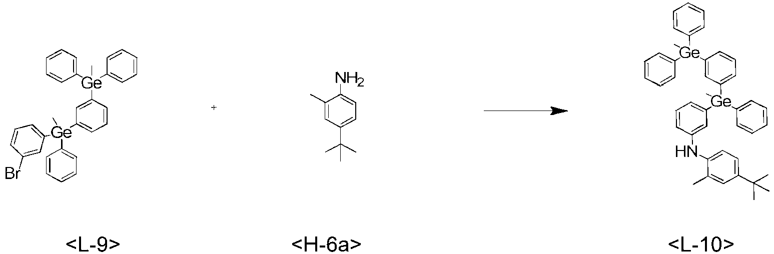

<L-10> was obtained by performing a synthesis in the same manner as in Synthesis Example 1-1, except that <L-9> was used instead of <A-1a>, and <H-6a> was used instead of <A-1b>. (Yield 67.7%)

### Synthesis Example 12-11: Synthesis of L-11

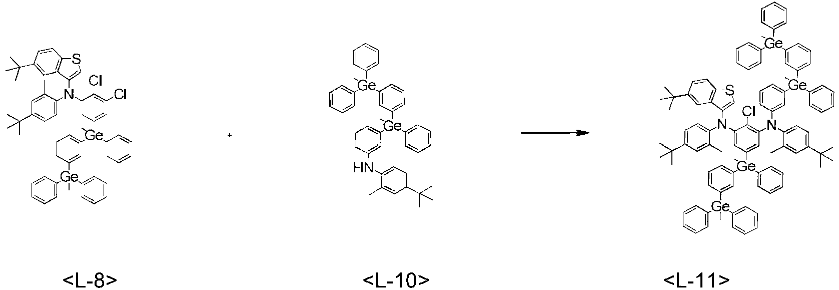

<L-11> was obtained by performing a synthesis in the same manner as in Synthesis Example 1-2, except that <L-10> was used instead of <A-1>, and <L-8> was used instead of <A-2a>. (Yield 86.9%)

### Synthesis Example 12-12: Synthesis of [Compound 154]

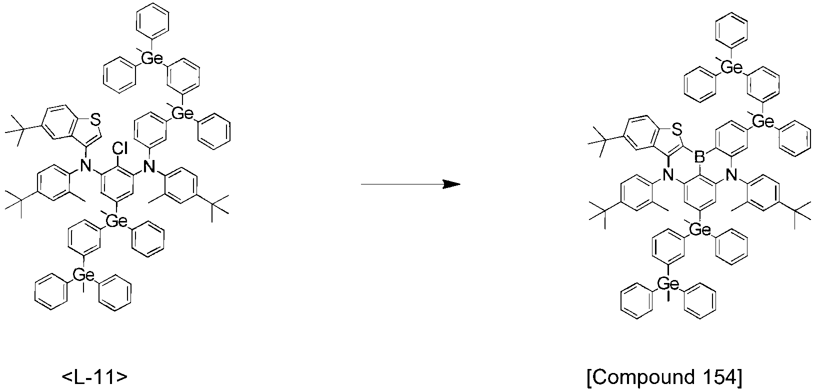

[Compound 154] was obtained by performing a synthesis in the same manner as in Synthesis Example 1-8, except that <L-11> was used instead of <A-7>. (Yield 13.1%)
MS (MALDI-TOF): m/z 1640.43 [M⁺]

### Synthesis Example 13: Synthesis of [Compound 1581

### Synthesis Example 13-1: Synthesis of M-1

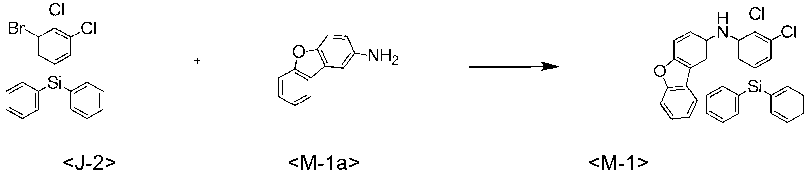

<M-1> was obtained by performing a synthesis in the same manner as in Synthesis Example 1-1, except that <J-2> was used instead of <A-1a>, and <M-1a> was used instead of <A-1b>. (Yield 60.1%)

### Synthesis Example 13-2: Synthesis of M-2

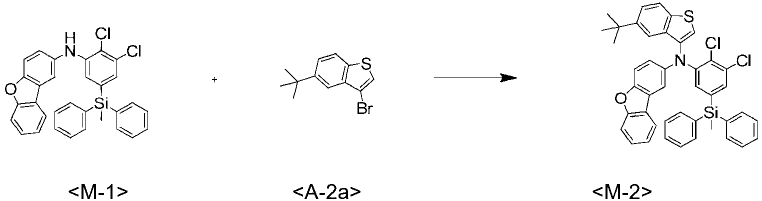

<M-2> was obtained by performing a synthesis in the same manner as in Synthesis Example 1-2, except that <M-1> was used instead of <A-1>. (Yield 89.2%)

### Synthesis Example 13-3: Synthesis of M-3

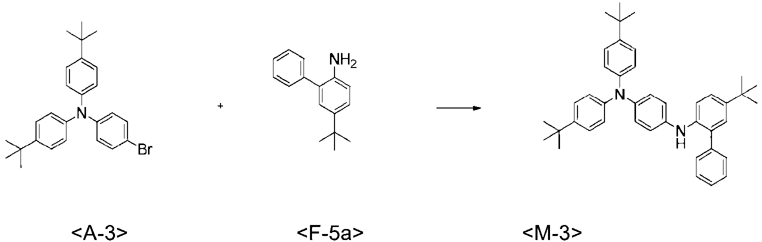

<M-3> was obtained by performing a synthesis in the same manner as in Synthesis Example 1-1, except that <A-3> was used instead of <A-1a>, and <F-5a> was used instead of <A-1b>. (Yield 61.7%)

### Synthesis Example 13-4: Synthesis of M-4

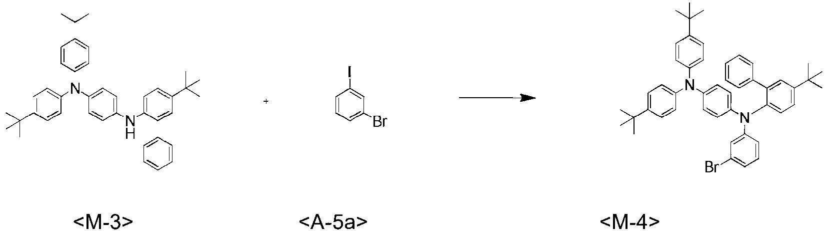

<M-4> was obtained by performing a synthesis in the same manner as in Synthesis Example 1-3, except that <M-3> was used instead of <A-3a>, and <A-5a> was used instead of <A-3b>. (Yield 73.1%)

### Synthesis Example 13-5: Synthesis of M-5

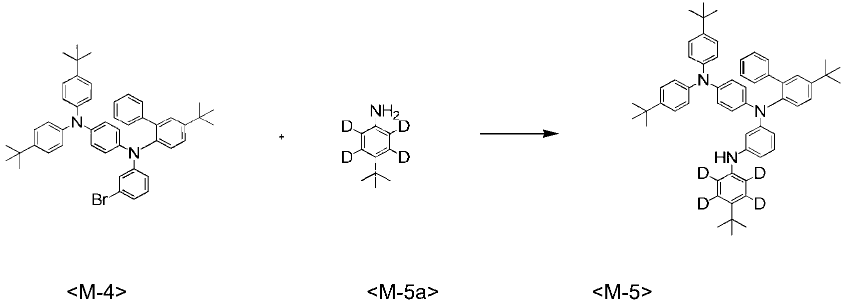

<M-5> was obtained by performing a synthesis in the same manner as in Synthesis Example 1-1, except that <M-4> was used instead of <A-1a>, and <M-5a> was used instead of <A-1b>. (Yield 66.2%)

### Synthesis Example 13-6: Synthesis of M-6

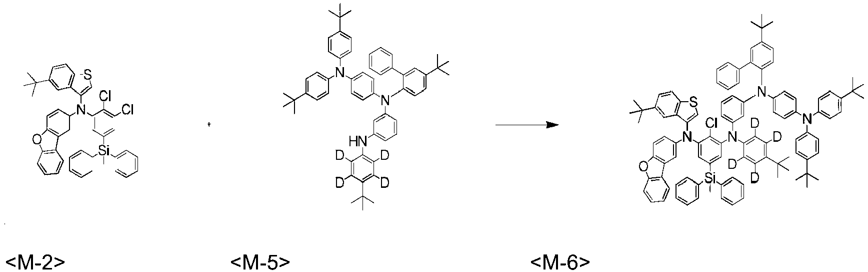

<M-6> was obtained by performing a synthesis in the same manner as in Synthesis Example 1-2, except that <M-5> was used instead of <A-1>, and <M-2> was used instead of <A-2a>. (Yield 87.7%)

### Synthesis Example 13-7: Synthesis of [Compound 158]

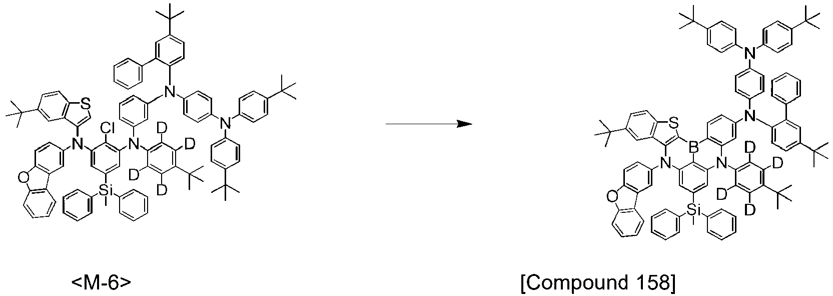

[Compound 158] was obtained by performing a synthesis in the same manner as in Synthesis Example 1-8, except that <M-6> was used instead of <A-7>. (Yield 13.6%)
MS (MALDI-TOF): m/z 1456.75 [M⁺]

### Synthesis Example 14: Synthesis of [Compound 162]

### Synthesis Example 14-1: Synthesis of N-1

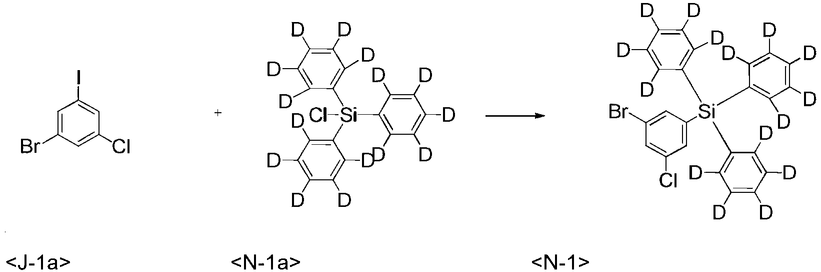

<N-1> was obtained by performing a synthesis in the same manner as in Synthesis Example 10-1, except that <N-1a> was used instead of <J-1b>. (Yield 68.7%)

### Synthesis Example 14-2: Synthesis of N-2

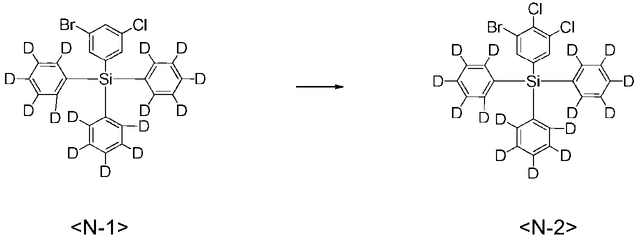

<N-2> was obtained by performing a synthesis in the same manner as in Synthesis Example 10-2, except that <N-1> was used instead of <J-1>. (Yield 71.7%)

### Synthesis Example 14-3: Synthesis of N-3

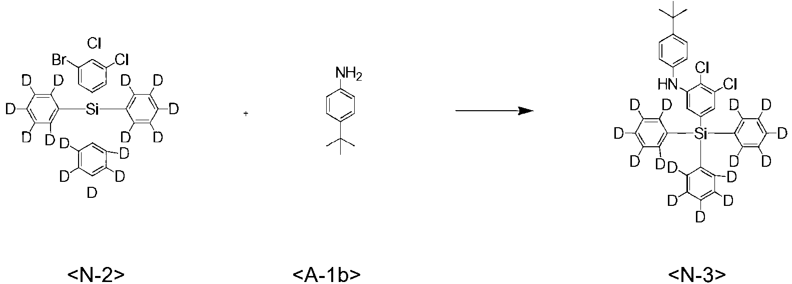

<N-3> was obtained by performing a synthesis in the same manner as in Synthesis Example 1-1, except that <N-2> was used instead of <A-1a>. (Yield 62%)

### Synthesis Example 14-4: Synthesis of N-4

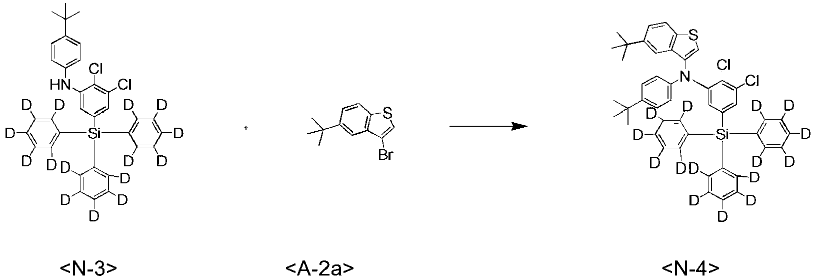

<N-4> was obtained by performing a synthesis in the same manner as in Synthesis Example 1-2, except that <N-3> was used instead of <A-1>. (Yield 87.9%)

### Synthesis Example 14-5: Synthesis of N-5

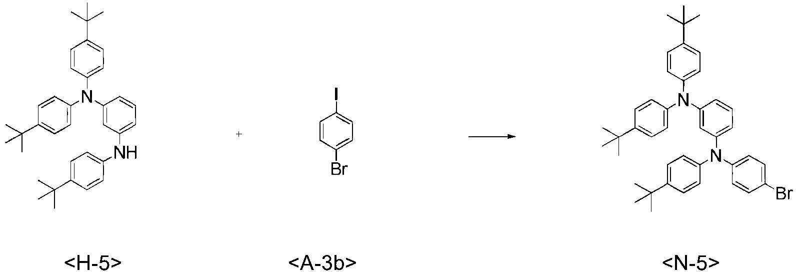

<N-5> was obtained by performing a synthesis in the same manner as in Synthesis Example 1-3, except that <H-5> was used instead of <A-3a>. (Yield 73.7%)

### Synthesis Example 14-6: Synthesis of N-6

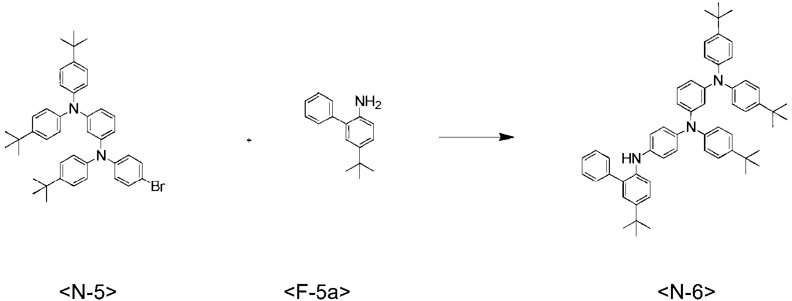

<N-6> was obtained by performing a synthesis in the same manner as in Synthesis Example 1-1, except that <N-5> was used instead of <A-1a>, and <F-5a> was used instead of <A-1b>. (Yield 63.3%)

### Synthesis Example 14-7: Synthesis of N-7

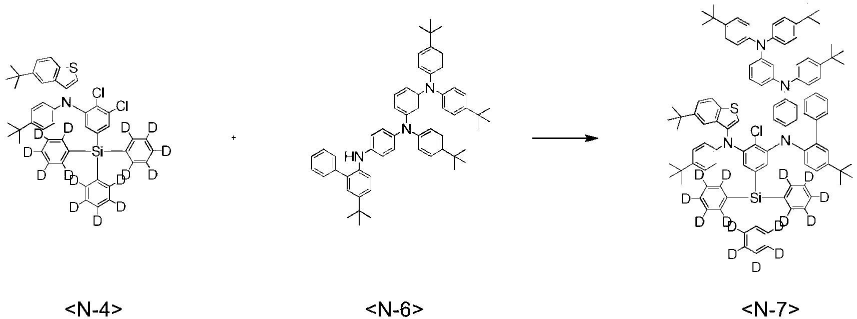

<N-7> was obtained by performing a synthesis in the same manner as in Synthesis Example 1-2, except that <N-4> was used instead of <A-1>, and <N-6> was used instead of <A-2a>. (Yield 86.4%)

### Synthesis Example 14-8: Synthesis of [Compound 162]

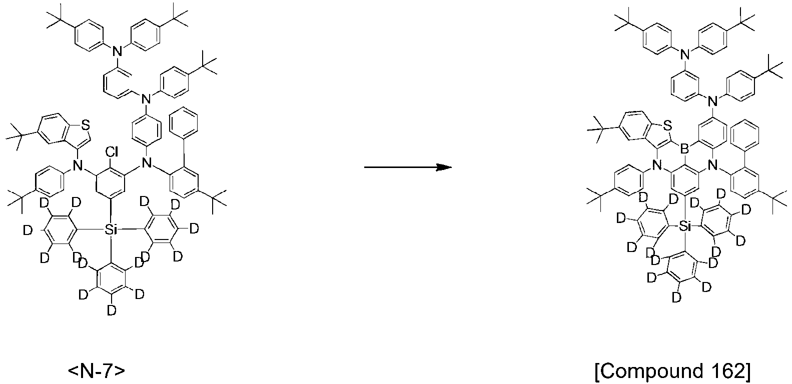

[Compound 162] was obtained by performing a synthesis in the same manner as in Synthesis Example 1-8, except that <N-7> was used instead of <A-7>. (Yield 14.1%)
MS (MALDI-TOF): m/z 1495.89 [M⁺]

### Synthesis Example 15: Synthesis of [Compound 163]

### Synthesis Example 15-1: Synthesis of O-1

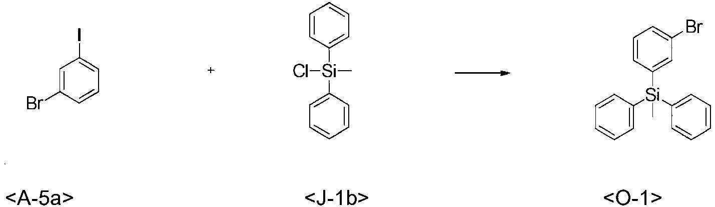

<O-1> was obtained by performing a synthesis in the same manner as in Synthesis Example 10-1, except that <A-5a> was used instead of <J-1a>. (Yield 71%)

### Synthesis Example 15-2: Synthesis of O-2

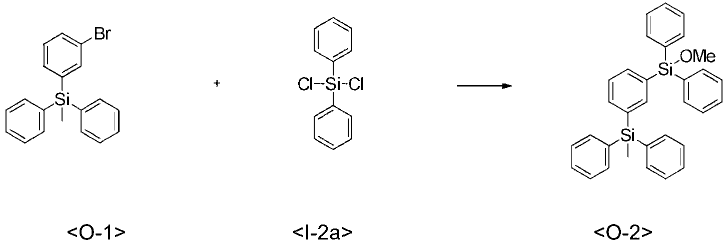

<O-2> was obtained by performing a synthesis in the same manner as in Synthesis Example 9-2, except that <O-1> was used instead of <I-1>. (Yield 72.1%)

### Synthesis Example 15-3: Synthesis of O-3

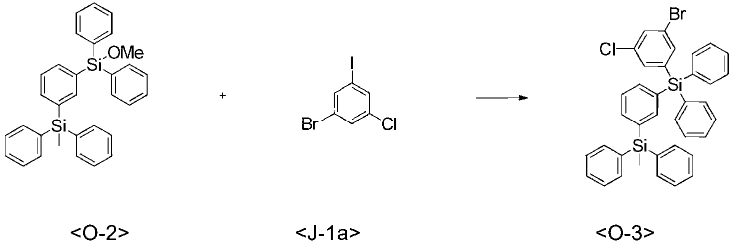

<O-3> was obtained by performing a synthesis in the same manner as in Synthesis Example 9-1, except that <O-2> was used instead of <I-1a>, and <J-1a> was used instead of <A-5a>. (Yield 49.1%)

### Synthesis Example 15-4: Synthesis of O-4

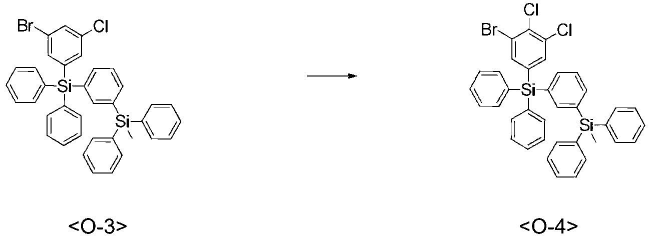

<O-4> was obtained by performing a synthesis in the same manner as in Synthesis Example 10-2, except that <O-3> was used instead of <J-1>. (Yield 72%)

### Synthesis Example 15-5: Synthesis of O-5

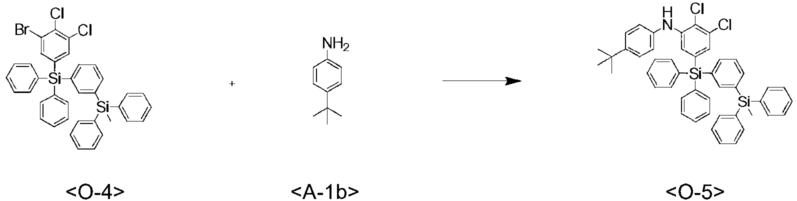

<O-5> was obtained by performing a synthesis in the same manner as in Synthesis Example 1-1, except that <O-4> was used instead of <A-1a>. (Yield 60.8%)

### Synthesis Example 15-6: Synthesis of O-6

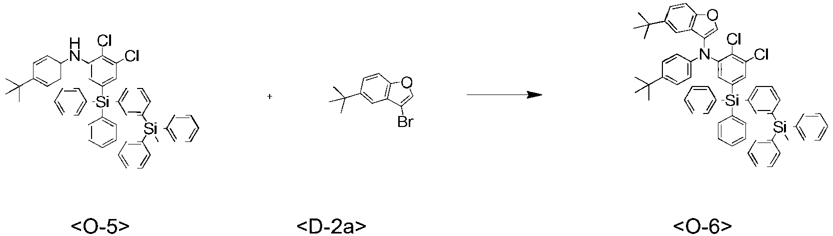

<O-6> was obtained by performing a synthesis in the same manner as in Synthesis Example 1-2, except that <O-5> was used instead of <A-1>, and <D-2a> was used instead of <A-2a>. (Yield 87.1%)

### Synthesis Example 15-7: Synthesis of O-7

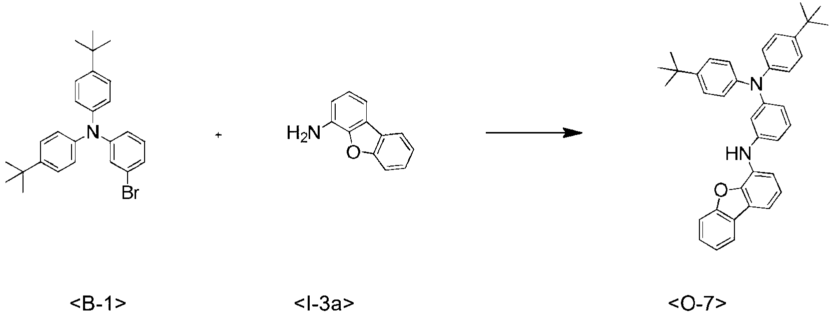

<O-7> was obtained by performing a synthesis in the same manner as in Synthesis Example 1-1, except that <B-1> was used instead of <A-1a>, and <I-3a> was used instead of <A-1b>. (Yield 61.1%)

### Synthesis Example 15-8: Synthesis of O-8

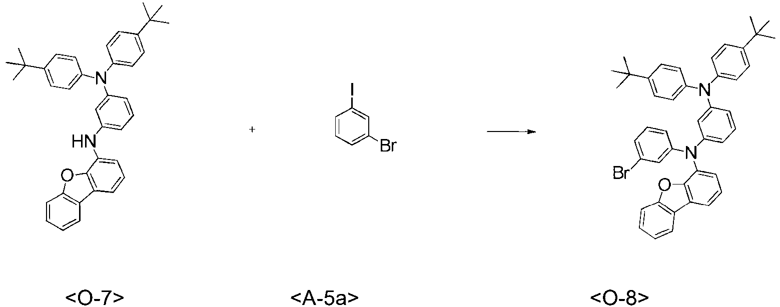

<O-8> was obtained by performing a synthesis in the same manner as in Synthesis Example 1-3, except that <O-7> was used instead of <A-3a>, and <A-5a> was used instead of <A-3b>. (Yield 71.1%)

### Synthesis Example 15-9: Synthesis of O-9

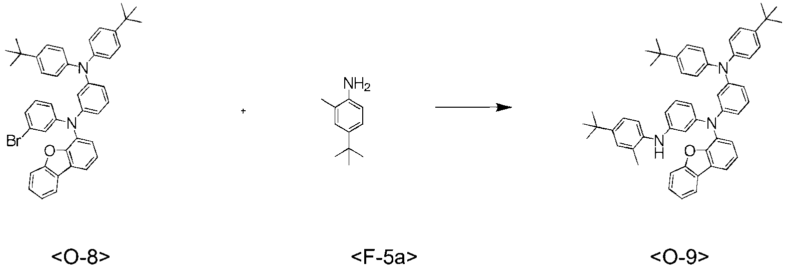

<O-9> was obtained by performing a synthesis in the same manner as in Synthesis Example 1-1, except that <O-8> was used instead of <A-1a>, and <F-5a> was used instead of <A-1b>. (Yield 63%)

### Synthesis Example 15-10: Synthesis of O-10

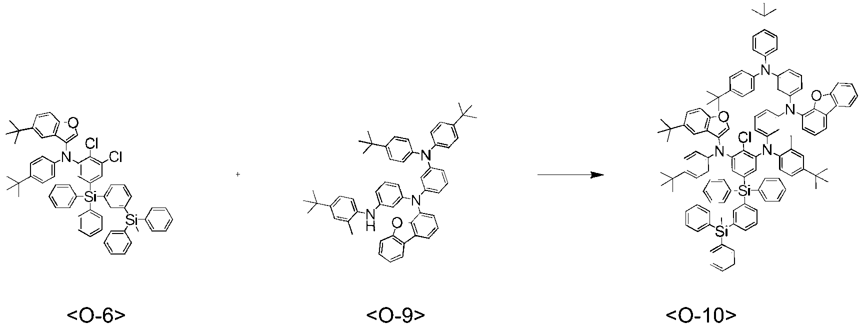

<O-10> was obtained by performing a synthesis in the same manner as in Synthesis Example 1-2, except that <O-9> was used instead of <A-1>, and <O-6> was used instead of <A-2a>. (Yield 87.4%)

### Synthesis Example 15-11: Synthesis of [Compound 163]

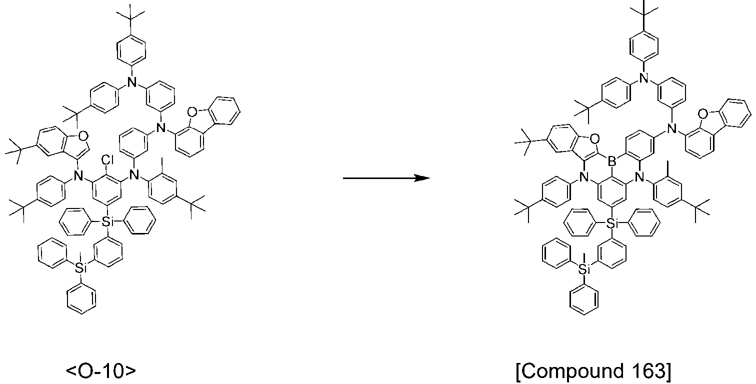

[Compound 163] was obtained by performing a synthesis in the same manner as in Synthesis Example 1-8, except that <O-10> was used instead of <A-7>. (Yield 11.1%)
MS (MALDI-TOF): m/z 1632.82 [M⁺]

### Examples 1 to 15: Manufacture of Organic Light-Emitting Device

ITO glass was patterned to have a light-emitting area of 2 mm×2 mm, and then cleaned. The ITO glass was installed in a vacuum chamber, and the base pressure was set at 1x10⁻⁷ torr. Then, on the ITO, an electron acceptor having the following Structural Formula [Acceptor-1] and [Chemical Formula F] were deposited (100 Å) at a deposition ratio of 2:98 ([Acceptor-1]:[Chemical Formula F]) as a hole injection layer. [Chemical Formula F] was deposited (550 Å) as a hole transport layer, and then [Chemical Formula G] was deposited (50 Å) as an electron blocking layer. As a light-emitting layer, a host [BH-1] and the compound (2 wt%) of the present invention described below were mixed and deposited (200 Å). After that, [Chemical Formula H] was deposited (50 Å) as a hole blocking layer, [Chemical Formula E-1] and [Chemical Formula E-2] were deposited (250 Å) at a ratio of 1:1 as an electron transport layer, [Chemical Formula E-2] was deposited (10 Å) as an electron injection layer, and Al was deposited (1000 Å) in this order to manufacture an organic light-emitting device. Light-emitting characteristics of the organic light-emitting devices were measured at 0.4 mA.

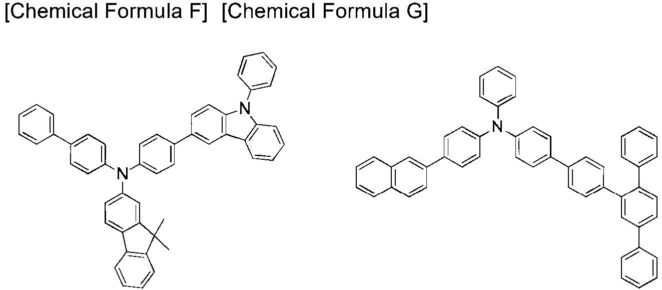

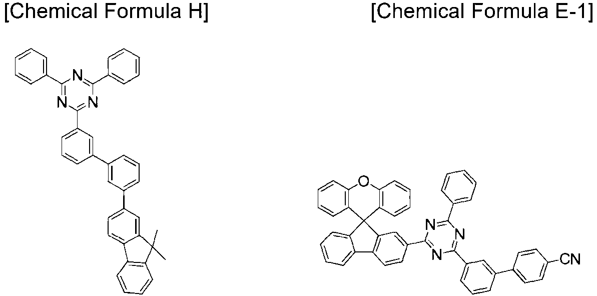

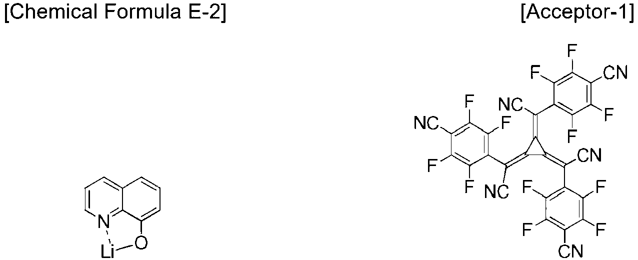

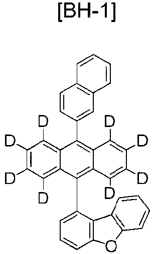

### Comparative Examples 1 and 2

Organic light-emitting devices were manufactured in the same manner as in the Examples, except that [RD-1] and [RD-2] were respectively used instead of the compounds used in the Examples, and light-emitting characteristics of the organic light-emitting device were measured at 0.4 mA. The structures of [RD-1] and [RD-2] are as follows.

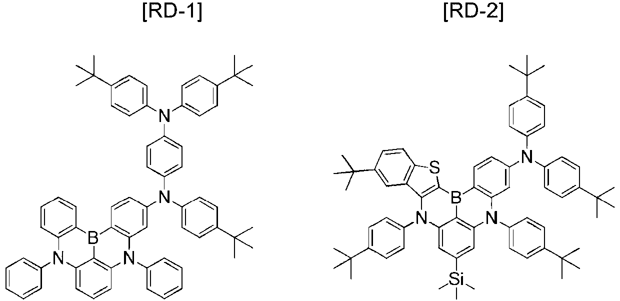

For each of the organic light-emitting devices manufactured in Examples 1 to 15 and Comparative Examples 1 and 2, external quantum efficiency and lifespan were measured, and the results are shown in the following [Table 1].

**Table 1**

| Classification | Dopant | External Quantum Efficiency (EQE, %) | Lifespan (T97, hr) |
|---|---|---|---|
| Example 1 | Compound 1 | 9.4 | 200 |
| Example 2 | Compound 16 | 9.3 | 192 |
| Example 3 | Compound 20 | 9.6 | 212 |
| Example 4 | Compound 48 | 9.8 | 180 |
| Example 5 | Compound 49 | 9.3 | 190 |
| Example 6 | Compound 55 | 9.1 | 173 |
| Example 7 | Compound 67 | 8.8 | 180 |
| Example 8 | Compound 98 | 9.8 | 217 |
| Example 9 | Compound 114 | 9.6 | 195 |
| Example 10 | Compound 129 | 10.1 | 200 |
| Example 11 | Compound 140 | 8.6 | 165 |
| Example 12 | Compound 154 | 9.8 | 172 |
| Example 13 | Compound 158 | 10.1 | 205 |
| Example 14 | Compound 162 | 10.5 | 228 |
| Example 15 | Compound 163 | 9.8 | 180 |
| Comparative Example 1 | RD-1 | 7.6 | 110 |
| Comparative Example 2 | RD-2 | 7.1 | 55 |

As shown in [Table 1], the device employing the compound according to the present invention as a dopant compound of the light-emitting layer in the organic light-emitting device may realize a high-efficiency and long-lifespan organic light-emitting device having excellent quantum efficiency and lifespan characteristics compared with the devices (Comparative Examples 1 and 2) employing the compounds having structures contrasting with the characteristic structure of the compound according to the present invention.

## Claims

1. A polycyclic compound represented by the following [Chemical Formula 1] or [Chemical Formula 2]: 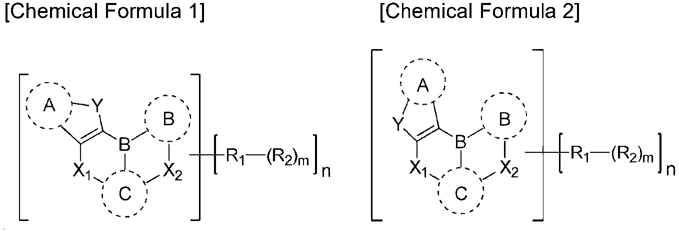
wherein, in [Chemical Formula 1] and [Chemical Formula 2], rings A to C are the same as or different from each other, and each independently any one selected from a substituted or unsubstituted C₆-C₅₀ aromatic hydrocarbon ring, a substituted or unsubstituted C₃-C₅₀ aliphatic hydrocarbon ring, a substituted or unsubstituted C₂-C₅₀ aromatic heteroring, a substituted or unsubstituted C₂-C₅₀ aliphatic heteroring, and a substituted or unsubstituted ring in which a C₃-C₃₀ aliphatic ring and a C₃-C₃₀ aromatic ring are fused;
X₁ and X₂ are the same as or different from each other, and each independently any one selected from O, S, Se, NR₃, CR₄R₅, SiR₆R₇ and GeR₈R₉;
Y is any one selected from O, S, NR₃, CR₄R₅, SiR₆R₇ and GeR₈R₉;
R₁ and R₂ are the same as or different from each other, and each independently any one selected from a substituted or unsubstituted C₁-C₃₀ arylamine group, a substituted or unsubstituted C₁-C₃₀ arylsilyl group, and a substituted or unsubstituted C₁-C₃₀ arylgermanium group;
R₃ to R₉ are the same as or different from each other, and each independently any one selected from hydrogen, deuterium, tritium, a substituted or unsubstituted C₁-C₃₀ alkyl group, a substituted or unsubstituted C₁-C₃₀ halogenated alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted cyclic group in which a C₃-C₃₀ aliphatic ring and a C₅-C₃₀ aromatic ring are fused, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group;
m is an integer of 1 to 3, and when m is an integer of 2 or greater, the respective R₂s are the same as or different from each other;
n is an integer of 1 to 3, and when n is an integer of 2 or greater, the respective R₁s and R₂s in the parentheses are the same as or different from each other; and
the 'substituted' in the 'substituted or unsubstituted' in [Chemical Formula 1] and [Chemical Formula 2] means being substituted with one, or two or more substituents selected from the group consisting of deuterium, tritium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a cyclic group in which a C₃-C₂₄ aliphatic ring and a C₅-C₂₄ aromatic ring are fused, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, or being substituted with a substituent in which two or more of the above-mentioned substituents are linked, hydrogen atoms in the substituents are optionally substituted with one or more deuterium or tritium atoms, and two or more adjacent substituents are optionally linked to each other to further form an alicyclic or aromatic monocyclic or polycyclic ring.

2. The polycyclic compound of claim 1, wherein Y in [Chemical Formula 1] or [Chemical Formula 2] is any one each selected from O and S.

3. The polycyclic compound of claim 1, wherein X₁ and X₂ in [Chemical Formula 1] or [Chemical Formula 2] are the same as or different from each other, and each independently NR₃.

4. The polycyclic compound of claim 3, wherein, when R₃ is a substituted or unsubstituted C₆-C₅₀ aryl group, the term 'substituted' excludes a C₂-C₃₀ heteroaryl group including N.

5. The polycyclic compound of claim 1, wherein the rings A to C in [Chemical Formula 1] or [Chemical Formula 2] are the same as or different from each other, and each independently a substituted or unsubstituted C₆-C₂₀ aromatic hydrocarbon ring.

6. The polycyclic compound of claim 1, wherein, in [Chemical Formula 1] or [Chemical Formula 2], n is 1, and R₁ is a substituted or unsubstituted C₁-C₃₀ arylamine group.

7. The polycyclic compound of claim 1, wherein, in [Chemical Formula 1] or [Chemical Formula 2], n is 1, and R₁ is a substituted or unsubstituted C₁-C₃₀ arylsilyl group.

8. The polycyclic compound of claim 1, wherein [Chemical Formula 1] or [Chemical Formula 2] is any one selected from compounds represented by the following chemical formulae:

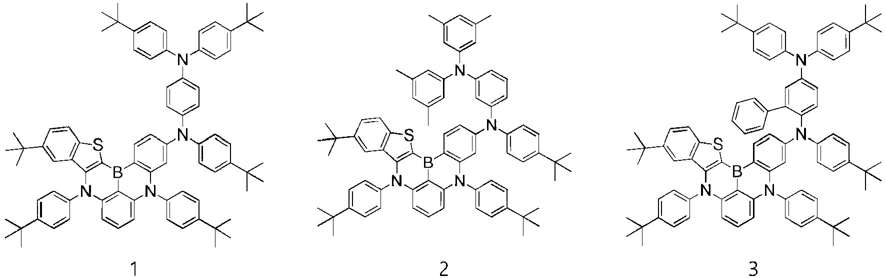

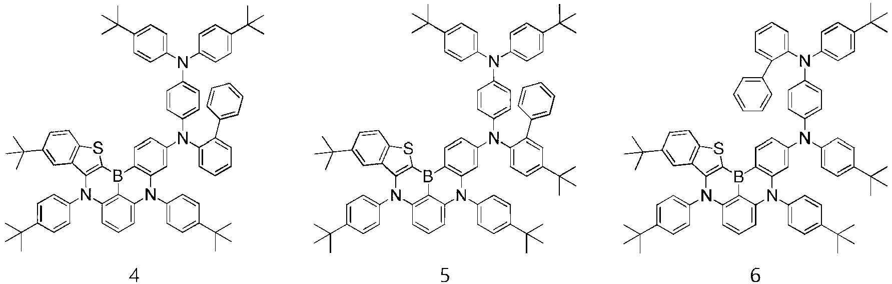

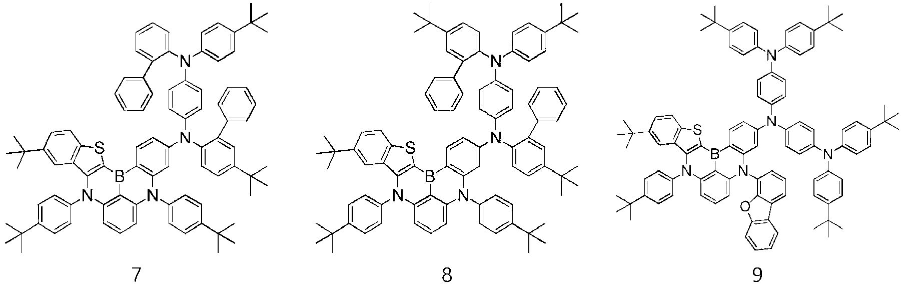

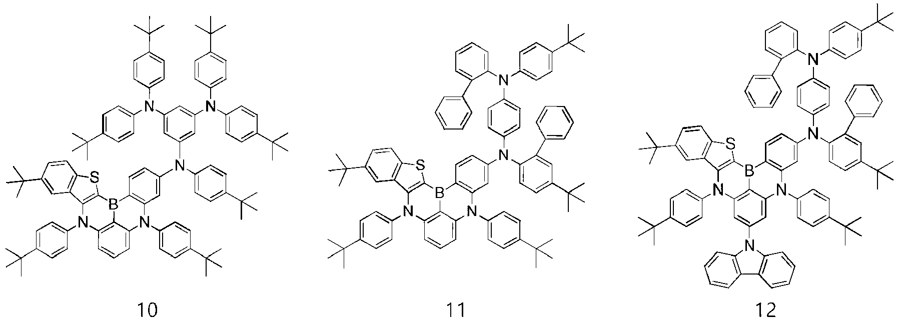

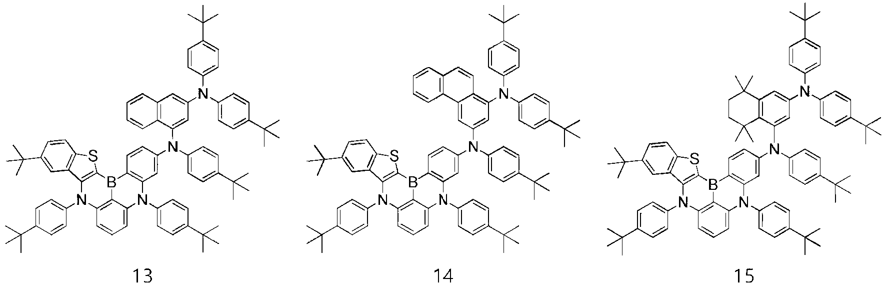

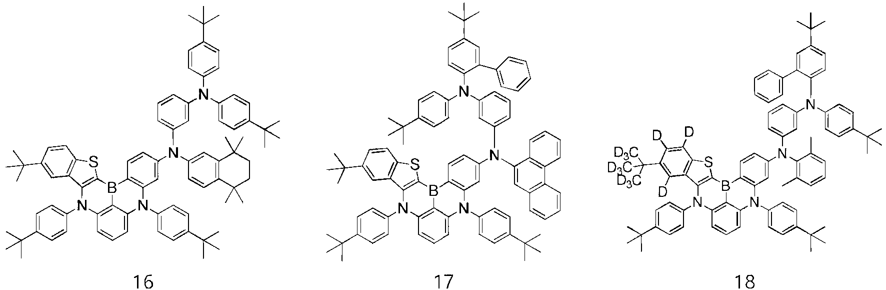

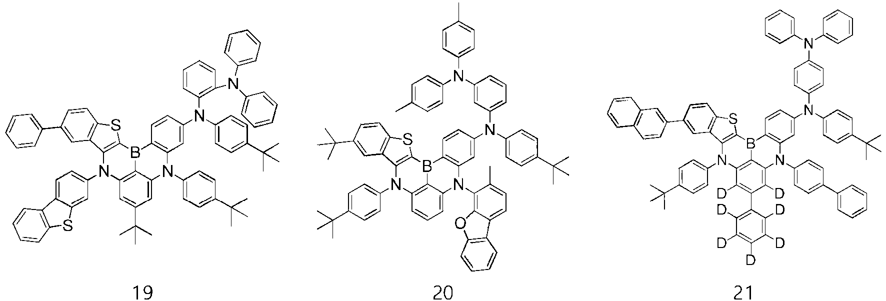

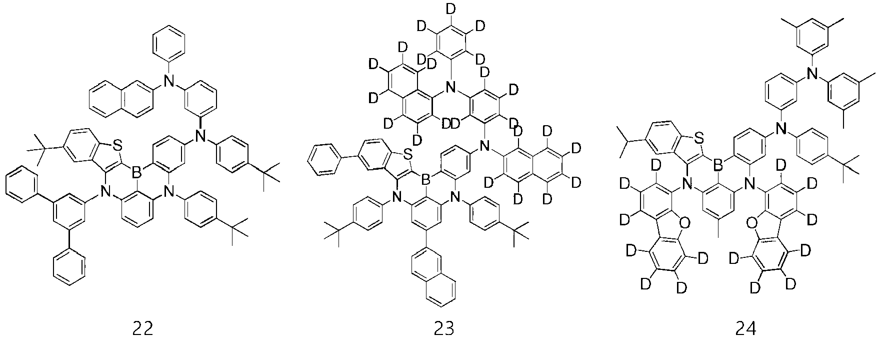

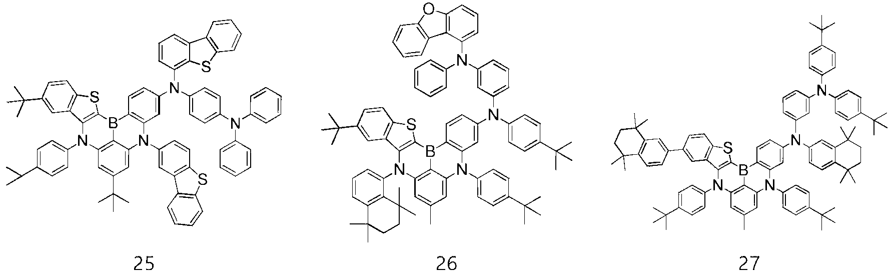

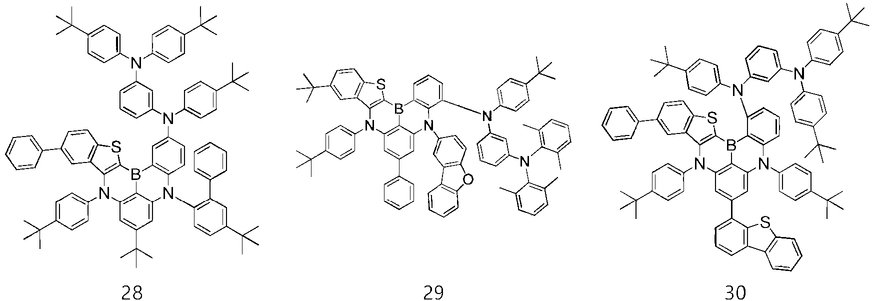

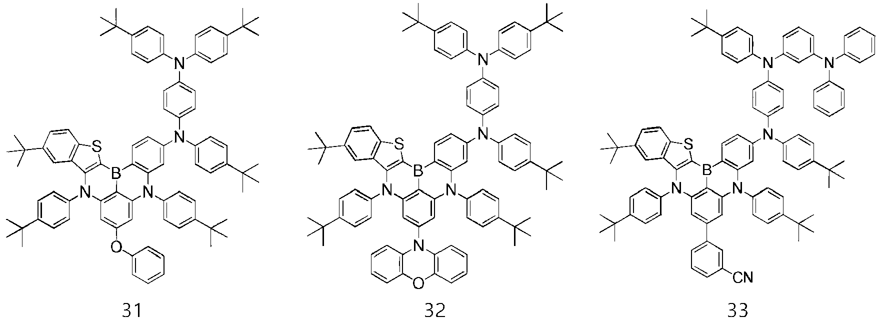

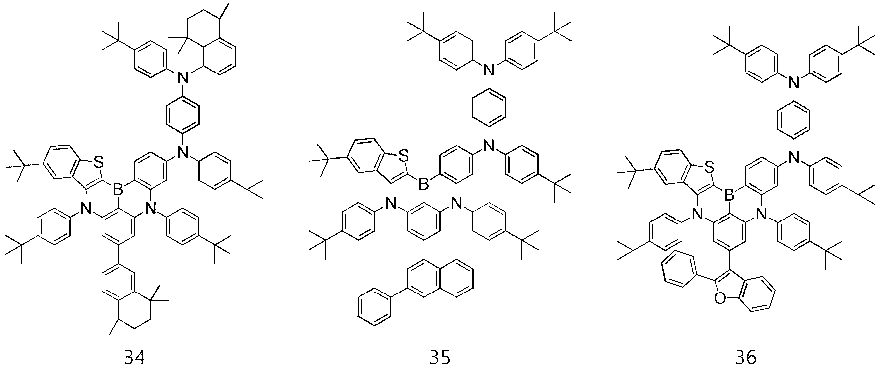

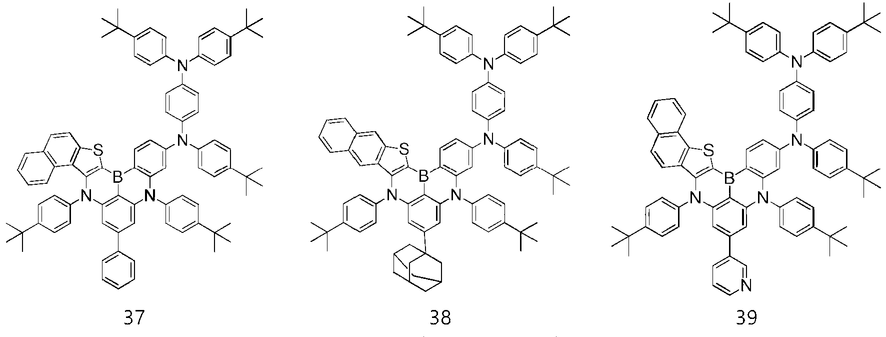

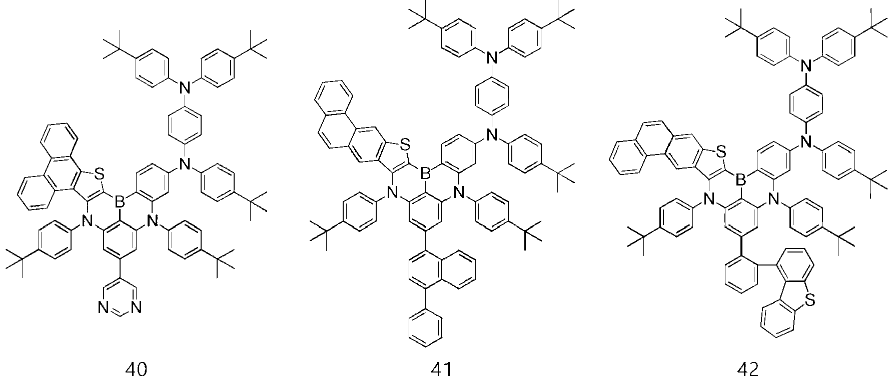

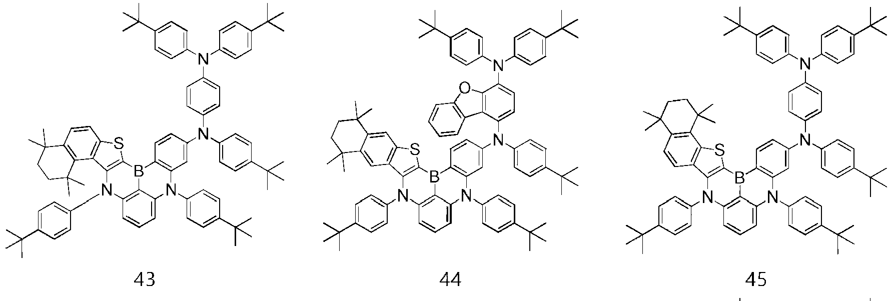

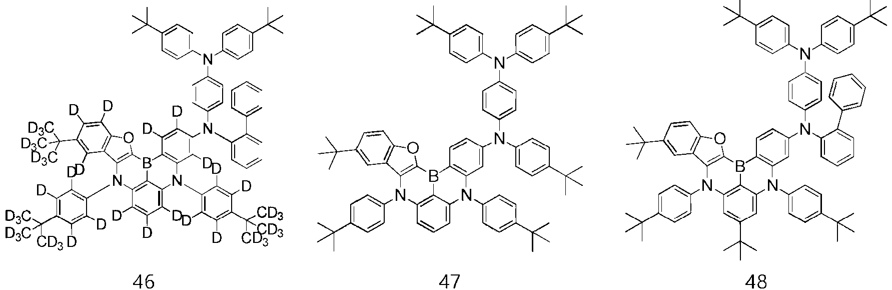

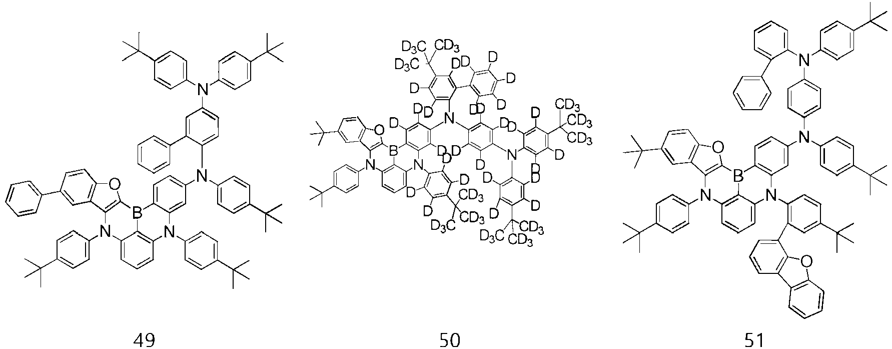

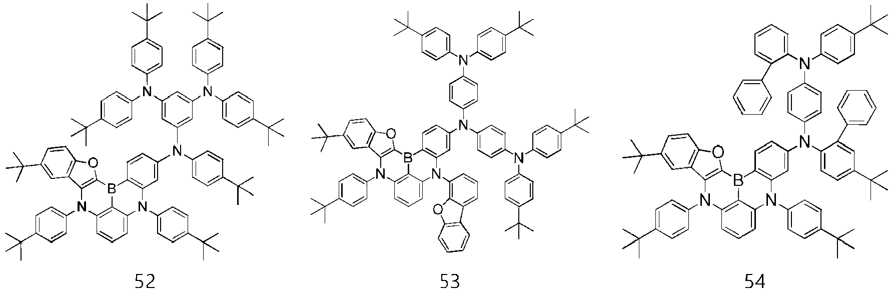

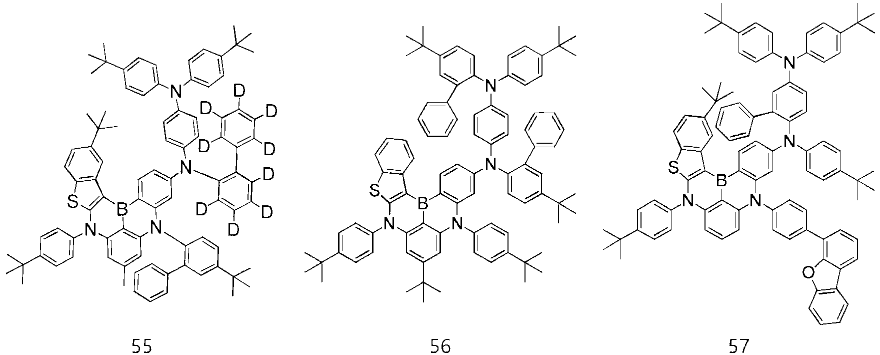

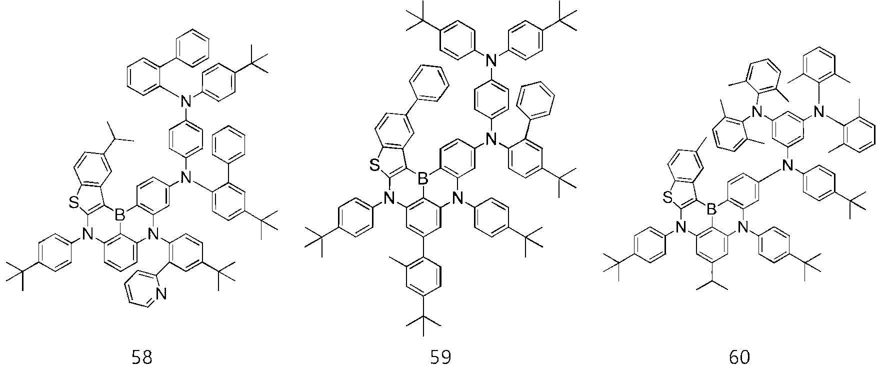

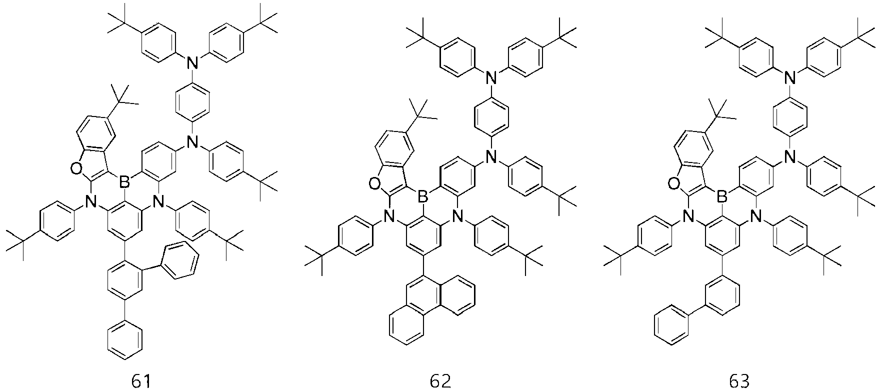

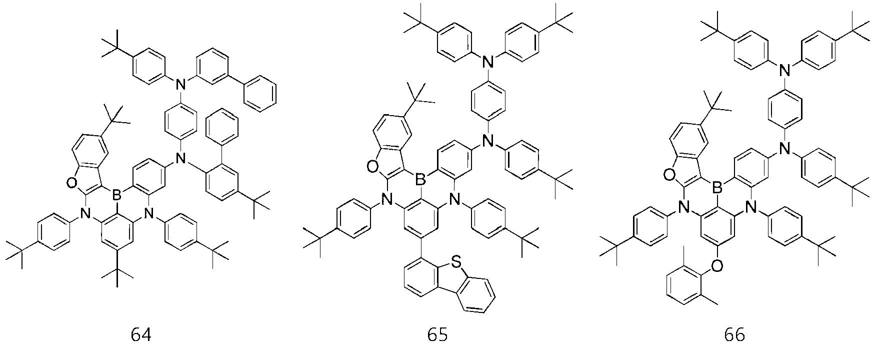

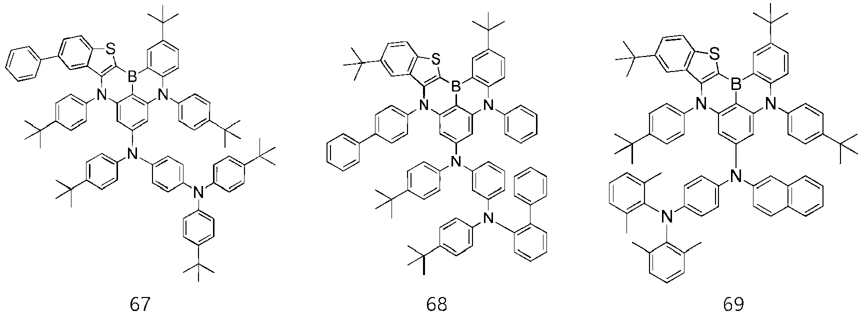

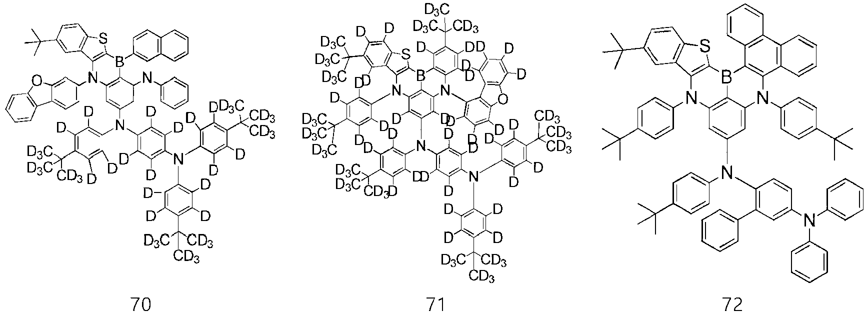

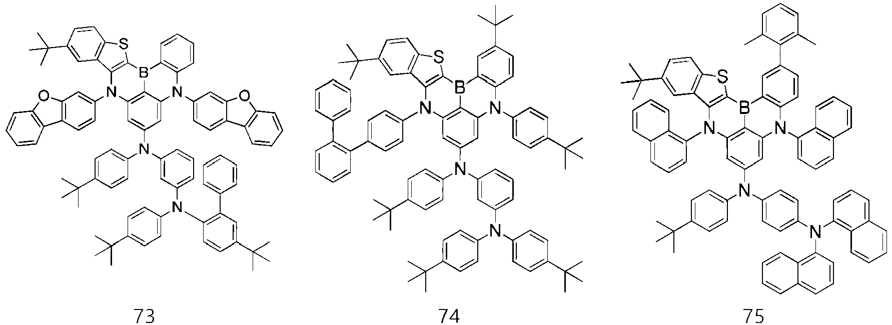

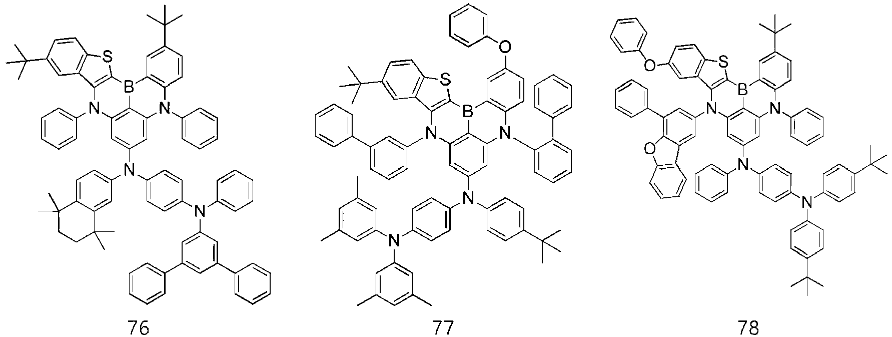

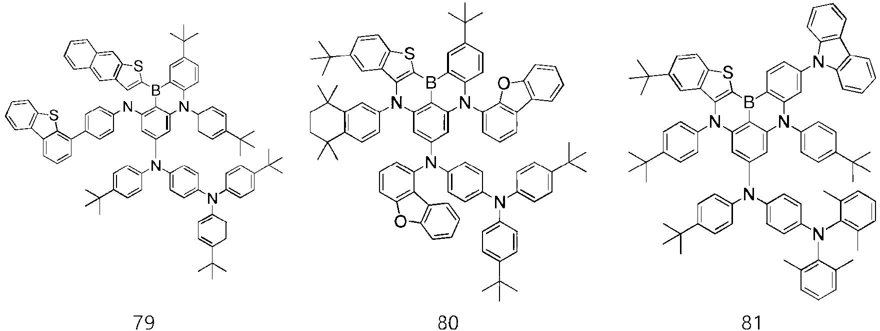

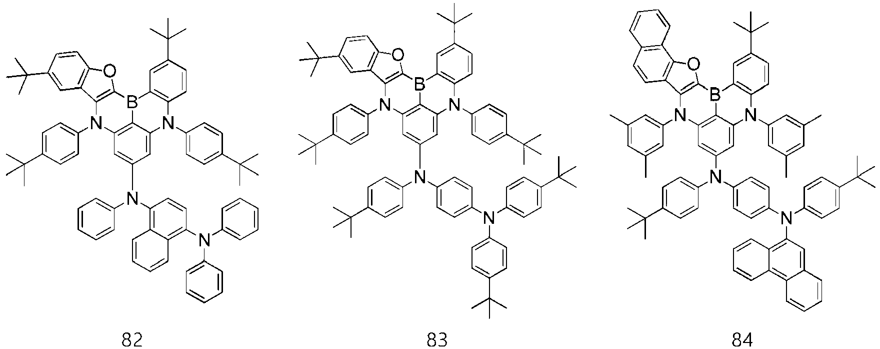

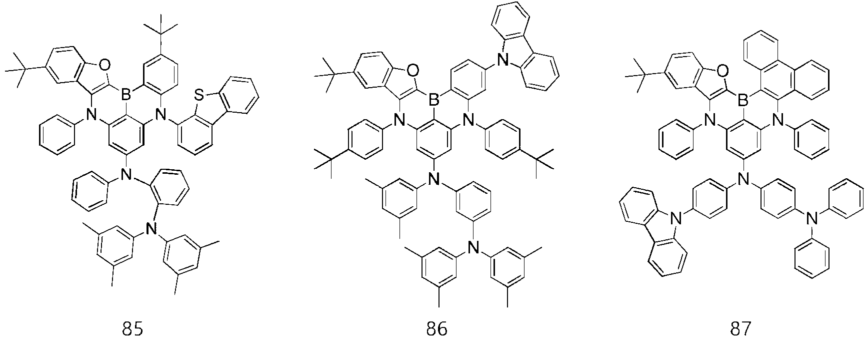

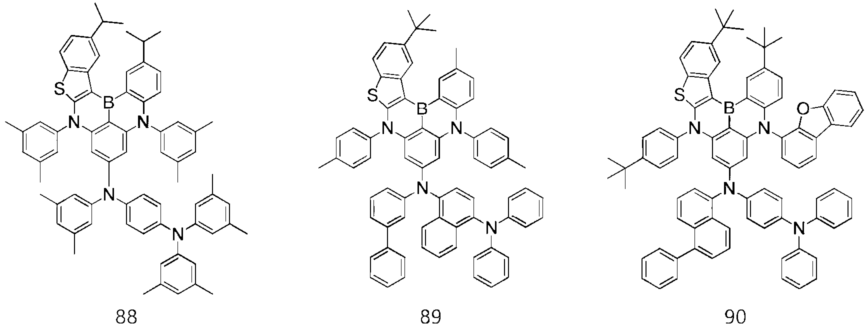

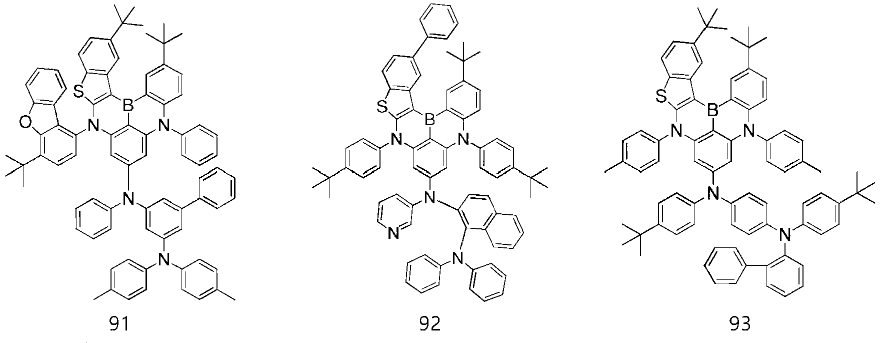

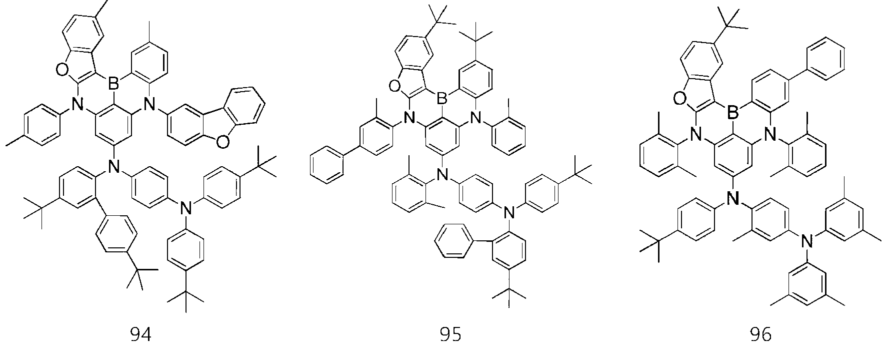

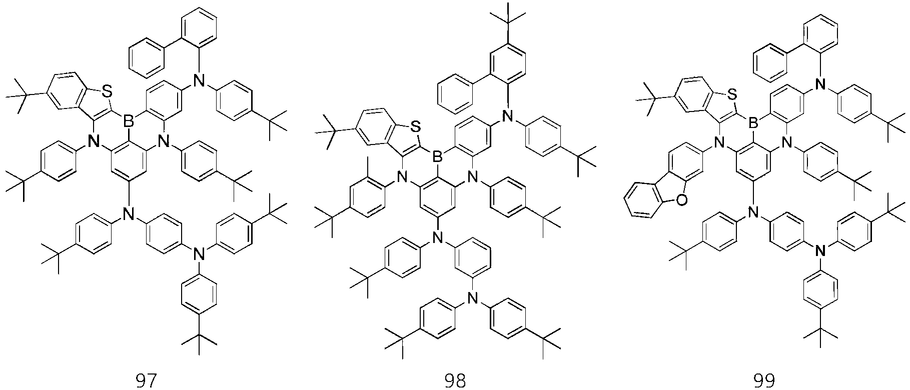

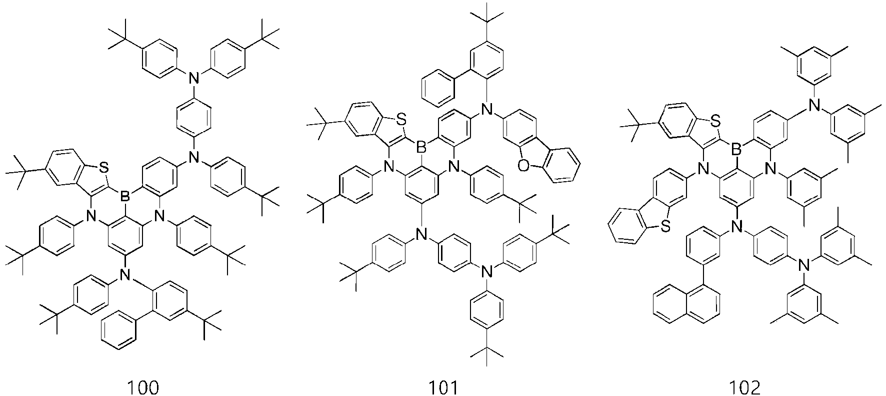

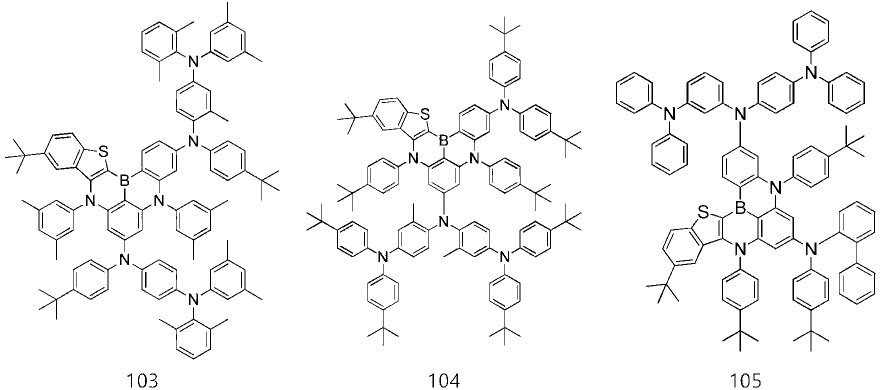

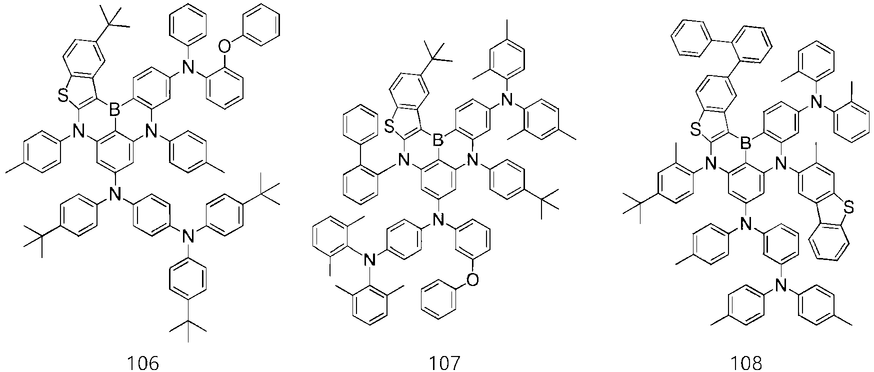

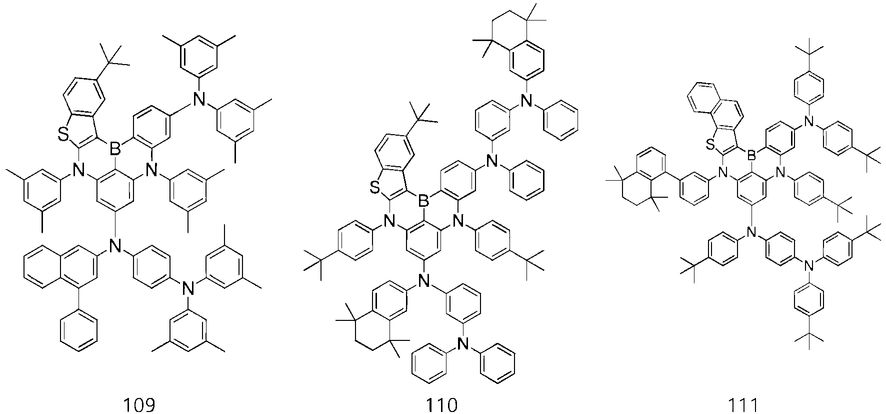

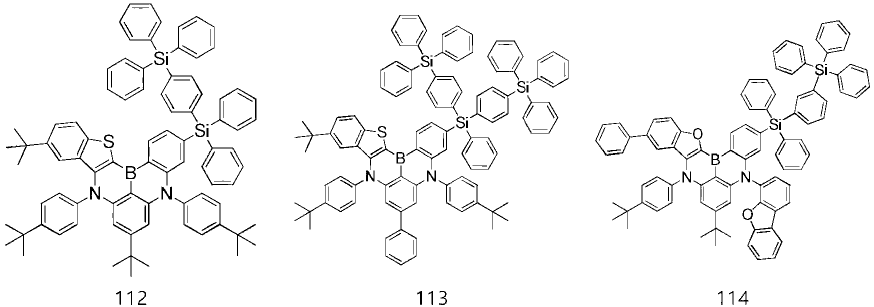

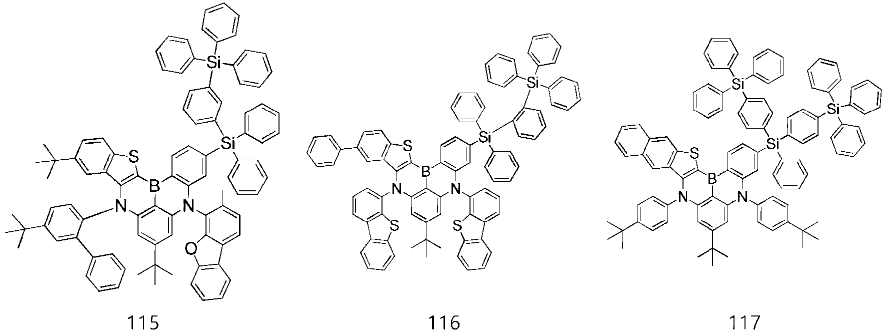

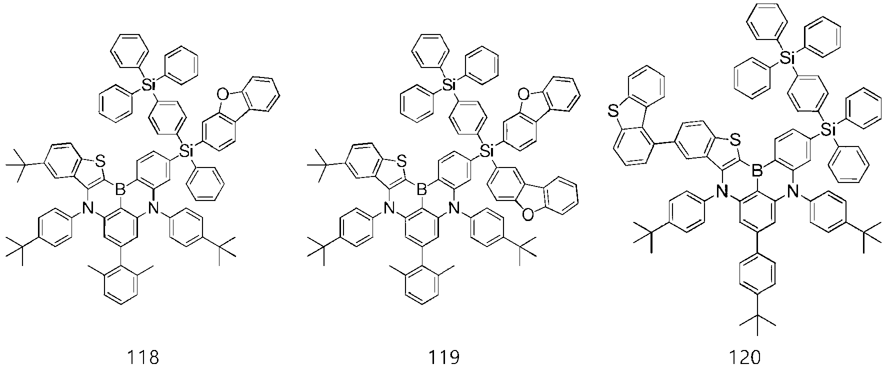

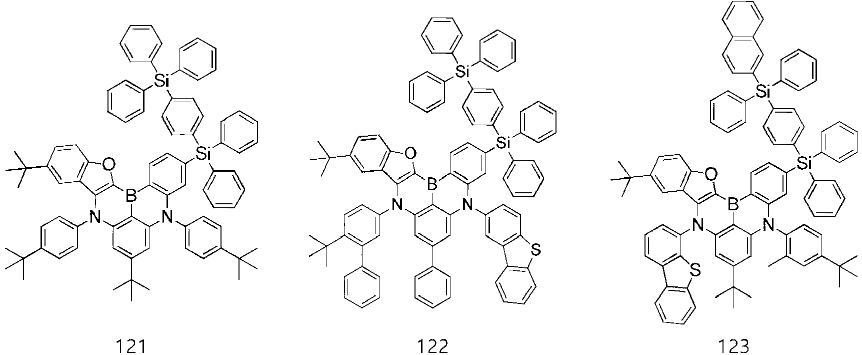

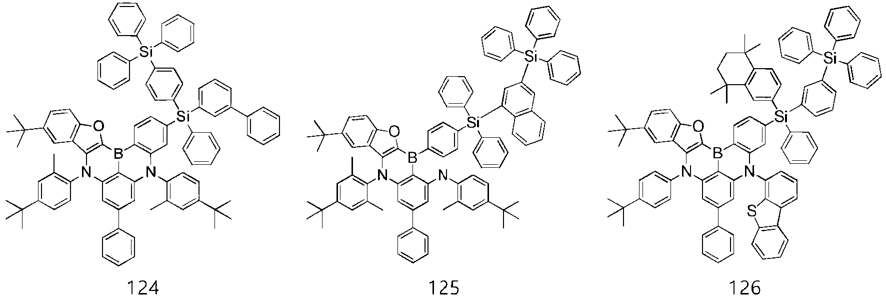

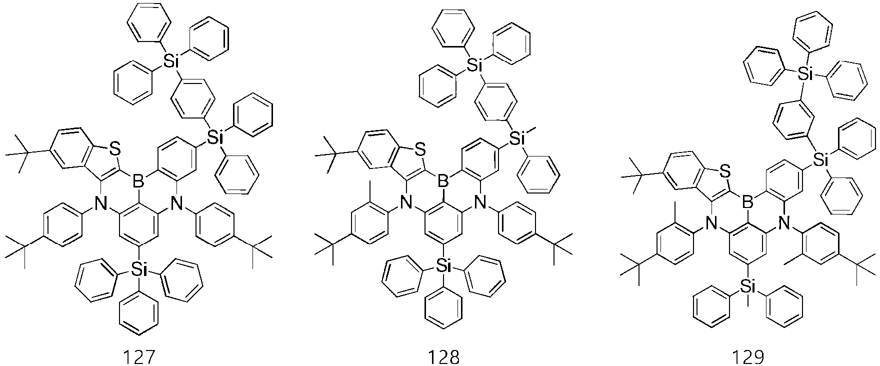

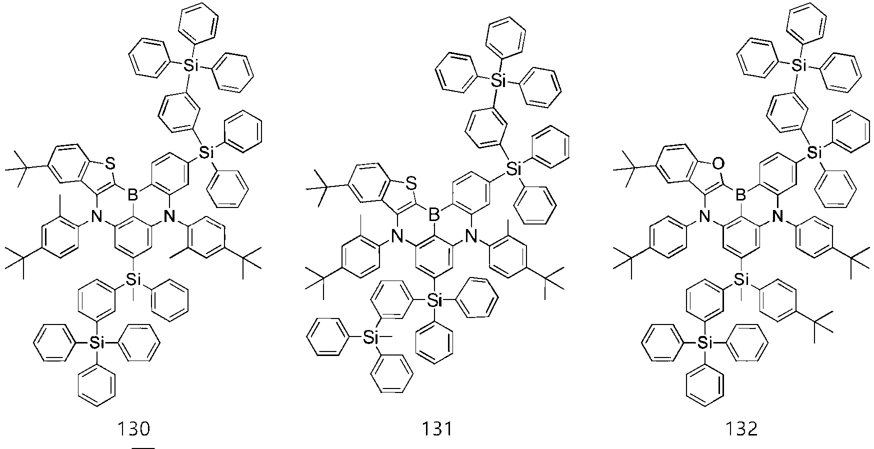

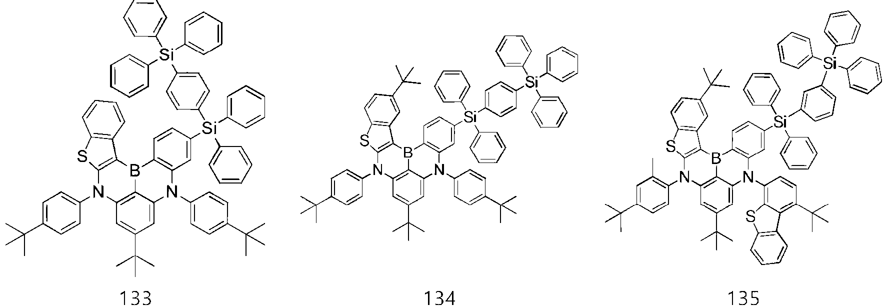

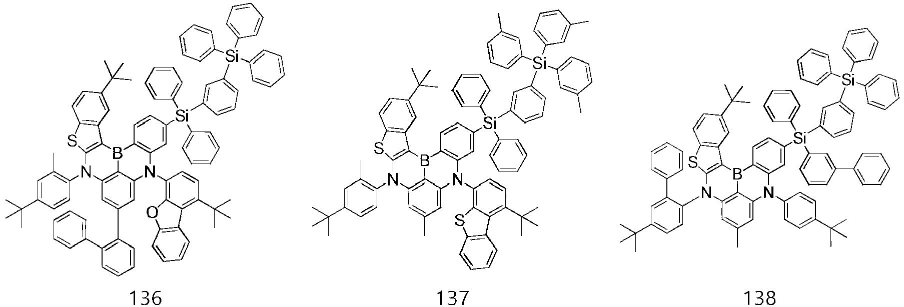

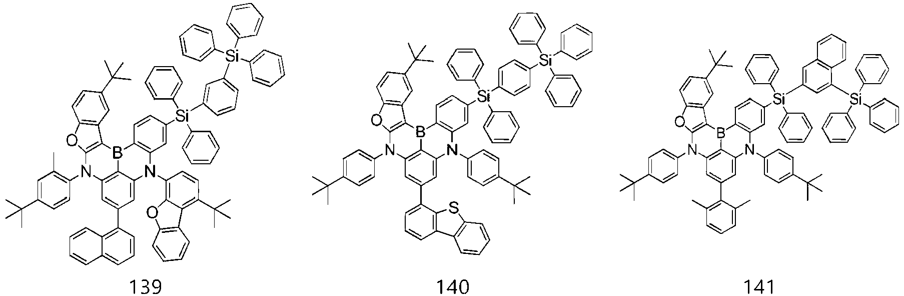

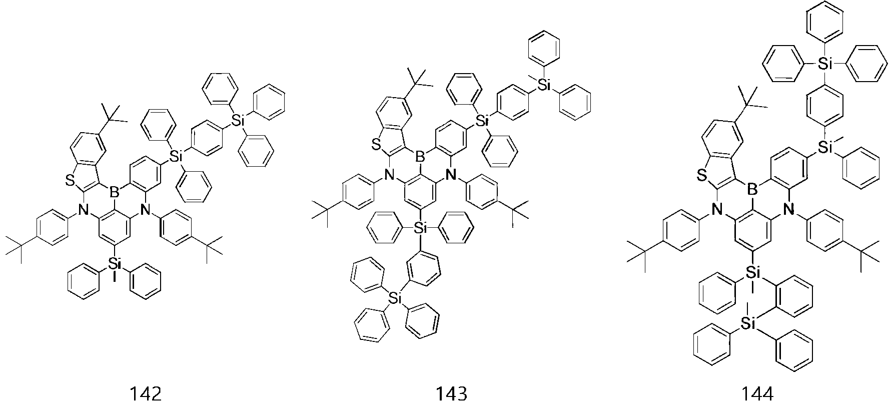

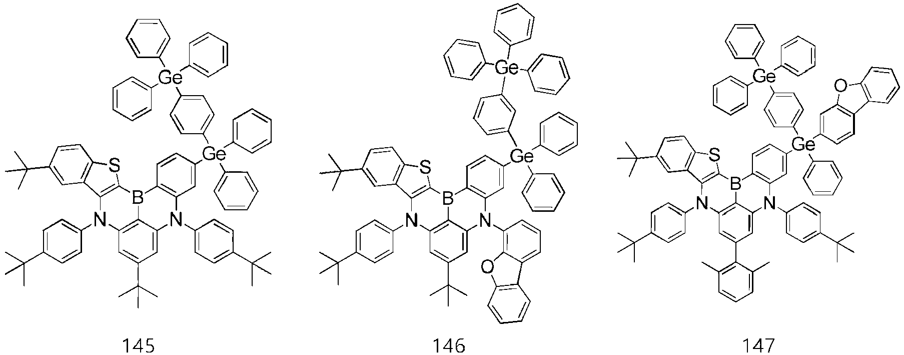

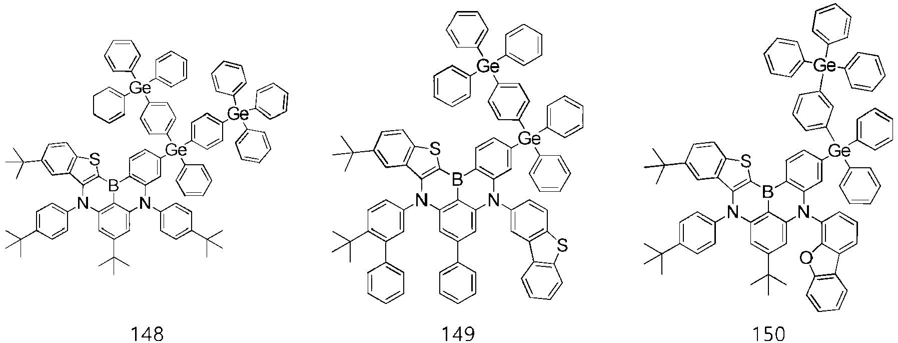

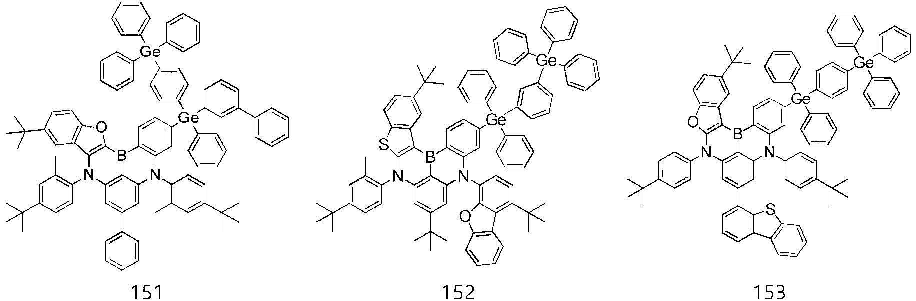

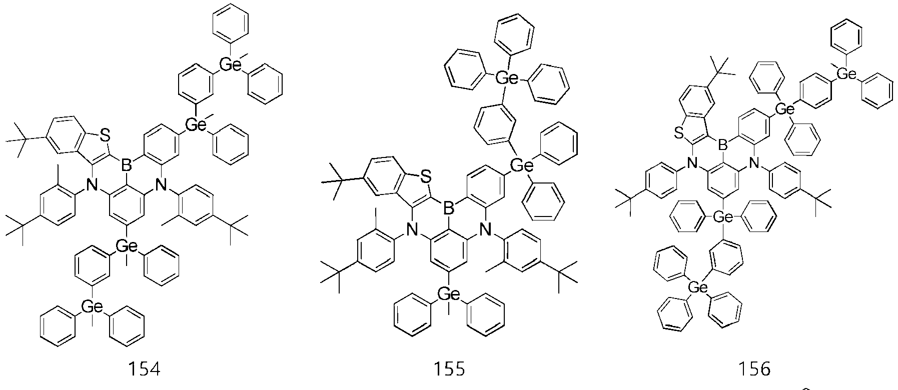

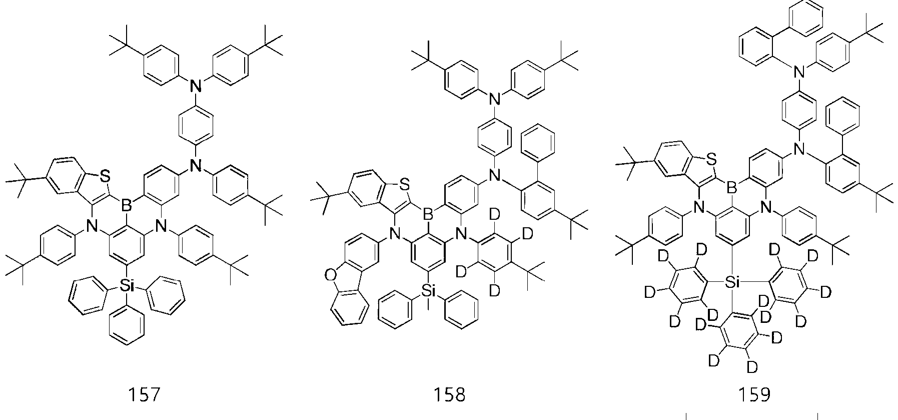

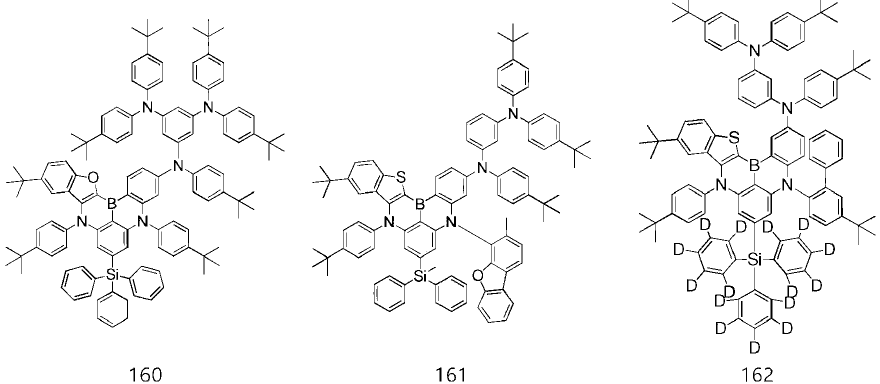

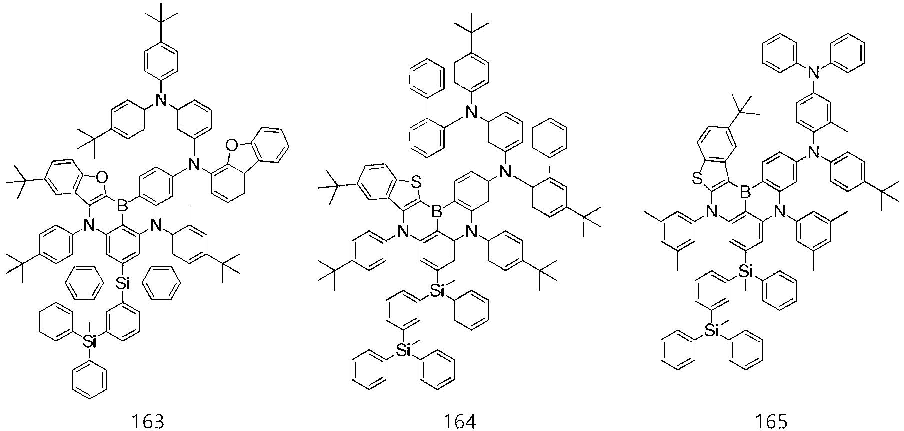

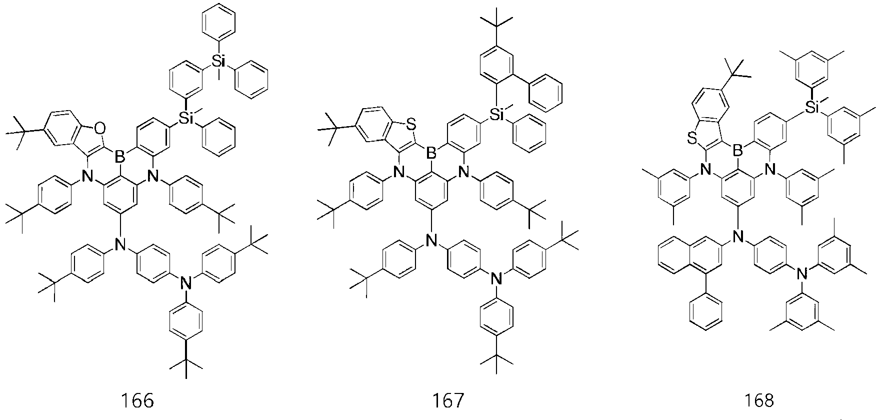

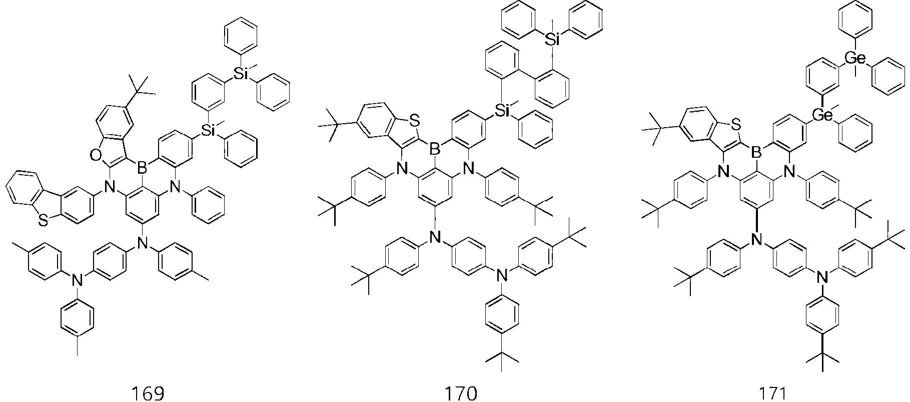

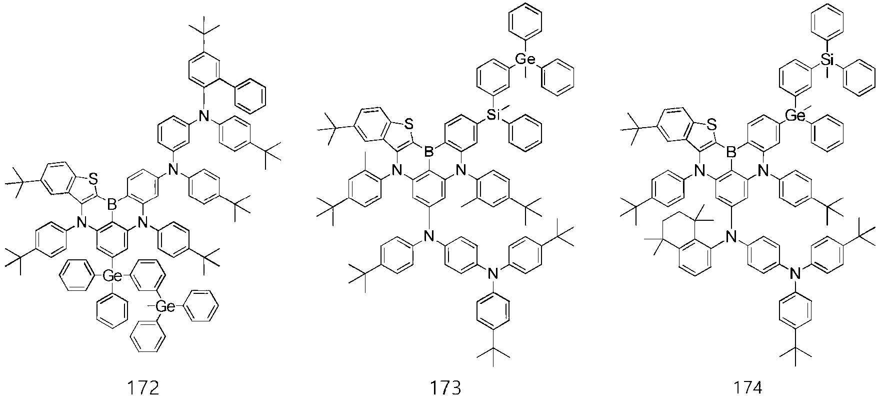

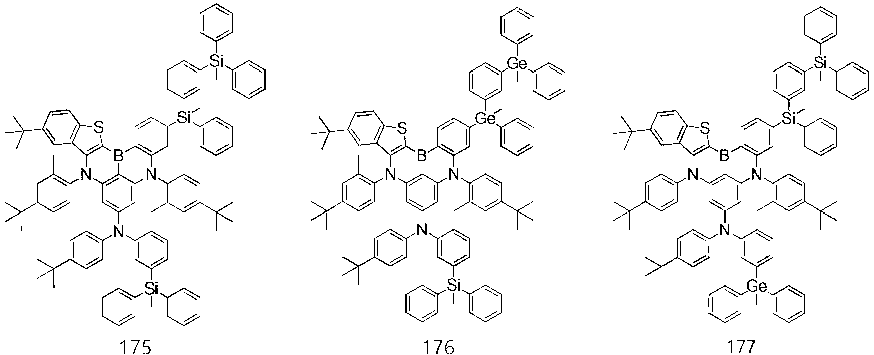

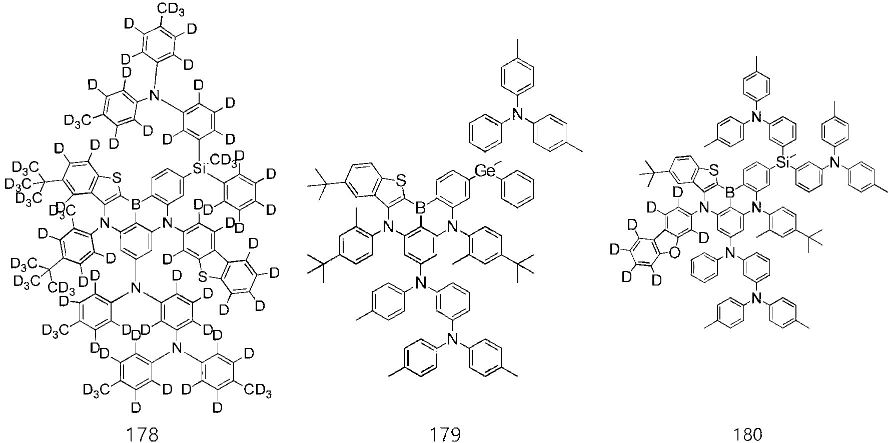

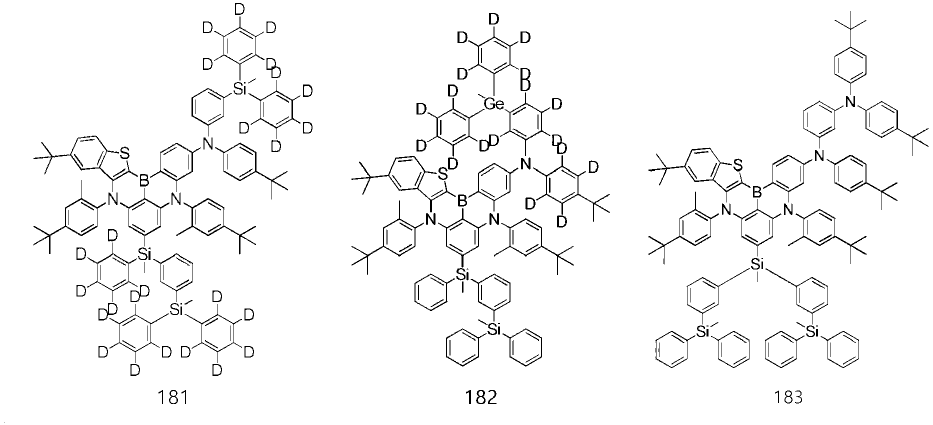

9. An organic light-emitting device comprising:
a first electrode;
a second electrode provided opposite to the first electrode; and
an organic layer interposed between the first electrode and the second electrode,
wherein the organic layer includes a hole injection layer, a hole transport layer, an electron blocking layer, a functional layer having both hole injection and hole transport functions, a light-emitting layer, an electron transport layer, an electron injection layer, a hole blocking layer, a functional layer having both electron injection and electron transport functions, and
the light-emitting layer includes at least one of polycyclic compounds represented by the following [Chemical Formula 1] or [Chemical Formula 2]: 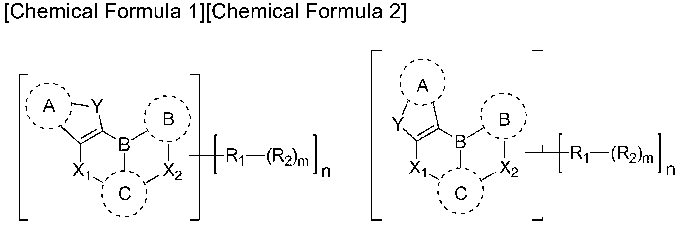
in [Chemical Formula 1] and [Chemical Formula 2],
rings A to C are the same as or different from each other, and each independently any one selected from a substituted or unsubstituted C₆-C₅₀ aromatic hydrocarbon ring, a substituted or unsubstituted C₃-C₅₀ aliphatic hydrocarbon ring, a substituted or unsubstituted C₂-C₅₀ aromatic heteroring, a substituted or unsubstituted C₂-C₅₀ aliphatic heteroring, and a substituted or unsubstituted ring in which a C₃-C₃₀ aliphatic ring and a C₃-C₃₀ aromatic ring are fused;
X₁ and X₂ are the same as or different from each other, and each independently any one selected from O, S, Se, NR₃, CR₄R₅, SiR₆R₇ and GeR₈R₉;
Y is any one selected from O, S, NR₃, CR₄R₅, SiR₆R₇ and GeR₈R₉;
R₁ and R₂ are the same as or different from each other, and each independently any one selected from a substituted or unsubstituted C₁-C₃₀ arylamine group, a substituted or unsubstituted C₁-C₃₀ arylsilyl group, and a substituted or unsubstituted C₁-C₃₀ arylgermanium group;
R₃ to R₉ are the same as or different from each other, and each independently any one selected from hydrogen, deuterium, tritium, a substituted or unsubstituted C₁-C₃₀ alkyl group, a substituted or unsubstituted C₁-C₃₀ halogenated alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted cyclic group in which a C₃-C₃₀ aliphatic ring and a C₅-C₃₀ aromatic ring are fused, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group;
m is an integer of 1 to 3, and when m is an integer of 2 or greater, the respective R₂s are the same as or different from each other;
n is an integer of 1 to 3, and when n is an integer of 2 or greater, the respective R₁s and R₂s in the parentheses are the same as or different from each other; and
the 'substituted' in the 'substituted or unsubstituted' in [Chemical Formula 1] and [Chemical Formula 2] means being substituted with one, or two or more substituents selected from the group consisting of deuterium, tritium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a cyclic group in which a C₃-C₂₄ aliphatic ring and a C₅-C₂₄ aromatic ring are fused, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, or being substituted with a substituent in which two or more of the above-mentioned substituents are linked, hydrogen atoms in the substituents are optionally substituted with one or more deuterium or tritium atoms, and two or more adjacent substituents are optionally linked to each other to further form an alicyclic or aromatic monocyclic or polycyclic ring.

10. The organic light-emitting device of claim 9, wherein the light-emitting layer includes a host and a dopant, and at least one of the polycyclic compounds represented by [Chemical Formula 1] or [Chemical Formula 2] is a dopant in the light-emitting layer.

11. The organic light-emitting device of claim 10, wherein at least one other compound in addition to one polycyclic compound represented by [Chemical Formula 1] or [Chemical Formula 2] is mixed or co-deposited and used as the dopant.

12. The organic light-emitting device of claim 11, wherein at least one of the compounds mixed or co-deposited and used in addition to the polycyclic compound of [Chemical Formula 1] or [Chemical Formula 2] is an organometallic compound.

13. The organic light-emitting device of claim 10, wherein the host is an anthracene compound represented by the following [Chemical Formula 3]: 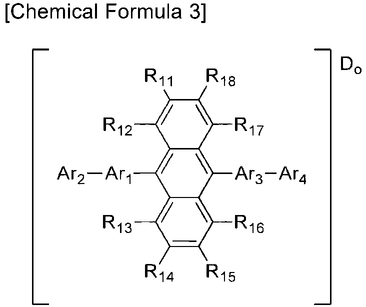 in [Chemical Formula 3],
R₁₁ to R₁₈ are the same as or different from each other, and each independently any one selected from hydrogen, deuterium, tritium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted cyclic group in which a C₃-C₃₀ aliphatic ring and a C₅-C₃₀ aromatic ring are fused, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group;
Ar₁ and Ar₃ are the same as or different from each other, and each independently a single bond, or any one selected from a substituted or unsubstituted C₆-C₃₀ arylene group, a substituted or unsubstituted C₅-C₃₀ 30 heteroarylene group, and a substituted or unsubstituted divalent cyclic group in which a C₃-C₃₀ aliphatic ring and a C₅-C₃₀ aromatic ring are fused;
Ar₂ and Ar₄ are the same as or different from each other, and each independently any one selected from a substituted or unsubstituted C₆-C₅₀ aryl group, a substituted or unsubstituted C₃-C₃₀ cycloalkyl group, a substituted or unsubstituted C₃-C₃₀ heterocycloalkyl group, a substituted or unsubstituted C₂-C₅₀ heteroaryl group, and a substituted or unsubstituted cyclic group in which a C₃-C₃₀ aliphatic ring and a C₃-C₃₀ aromatic ring are fused;
Dₒ refers to the number of hydrogen atoms in [Chemical Formula 3] substituted with deuterium or tritium;
o is an integer of 0 to 50; and
the 'substituted' in the 'substituted or unsubstituted' in [Chemical Formula 3] means being substituted with one, or two or more substituents selected from the group consisting of deuterium, tritium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a cyclic group in which a C₃-C₂₄ aliphatic ring and a C₅-C₂₄ aromatic ring are fused, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, or being substituted with a substituent in which two or more of the above-mentioned substituents are linked, hydrogen atoms in the substituents are optionally substituted with one or more deuterium or tritium atoms, and two or more adjacent substituents are optionally linked to each other to further form an alicyclic or aromatic monocyclic or polycyclic ring.

14. The organic light-emitting device of claim 13, wherein the anthracene compound represented by [Chemical Formula 3] is an anthracene compound represented by the following [Chemical Formula 3-1]: 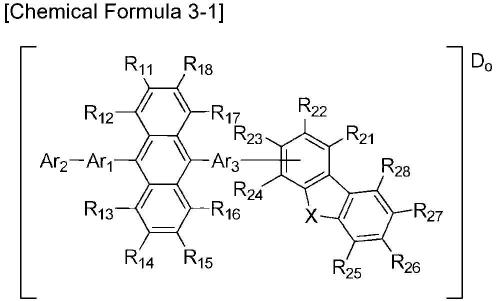 in [Chemical Formula 3-1],
X is O or S;
Ar₁ and Ar₃ are the same as or different from each other, and each independently a single bond, or any one selected from a substituted or unsubstituted C₆-C₃₀ arylene group, a substituted or unsubstituted C₅-C₃₀ heteroarylene group, and a substituted or unsubstituted divalent cyclic group in which a C₃-C₃₀ aliphatic ring and a C₅-C₃₀ aromatic ring are fused;
Ar₂ is any one selected from a substituted or unsubstituted C₆-C₅₀ aryl group, a substituted or unsubstituted C₃-C₃₀ cycloalkyl group, a substituted or unsubstituted C₃-C₃₀ heterocycloalkyl group, a substituted or unsubstituted C₂-C₅₀ heteroaryl group, and a substituted or unsubstituted cyclic group in which a C₃-C₃₀ aliphatic ring and a C₅-C₃₀ aromatic ring are fused;
one of R₂₁ to R₂₄ is a single bond linked to Ar₃;
the remaining substituents among R₁₁ to R₁₈ and R₂₁ to R₂₈, excluding the single bond linked to Ar₃ are the same as or different from each other, and each independently any one selected from hydrogen, deuterium, tritium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted cyclic group in which a C₃-C₃₀ aliphatic ring and a C₅-C₃₀ aromatic ring are fused, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group;
two or more adjacent substituents among R₂₁ to R₂₈ are optionally linked to each other to form an alicyclic or aromatic monocyclic or polycyclic ring, and the carbon atoms in the formed alicyclic or aromatic monocyclic or polycyclic ring are optionally substituted with at least one heteroatom selected from N, S and O;
Dₒ refers to the number of hydrogen atoms in [Chemical Formula 3-1] substituted with deuterium or tritium;
o is an integer of 0 to 50; and
the 'substituted' in the 'substituted or unsubstituted' in [Chemical Formula 3-1] means being substituted with one, or two or more substituents selected from the group consisting of deuterium, tritium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a cyclic group in which a C₃-C₂₄ aliphatic ring and a C₅-C₂₄ aromatic ring are fused, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, or being substituted with a substituent in which two or more of the above-mentioned substituents are linked, hydrogen atoms in the substituents are optionally substituted with one or more deuterium or tritium atoms, and two or more adjacent substituents are optionally linked to each other to further form an alicyclic or aromatic monocyclic or polycyclic ring.

15. The organic light-emitting device of claim 13, wherein the compound represented by [Chemical Formula 3] is any one selected from compounds represented by the following chemical formulae:
